# EUROPEAN PATENT APPLICATION

(11) **EP 4 207 967 A2**
(43) Date of publication of application: **05.07.2023**
(21) Application number: 22203390.4
(22) Date of filing: 24.10.2022
(51) Int. Cl.: H10K 50/11, H10K 50/19, H10K 85/30, H10K 85/60, H10K 101/10

(54) **ORGANIC LIGHT EMITTING DIODE AND ORGANIC LIGHT EMITTING DISPLAY DEVICE INCLUDING THE SAME**

(30) Priority: 28.12.2021 KR 20210189586
(71) Applicant: LG Display Co., Ltd., SEOUL, 07336 (KR)
(72) Inventor: Im, Joon-Beom, 10845 Gyeonggi-do (KR); Shin, In-Ae, 10845 Gyeonggi-do (KR); Ahn, Han-Jin, 10845 Gyeonggi-do (KR); Kim, Jun-Yun, 10845 Gyeonggi-do (KR)
(74) Representative: Heller, Benjamin Henry

(57) **Abstract**

An organic light emitting diode includes a reflective electrode (210); a transparent electrode (230) facing the reflective electrode; and a first emitting part (310) including a first blue emitting material layer (320) and positioned between the reflective electrode and the transparent electrode, the first blue emitting material layer including a fluorescent compound; and a second emitting part (350) including a second blue emitting material layer (360) and positioned between the first emitting part and the transparent electrode, the second blue emitting material layer including a fluorescent compound and a phosphorescent compound, wherein a difference between a second emission peak intensity of the second blue emitting material layer and a second emission peak intensity of the first blue emitting material layer is 0.1 or less.

## Description

### CROSS-REFERENCE TO RELATED APPLICATIONS

The present application claims the benefit of Korean Patent Application No. 10-2021-0189586 filed in the Republic of Korea on December 28, 2021, which is hereby incorporated by reference in its entirety.

### BACKGROUND

### TECHNICAL FIELD

The present disclosure relates to an organic light emitting diode, and more particularly, to an organic light emitting diode having high display performance and an organic light emitting display device including the organic light emitting diode.

### DISCUSSION OF THE RELATED ART

Requirement for flat panel display devices having small occupied area is increased. Among the flat panel display devices, a technology of an organic light emitting display device, which includes an organic light emitting diode (OLED) and may be called to as an organic electroluminescent device, is rapidly developed.

The OLED emits light by injecting electrons from a cathode as an electron injection electrode and holes from an anode as a hole injection electrode into an emitting material layer, combining the electrons with the holes, generating an exciton, and transforming the exciton from an excited state to a ground state.

However, the related art OLED has a limitation in the emitting properties such as the driving voltage, the luminance, the color purity and the lifespan. In particular, the blue OLED has a big limitation in the emitting properties.

### SUMMARY

Accordingly, embodiments of the present disclosure are directed to an OLED and an organic light emitting display device that substantially obviate one or more of the problems associated with the limitations and disadvantages of the related art.

An object of the present disclosure is to provide an OLED and an organic light emitting device having high display performance.

Additional features and aspects will be set forth in the description that follows, and in part will be apparent from the description, or may be learned by practice of the present disclosure concepts provided herein. Other features and aspects of the present disclosure concepts may be realized and attained by the structure particularly pointed out in the written description, or derivable therefrom, and the claims hereof as well as the appended drawings.

To achieve these and other advantages in accordance with the purpose of the embodiments of the present disclosure, as described herein, an aspect of the present disclosure is an organic light emitting diode including a reflective electrode; a transparent electrode facing the reflective electrode; and a first emitting part including a first blue emitting material layer and positioned between the reflective electrode and the transparent electrode, the first blue emitting material layer including a fluorescent compound; and a second emitting part including a second blue emitting material layer and positioned between the first emitting part and the transparent electrode, the second blue emitting material layer including a fluorescent compound and a phosphorescent compound, and a charge generation layer positioned between the first and second emitting parts, wherein a difference between a second emission peak intensity of the fluorescent compound of the second blue emitting material layer and a second emission peak intensity of the fluorescent compound of the first blue emitting material layer is 0.1 or less.

Another aspect of the present disclosure is an organic light emitting display device including a substrate including a blue pixel region, a red pixel region and a green pixel region; and first to third organic light emitting diodes positioned over the substrate and respectively corresponding to the blue pixel region, the red pixel region and the green pixel region, each of the first to third organic light emitting diodes including: a reflective electrode; a transparent electrode facing the reflective electrode; and an organic light emitting layer between the reflective electrode and the transparent electrode, wherein in the first organic light emitting diode, the organic light emitting layer includes a first emitting part including a first blue emitting material layer a second emitting part including a second blue emitting material layer and positioned between the first emitting part and the transparent electrode, wherein the first blue emitting material layer includes a fluorescent compound, and the second blue emitting material layer includes a fluorescent compound and a phosphorescent compound, and a charge generation layer positioned between the first and second emitting parts, and wherein a difference between a second emission peak intensity of the fluorescent compound of the second blue emitting material layer and a second emission peak intensity of the fluorescent compound of the first blue emitting material layer is 0.1 or less.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the present disclosure and are incorporated in and constitute a part of this application, illustrate embodiments of the present disclosure and together with the description serve to explain principles of the present disclosure.
FIG. 1 is a schematic circuit diagram of an organic light emitting display device of the present disclosure.
FIG. 2 is a schematic cross-sectional view of an organic light emitting display device according to a first embodiment of the present disclosure.
FIG. 3 is a schematic cross-sectional view of an organic light emitting display device according to a second embodiment of the present disclosure.
FIG. 4 is a schematic cross-sectional view of an organic light emitting display device according to a third embodiment of the present disclosure.
FIG. 5 is a schematic cross-sectional view of a blue OLED of the present disclosure.
FIG. 6 is a schematic cross-sectional view of a red OLED of the present disclosure.
FIG. 7 is a schematic cross-sectional view of a green OLED of the present disclosure.
FIG. 8 is a schematic cross-sectional view of an organic light emitting display device according to a fourth embodiment of the present disclosure.
FIG. 9 is a schematic cross-sectional view of a white OLED of the present disclosure.
FIGs. 10A to 10C are an EL spectrum of an OLED of the present disclosure.
FIGs. 11A and 11B are a PL spectrum of a fluorescent compound used for an OLED of the present disclosure.
FIG. 12 is a spectrum showing an absorption wavelength of a fluorescent compound and an emission wavelength of a phosphorescent compound used for an OLED of the present disclosure.

### DETAILED DESCRIPTION

Reference will now be made in detail to some of the examples and preferred embodiments, which are illustrated in the accompanying drawings.

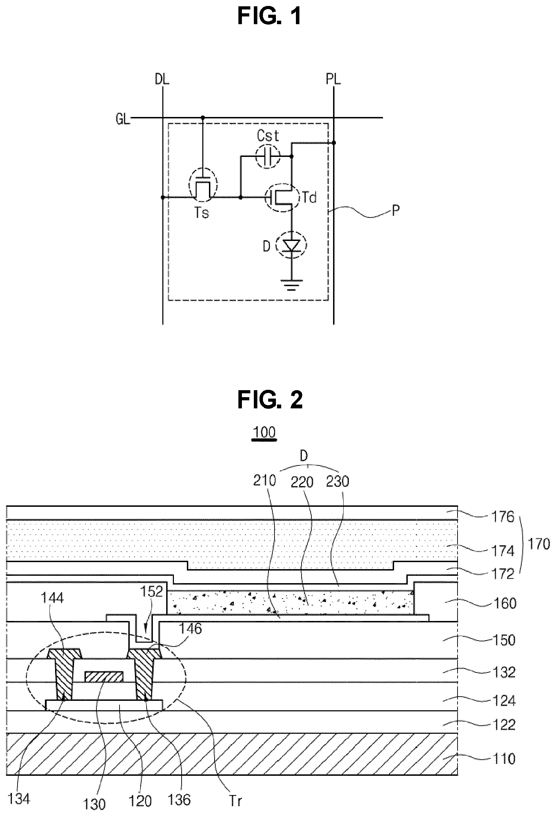

FIG. 1 is a schematic circuit diagram of an organic light emitting display device of the present disclosure.

As shown in FIG. 1, an organic light emitting display device includes a gate line GL, a data line DL, a power line PL, a switching thin film transistor TFT Ts, a driving TFT Td, a storage capacitor Cst, and an OLED D. The gate line GL and the data line DL cross each other to define a pixel region P. The pixel region may include a red pixel region, a green pixel region and a blue pixel region.

The switching TFT Ts is connected to the gate line GL and the data line DL, and the driving TFT Td and the storage capacitor Cst are connected to the switching TFT Ts and the power line PL. The OLED D is connected to the driving TFT Td.

In the organic light emitting display device, when the switching TFT Ts is turned on by a gate signal applied through the gate line GL, a data signal from the data line DL is applied to the gate electrode of the driving TFT Td and an electrode of the storage capacitor Cst.

When the driving TFT Td is turned on by the data signal, an electric current is supplied to the OLED D from the power line PL. As a result, the OLED D emits light. In this case, when the driving TFT Td is turned on, a level of an electric current applied from the power line PL to the OLED D is determined such that the OLED D can produce a gray scale.

The storage capacitor Cst serves to maintain the voltage of the gate electrode of the driving TFT Td when the switching TFT Ts is turned off. Accordingly, even if the switching TFT Ts is turned off, a level of an electric current applied from the power line PL to the OLED D is maintained to next frame.

As a result, the organic light emitting display device displays a desired image.

FIG. 2 is a schematic cross-sectional view of an organic light emitting display device according to a first embodiment of the present disclosure.

As shown in FIG. 2, the organic light emitting display device 100 includes a substrate 110, a TFT Tr on or over the substrate 110, a planarization layer 150 covering the TFT Tr and an OLED D on the planarization layer 150 and connected to the TFT Tr. A red pixel region, a green pixel region and a blue pixel region may be defined on the substrate 110.

The substrate 110 may be a glass substrate or a flexible substrate. For example, the flexible substrate may be one of a polyimide (PI) substrate, a polyethersulfone (PES) substrate, a polyethylenenaphthalate (PEN) substrate, a polyethylene terephthalate (PET) substrate and a polycarbonate (PC) substrate.

A buffer layer 122 is formed on the substrate, and the TFT Tr is formed on the buffer layer 122. The buffer layer 122 may be omitted. For example, the buffer layer 122 may be formed of an inorganic insulating material, e.g., silicon oxide or silicon nitride.

A semiconductor layer 120 is formed on the buffer layer 122. The semiconductor layer 120 may include an oxide semiconductor material or polycrystalline silicon.

When the semiconductor layer 120 includes the oxide semiconductor material, a light-shielding pattern (not shown) may be formed under the semiconductor layer 120. The light to the semiconductor layer 120 is shielded or blocked by the light-shielding pattern such that thermal degradation of the semiconductor layer 120 can be prevented. On the other hand, when the semiconductor layer 120 includes polycrystalline silicon, impurities may be doped into both sides of the semiconductor layer 120.

A gate insulating layer 124 is formed on the semiconductor layer 120. The gate insulating layer 124 may be formed of an inorganic insulating material such as silicon oxide or silicon nitride.

A gate electrode 130, which is formed of a conductive material, e.g., metal, is formed on the gate insulating layer 124 to correspond to a center of the semiconductor layer 120. In FIG. 2, the gate insulating layer 124 is formed on an entire surface of the substrate 110. Alternatively, the gate insulating layer 124 may be patterned to have the same shape as the gate electrode 130.

An interlayer insulating layer 132 is formed on the gate electrode 130 and over an entire surface of the substrate 110. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 120. The first and second contact holes 134 and 136 are positioned at both sides of the gate electrode 130 to be spaced apart from the gate electrode 130.

The first and second contact holes 134 and 136 are formed through the gate insulating layer 124. Alternatively, when the gate insulating layer 124 is patterned to have the same shape as the gate electrode 130, the first and second contact holes 134 and 136 is formed only through the interlayer insulating layer 132.

A source electrode 144 and a drain electrode 146, which are formed of a conductive material, e.g., metal, are formed on the interlayer insulating layer 132.

The source electrode 144 and the drain electrode 146 are spaced apart from each other with respect to the gate electrode 130 and respectively contact both sides of the semiconductor layer 120 through the first and second contact holes 134 and 136.

The semiconductor layer 120, the gate electrode 130, the source electrode 144 and the drain electrode 146 constitute the TFT Tr. The TFT Tr serves as a driving element. Namely, the TFT Tr is the driving TFT Td (of FIG. 1).

In the TFT Tr, the gate electrode 130, the source electrode 144, and the drain electrode 146 are positioned over the semiconductor layer 120. Namely, the TFT Tr has a coplanar structure.

Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 150 is formed on an entire surface of the substrate 110 to cover the source and drain electrodes 144 and 146. The planarization layer 150 provides a flat top surface and has a drain contact hole 152 exposing the drain electrode 146 of the TFT Tr.

The OLED D is disposed on the planarization layer 150 and includes a first electrode 210, which is connected to the drain electrode 146 of the TFT Tr, an organic light emitting layer 220 and a second electrode 230. The organic light emitting layer 220 and the second electrode 230 are sequentially stacked on the first electrode 210. The OLED D is positioned in each of the red, green and blue pixel regions and respectively emits the red, green and blue light.

The first electrode 210 is separately formed in each pixel region. The first electrode 210 may be an anode and may include a transparent conductive oxide material layer, which may be formed of a conductive material, e.g., a transparent conductive oxide (TCO), having a relatively high work function, and a reflective layer. Namely, the first electrode 210 may be a reflective electrode.

For example, the transparent conductive oxide material layer may be formed of one of indium-tin-oxide (ITO), indium-zinc-oxide (IZO), indium-tin-zinc-oxide (ITZO), tin oxide (SnO), zinc oxide (ZnO), indium-copper-oxide (ICO) and aluminum-zinc-oxide (AI:ZnO, AZO), and the reflective layer may be formed of one of silver (Ag), an alloy of Ag and one of palladium (Pd), copper (Cu), indium (In) and neodymium (Nd), and aluminum-palladium-copper (APC) alloy. For example, the first electrode 210 may have a structure of ITO/Ag/ITO or ITO/APC/ITO.

In addition, a bank layer 160 is formed on the planarization layer 150 to cover an edge of the first electrode 210. Namely, the bank layer 160 is positioned at a boundary of the pixel region and exposes a center of the first electrode 210 in the pixel region.

The organic light emitting layer 220 as an emitting unit is formed on the first electrode 210. For example, OLED D in the blue pixel region, the organic light emitting layer 220 includes a first emitting part including a first blue emitting material layer (EML) and a second emitting part including a second blue EML. Namely, the organic light emitting layer 220 has a double stack structure so that the OLED D has a tandem structure.

Each of the first and second emitting parts may further include at least one of a hole injection layer (HIL), a hole transporting layer (HTL), an electron blocking layer (EBL), a hole blocking layer (HBL), an electron transporting layer (ETL) and an electron injection layer (EIL) to have a multi-layered structure. In addition, the organic light emitting layer 220 may further include a charge generation layer (CGL) between the first and second emitting parts.

As illustrated below, in the OLED D in the blue pixel region, the first blue EML is a fluorescent emitting layer including a host and a fluorescent compound as a fluorescent emitter (dopant), and the second blue EML is a phosphor-stabilized-fluorescence (PSF) emitting layer including a first host, a second host, a phosphorescent compound and a fluorescent compound as a fluorescent emitter (dopant). In addition, the second blue EML being the PSF emitting layer is disposed to be closer to the second electrode 230 being a transparent electrode than the first blue EML being the fluorescent emitting layer, and a difference " | I_{2nd}(EML2)-I_{2nd}(EML1) | " between a second emission peak intensity of the second blue EML being the PSF emitting layer and a second emission peak intensity of the first blue EML being the fluorescent emitting layer is 0.1 or less. As result, strong cavity effect is provided in the OLED D so that the OLED D has a significantly-improved blue emitting efficiency with sufficient lifespan.

Moreover, a difference" I Amax(FD2_PL)-Amax(FD1_PL) I " between a maximum emission wavelength "Amax(FD2_PL)" of the fluorescent compound "FD2" as the emitter or dopant in the first blue EML being the fluorescent emitting layer and a maximum emission wavelength "λmax(FD1_PL)" of the fluorescent compound "FD1" in the second blue EML being the PSF emitting layer is 15nm or less. As a result, the emitting property of the OLED D is further improved.

Furthermore, in the second blue EML being the PSF emitting layer, a difference" I λmax(FD1_Abs)-λmax(PD_PL) I " between a maximum absorption wavelength "λmax(FD1_Abs)" of the fluorescent compound "FD1" and a maximum emission wavelength "λmax(PD_PL)" of the phosphorescent compound "PD" is 10nm or less. As a result, the emitting property of the OLED D is significantly improved.

Emission and absorption characteristics may be measured at room temperature (i.e. 25_{°}C) in an organic solvent, such as toluene. For example, a solution of the sample in an organic solvent (such as toluene) having a concentration of about 1 × 10⁻⁵ M may be used. The emission and absorption may be measured using a fluorescence spectrometer, such as FS-5 Fluorescence spectrometer (Edinburgh Instruments), with photoluminescence detection.

The second electrode 230 is formed over the substrate 110 where the organic light emitting layer 220 is formed. The second electrode 230 covers an entire surface of the display area and may be formed of a conductive material having a relatively low work function to serve as a cathode. For example, the second electrode 230 may be formed of aluminum (Al), magnesium (Mg), calcium (Ca), silver (Ag) or their alloy, e.g., Mg-Ag alloy (MgAg). The second electrode 230 may have a thin profile, e.g., 10 to 30nm, to be transparent (or semi-transparent).

Alternatively, in a bottom-emission type organic light emitting display device 100, the first electrode 210 may be a transparent electrode, and the second electrode 230 may be a reflective electrode. In this case, the second blue EML being the PSF emitting layer is disposed to be closer to the first electrode 210 being the transparent electrode than the first blue EML being the fluorescent emitting layer.

Although not shown, the OLED D may further include a capping layer on the second electrode 230. The emitting efficiency of the OLED D may be further improved by the capping layer.

An encapsulation film (or an encapsulation layer) 170 is formed on the second electrode 230 to prevent penetration of moisture into the OLED D. The encapsulation film 170 includes a first inorganic insulating layer 172, an organic insulating layer 174 and a second inorganic insulating layer 176 sequentially stacked, but it is not limited thereto.

Although not shown, the organic light emitting display device 100 may include a color filter corresponding to the red, green and blue pixel regions. For example, the color filter may be positioned on or over the OLED D or the encapsulation film 170.

In addition, the organic light emitting display device 100 may further include a cover window (not shown) on or over the encapsulation film 170 or the color filter. In this instance, the substrate 110 and the cover window have a flexible property such that a flexible organic light emitting display device may be provided.

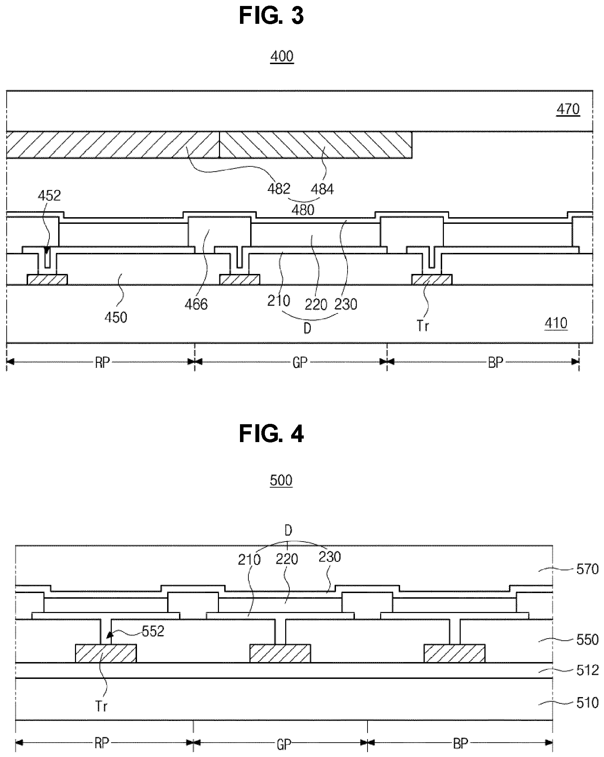

FIG. 3 is a schematic cross-sectional view of an organic light emitting display device according to a second embodiment of the present disclosure.

As shown in FIG. 3, the organic light emitting display device 400 includes a first substrate 410, where a red pixel RP, a green pixel GP and a blue pixel BP are defined, a second substrate 470 facing the first substrate 410, an OLED D, which is positioned between the first and second substrates 410 and 470 and providing blue emission, and a color conversion layer 480 between the OLED D and the second substrate 470.

Each of the first and second substrates 410 and 470 may be a glass substrate or a flexible substrate. For example, the flexible substrate may be one of a polyimide (PI) substrate, polyethersulfone (PES), polyethylenenaphthalate (PEN), polyethylene terephthalate (PET) and polycarbonate (PC).

A TFT Tr, which corresponding to each of the red, green and blue pixels RP, GP and BP, is formed on the first substrate 410, and a planarization layer (a passivation layer) 450, which has a drain contact hole 452 exposing an electrode, e.g., a drain electrode, of the TFT Tr is formed to cover the TFT Tr.

The OLED D including a first electrode 210, an organic light emitting layer 220 and a second electrode 230 is formed on the planarization layer 450. In this instance, the first electrode 210 may be connected to the drain electrode of the TFT Tr through the drain contact hole 452.

A bank layer 466 is formed on the planarization layer 450 to cover an edge of the first electrode 210.

The OLED D is formed in each of the red, green and blue pixels RP, GP and BP and provides the blue light. Namely, the OLED D1 is a blue OLED.

The first electrode 210 may be an anode, and the second electrode 230 may be a cathode. The first electrode 210 is a reflective electrode, and the second electrode 230 is a transparent electrode. For example, the first electrode 210 may have a structure of ITO/Ag/ITO, and the second electrode 230 may include MgAg.

The organic light emitting layer 220 includes a first emitting part including a first blue EML and a second emitting part including a second blue EML.

Each of the first and second emitting parts may further include at least one of an HIL, an HTL, an EBL, an HBL, an ETL and an EIL to have a multi-layered structure. In addition, the organic light emitting layer 220 may further include a CGL between the first and second emitting parts.

The first blue EML is a fluorescent emitting layer including a host and a fluorescent compound as a fluorescent emitter (dopant), and the second blue EML is a phosphor-stabilized-fluorescence (PSF) emitting layer including a first host, a second host, a phosphorescent compound and a fluorescent compound as a fluorescent emitter (dopant). In addition, the second blue EML being the PSF emitting layer is disposed to be closer to the second electrode 230 being a transparent electrode than the first blue EML being the fluorescent emitting layer, and a difference" | I_{2nd}(EML2)-I_{2nd}(EML1) | " between a second emission peak intensity of the second blue EML being the PSF emitting layer and a second emission peak intensity of the first blue EML being the fluorescent emitting layer is 0.1 or less. As result, strong cavity effect is provided in the OLED D so that the OLED D has a significantly-improved blue emitting efficiency with sufficient lifespan.

Moreover, a difference" I Amax(FD2_PL)-Amax(FD1_PL) I " between a maximum emission wavelength "Amax(FD2_PL)" of the fluorescent compound "FD2" as the emitter or dopant in the first blue EML being the fluorescent emitting layer and a maximum emission wavelength "λmax(FD1_PL)" of the fluorescent compound "FD1" in the second blue EML being the PSF emitting layer is 15nm or less. As a result, the emitting property of the OLED D is further improved.

Furthermore, in the second blue EML being the PSF emitting layer, a difference" | λmax(FD1_Abs)-λmax(PD_PL) | " between a maximum absorption wavelength "λmax(FD1_Abs)" of the fluorescent compound "FD2" and a maximum emission wavelength "λmax(PD_PL)" of the phosphorescent compound "PD" is 10nm or less. As a result, the emitting property of the OLED D is significantly improved.

The color conversion layer 480 includes a first color conversion layer 482 corresponding to the red pixel RP and a second color conversion layer 484 corresponding to the green pixel GP. For example, the color conversion layer 480 may include an inorganic color conversion material such as a quantum dot. The color conversion layer 480 is not presented in the blue pixel BP so that the OLED D in the blue pixel may directly face the second electrode 470.

The blue light from the OLED D in the red pixel region RP is converted into the red light by the first color conversion layer 482 in the red pixel RP, and the blue light from the OLED D in the green pixel region GP is converted into the green light by the second color conversion layer 484 in the green pixel GP.

Although not shown, a color filter may be formed between the second substrate 470 and the color conversion layer 480. For example, a red color filter may be formed between the first color conversion layer 482 and the second substrate 470, and a green color filter may be formed between the second color conversion layer 484 and the second substrate 470.

Accordingly, the organic light emitting display device 400 can display a full-color image.

On the other hand, when the light from the OLED D passes through the first substrate 410, i.e., a bottom-emission type OLED, the color conversion layer 480 is disposed between the OLED D and the first substrate 410. In this instance, the second emitting part including the second blue EML, which is the PSF emitting layer, is disposed to be closer to the first electrode 210 being the transparent electrode, and the first emitting part including the first blue EML, which is the fluorescent emitting layer, is disposed between the second emitting part and the second electrode 230 being the reflective electrode.

In the organic light emitting display device 400, the OLED D emitting the blue light is formed in all of the red, green and blue pixel regions RP, GP and BP, and a full color image is provided by using the color conversion layer 480.

FIG. 4 is a schematic cross-sectional view of an organic light emitting display device according to a third embodiment of the present disclosure.

As shown in FIG. 4, the organic light emitting display device 500 includes a substrate 510, wherein first to a red pixel region RP, a green pixel region GP and a blue pixel region BP are defined, a TFT Tr over the substrate 510 and an OLED D over the TFT Tr. The OLED D is connected to the TFT Tr.

The substrate 510 may be a glass substrate or a flexible substrate.

A buffer layer 512 is formed on the substrate 510, and the TFT Tr is formed on the buffer layer 512. The buffer layer 512 may be omitted.

The TFT Tr is positioned on the buffer layer 512. The TFT Tr includes a semiconductor layer, a gate electrode, a source electrode and a drain electrode and acts as a driving element. Namely, the TFT Tr may be the driving TFT Td (of FIG. 1).

A planarization layer (or passivation layer) 550 is formed on the TFT Tr. The planarization layer 550 has a flat top surface and includes a drain contact hole 552 exposing the drain electrode of the TFT Tr.

The OLED D is disposed on the planarization layer 550 and includes a first electrode 210, an organic light emitting layer 220 and a second electrode 230. The first electrode 210 is connected to the drain electrode of the TFT Tr, and the organic light emitting layer 220 and the second electrode 230 are sequentially stacked on the first electrode 210. The OLED D is disposed in each of the red, green and blue pixel regions RP, GP and BP and emits different color light in the red, green and blue pixel regions RP, GP and BP. For example, the OLED D in the red pixel region RP may emit the red light, the OLED D in the green pixel region GP may emit the green light, and the OLED D in the blue pixel region BP may emit the blue light.

The first electrode 210 is formed to be separated in the red, green and blue pixel regions RP, GP and BP, and the second electrode 230 is formed as one-body to cover the red, green and blue pixel regions RP, GP and BP.

The first electrode 210 is one of an anode and a cathode, and the second electrode 230 is the other one of the anode and the cathode. In addition, the first electrode 210 is a reflective electrode, and the second electrode 230 is a transparent electrode (or a semi-transparent electrode). Namely, the light from the OLED D passes through the second electrode 230 to display an image. (i.e., a top-emission type organic light emitting display device)

For example, the first electrode 210 may be an anode and may include a transparent conductive oxide material layer, which may be formed of a conductive material, e.g., a transparent conductive oxide (TCO), having a relatively high work function, and a reflection layer.

The second electrode 230 may a cathode and may be formed of a conductive material having a relatively low work function. The second electrode 230 may have a thin profile to be transparent (or semi-transparent).

In the blue pixel region BP, the organic light emitting layer 220, e.g., a first organic light emitting layer, includes a first emitting part, e.g., a first blue emitting part, including a first blue EML and a second emitting part, e.g., a second blue emitting part, including a second blue EML.

In the red pixel region RP, the organic light emitting layer 220, e.g., a second organic light emitting layer, includes a first emitting part, e.g., a first red emitting part, including a first red EML and a second emitting part, e.g., a second red emitting part, including a second red EML.

In the green pixel region BP, the organic light emitting layer 220, e.g., a third organic light emitting layer, includes a first emitting part, e.g., a first green emitting part, including a first green EML and a second emitting part, e.g., a second green emitting part, including a second green EML.

In each of the red, green and blue pixel regions RP, GP and BP, each of the first and second emitting parts may further include at least one of an HIL, an HTL, an EBL, an HBL, an ETL and an EIL to have a multi-layered structure. In addition, in each of the red, green and blue pixel regions RP, GP and BP, the organic light emitting layer 220 may further include a CGL between the first and second emitting parts.

The first blue EML is a fluorescent emitting layer including a host and a fluorescent compound as a fluorescent compound as a fluorescent emitter (dopant), and the second blue EML is a phosphor-stabilized-fluorescence (PSF) emitting layer including a first host, a second host, a phosphorescent compound and a fluorescent compound as a fluorescent compound as a fluorescent emitter (dopant). In addition, the second blue EML being the PSF emitting layer is disposed to be closer to the second electrode 230 being a transparent electrode than the first blue EML being the fluorescent emitting layer, and a difference " | I_{2nd}(EML2)-I_{2nd}(EML1) | " between a second emission peak intensity of the second blue EML being the PSF emitting layer and a second emission peak intensity of the first blue EML being the fluorescent emitting layer is 0.1 or less. As result, strong cavity effect is provided in the OLED D so that the OLED D has a significantly-improved blue emitting efficiency with sufficient lifespan.

Moreover, a difference" I Amax(FD2_PL)-Amax(FD1_PL) I " between a maximum emission wavelength "Amax(FD2_PL)" of the fluorescent compound "FD2" as the emitter or dopant in the first blue EML being the fluorescent emitting layer and a maximum emission wavelength "λmax(FD1_PL)" of the fluorescent compound "FD1" in the second blue EML being the PSF emitting layer is 15nm or less. As a result, the emitting property of the OLED D is further improved.

Furthermore, in the second blue EML being the PSF emitting layer, a difference" I λmax(FD1_Abs)-λmax(PD_PL) I " between a maximum absorption wavelength "λmax(FD1_Abs)" of the fluorescent compound "FD2" and a maximum emission wavelength "λmax(PD_PL)" of the phosphorescent compound "PD" is 10nm or less. As a result, the emitting property of the OLED D is significantly improved.

The first red EML is a fluorescent emitting layer including a host, a delayed fluorescent compound and a fluorescent compound as a fluorescent dopant, and the second red EML is a phosphorescent emitting layer including a host and a phosphorescent compound as a phosphorescent emitter (dopant). The second red EML being the phosphorescent emitting layer is disposed to be closer to the second electrode 230 being the transparent electrode than the first red EML being the fluorescent emitting layer, and the second red EML being the phosphorescent emitting layer has higher emitting efficiency (cd/A) than the first red EML being the fluorescent emitting layer. For example, the phosphorescent emitter of the second red EML being the phosphorescent emitting layer may have higher quantum efficiency than the fluorescent emitter of the first red EML being the fluorescent emitting layer.

As a result, strong cavity effect is provided in the OLED D in the red pixel region RP so that the OLED D in the red pixel region RP has low driving voltage and significantly-improved red emitting efficiency.

The first green EML is a phosphorescent emitting layer including a host and a phosphorescent compound as a phosphorescent emitter (dopant), and the second green EML is a fluorescent emitting layer including a host, a delayed fluorescent compound and a fluorescent compound as a fluorescent dopant. The second green EML being the fluorescent emitting layer is disposed to be closer to the second electrode 230 being the transparent electrode than the first green EML being the phosphorescent emitting layer, and the second green EML being the fluorescent emitting layer has higher emitting efficiency (cd/A) than the first green EML being the phosphorescent emitting layer. For example, the fluorescent emitter of the second green EML being the fluorescent emitting layer may have higher quantum efficiency than the phosphorescent emitter of the first green EML being the phosphorescent emitting layer.

As a result, strong cavity effect is provided in the OLED D in the green pixel region GP so that the OLED D in the green pixel region GP has low driving voltage and significantly-improved green emitting efficiency.

Although not shown, the OLED D may further include the capping layer on the second electrode 230. The emitting efficiency of the OLED D and/or the organic light emitting display device 500 may be further improved by the capping layer.

An encapsulation film (or an encapsulation layer) 570 is formed on the second electrode 230 to prevent penetration of moisture into the OLED D. The encapsulation film 570 may have a structure including an inorganic insulating layer and an organic insulating layer.

Although not shown, the organic light emitting display device 500 may include a color filter corresponding to the red, green and blue pixel regions RP, GP and BP. For example, the color filter may be positioned on or over the OLED D or the encapsulation film 570.

On the other hand, in the bottom-emission type organic light emitting display device 500, the first electrode 210 serves as a transparent electrode, and the second electrode 230 serves as a reflective electrode. In this instance, in the blue pixel region BP, the second blue EML being the PSF emitting layer is disposed to be closer to the first electrode 210 being the transparent electrode than the first blue EML being the fluorescent emitting layer. In the red pixel region RP, the second red EML being the phosphorescent emitting layer is disposed to be closer to the first electrode 210 being the transparent electrode than the first red EML being the fluorescent emitting layer. In the green pixel region GP, the second green EML being the fluorescent emitting layer is disposed to be closer to the first electrode 210 being the transparent electrode than the first green EML being the phosphorescent emitting layer.

In addition, the organic light emitting display device 500 may further include a cover window (not shown) on or over the encapsulation film 570 or the color filter. In this instance, the substrate 510 and the cover window have a flexible property such that a flexible organic light emitting display device may be provided.

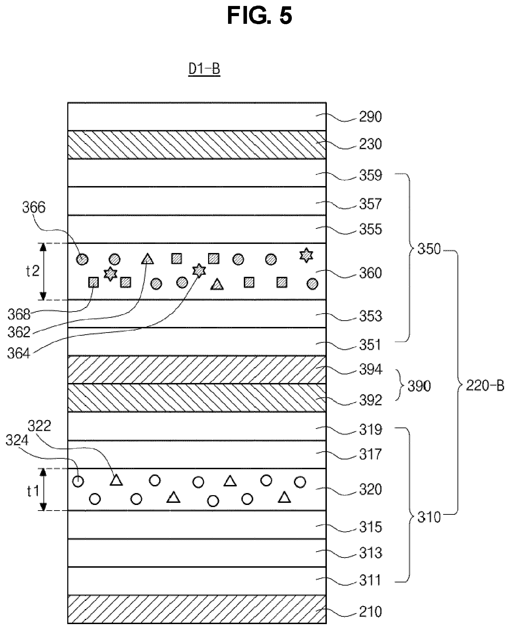

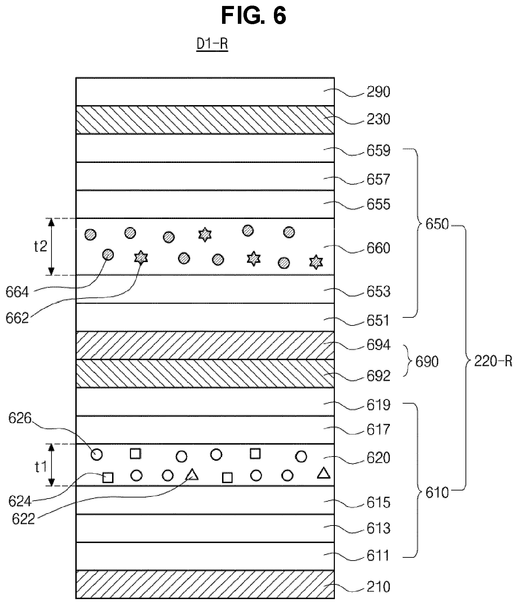

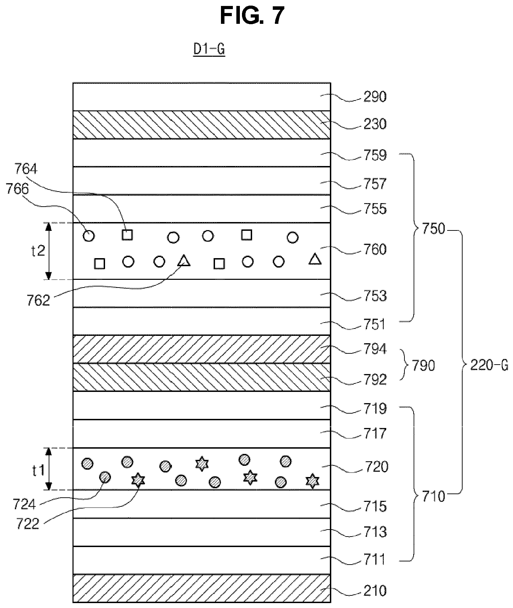

FIG. 5 is a schematic cross-sectional view of a blue OLED of the present disclosure, FIG. 6 is a schematic cross-sectional view of a red OLED of the present disclosure, and FIG. 7 is a schematic cross-sectional view of a green OLED of the present disclosure.

Referring to FIG. 5, the blue OLED D1-B includes a first electrode 210 being a reflective electrode, a second electrode 230 being a transparent electrode (a semitransparent electrode) and facing the first electrode 210 and a first organic light emitting layer 220-B, e.g., a blue organic light emitting layer. The first organic light emitting layer 220-B includes a first blue emitting part 310 including a first blue EML 320 and a second blue emitting part 350 including a second blue EML 360. In addition, the first organic light emitting layer 220-B may further include a CGL 390 between the first and second blue emitting parts 310 and 350.

Referring to FIG. 6, the red OLED D1-R includes a first electrode 210 being a reflective electrode, a second electrode 230 being a transparent electrode (a semitransparent electrode) and facing the first electrode 210 and a second organic light emitting layer 220-R, e.g., a red organic light emitting layer. The second organic light emitting layer 220-R includes a first red emitting part 610 including a first red EML 620 and a second red emitting part 650 including a second red EML 660. In addition, the second organic light emitting layer 220-R may further include a CGL 690 between the first and second red emitting parts 610 and 650.

Referring to FIG. 7, the green OLED D1-G includes a first electrode 210 being a reflective electrode, a second electrode 230 being a transparent electrode (a semitransparent electrode) and facing the first electrode 210 and a third organic light emitting layer 220-G, e.g., a green organic light emitting layer. The third organic light emitting layer 220-G includes a first green emitting part 710 including a first green EML 720 and a second green emitting part 750 including a second green EML 760. In addition, the third organic light emitting layer 220-G may further include a CGL 790 between the first and second green emitting parts 710 and 750.

In addition, each of the blue OLED D1-B, the red OLED D1-R and the green OLED D1-G may further include a capping layer 290 for enhancing a light extraction. The capping layer 290 of the blue OLED D1-B, the capping layer 290 of the red OLED D1-R and the capping layer 290 of the green OLED D1-G may be continuously formed as one-body.

In the organic light emitting display device 400 in FIG. 3, the blue OLED D1-B is positioned to correspond to the red, green and blue pixel regions RP, GP and BP.

On the other hand, in the organic light emitting display device 500 in FIG. 4, the blue OLED D1-B is positioned in the blue pixel region BP, the red OLED D1-R is positioned in the red pixel region RP, and the green OLED D1-G is positioned in the green pixel region GP.

The first electrode 210 may be anode, and the second electrode 230 may be a cathode. The first electrode 210 is a reflective electrode, and the second electrode 230 is a transparent electrode (or a semi-transparent electrode). For example, the first electrode 210 may have a structure of ITO/Ag/ITO, and the second electrode 230 may be formed of MgAg or Al. When the second electrode 230 is formed of MgAg, Mg may be doped with 10wt%. Namely, the first electrode 210 may have a first transmittance, and the second electrode 230 may have a second transmittance greater than the first transmittance.

The first blue emitting part 310 may further include at least one of a first HTL 313 under the first blue EML 320 and a first ETL 319 on or over the first blue EML 320. In addition, the first blue emitting part 310 may further include an HIL 311 under the first HTL 313. Moreover, the first blue emitting part 310 may further include at least one of a first EBL 315 between the first blue EML 320 and the first HTL 313 and a first HBL 317 between the first blue EML 320 and the first ETL 319.

The second blue emitting part 350 may further include at least one of a second HTL 351 under the second blue EML 360 and a second ETL 357 on or over the second blue EML 360. In addition, the second blue emitting part 350 may further include an EIL 359 on the second ETL 357. Moreover, the second blue emitting part 350 may further include at least one of the second EBL 353 between the second blue EML 360 and the second HTL 351 and a second HBL 355 between the second blue EML 360 and the second ETL 357.

The first red emitting part 610 may further include at least one of a first HTL 613 under the first red EML 620 and a first ETL 619 on or over the first red EML 620. In addition, the first red emitting part 610 may further include an HIL 611 under the first HTL 613. Moreover, the first red emitting part 610 may further include at least one of a first EBL 615 between the first red EML 620 and the first HTL 613 and a first HBL 617 between the first red EML 620 and the first ETL 619.

The second red emitting part 650 may further include at least one of a second HTL 651 under the second red EML 660 and a second ETL 657 on or over the second red EML 660. In addition, the second red emitting part 650 may further include an EIL 659 on the second ETL 657. Moreover, the second red emitting part 650 may further include at least one of the second EBL 653 between the second red EML 660 and the second HTL 651 and a second HBL 655 between the second red EML 660 and the second ETL 657.

The first green emitting part 710 may further include at least one of a first HTL 713 under the first green EML 720 and a first ETL 719 on or over the first green EML 720. In addition, the first green emitting part 710 may further include an HIL 711 under the first HTL 713. Moreover, the first green emitting part 710 may further include at least one of a first EBL 715 between the first green EML 720 and the first HTL 713 and a first HBL 717 between the first green EML 720 and the first ETL 719.

The second green emitting part 750 may further include at least one of a second HTL 751 under the second green EML 760 and a second ETL 757 on or over the second green EML 760. In addition, the second green emitting part 750 may further include an EIL 759 on the second ETL 757. Moreover, the second green emitting part 750 may further include at least one of the second EBL 753 between the second green EML 760 and the second HTL 751 and a second HBL 755 between the second green EML 760 and the second ETL 757.

The CGL 390 in the blue OLED D1-B may be a P-N junction type CGL of an N-type CGL 392 and a P-type CGL 394. The N-type CGL 392 is positioned between the first ETL 319 and the second HTL 351, and the P-type CGL 394 is positioned between the N-type CGL 392 and the second HTL 351. The N-type CGL 392 provides an electron into the first blue EML 320 of the first blue emitting part 310, and the P-type CGL 394 provides a hole into the second blue EML 360 of the second blue emitting part 350.

The CGL 690 in the red OLED D1-R may be a P-N junction type CGL of an N-type CGL 692 and a P-type CGL 694. The N-type CGL 692 is positioned between the first ETL 619 and the second HTL 651, and the P-type CGL 694 is positioned between the N-type CGL 692 and the second HTL 651. The N-type CGL 692 provides an electron into the first red EML 620 of the first red emitting part 610, and the P-type CGL 694 provides a hole into the second red EML 660 of the second red emitting part 650.

The CGL 790 in the green OLED D1-G may be a P-N junction type CGL of an N-type CGL 792 and a P-type CGL 794. The N-type CGL 792 is positioned between the first ETL 719 and the second HTL 751, and the P-type CGL 794 is positioned between the N-type CGL 792 and the second HTL 751. The N-type CGL 792 provides an electron into the first green EML 720 of the first green emitting part 710, and the P-type CGL 794 provides a hole into the second green EML 760 of the second green emitting part 750.

Each of the HIL 311, 611 and 711, the first HTL 313, 613 and 713, the first EBL 315, 615 and 715, the first HBL 317, 617 and 717, the first ETL 319, 619 and 719, the second HTL 351, 651 and 751, the second EBL 353, 653 and 753, the second HBL 355, 655 and 755, the second HTL 357, 657 and 757 and the EIL 359, 659 and 759 may be a common layer in the blue OLED D1-B, the red OLED D1-R and the green OLED D1-G. Namely, in the blue OLED D1-B, the red OLED D1-R and the green OLED D1-G, the HIL 311, 611 and 711, the first HTL 313, 613 and 713, the first EBL 315, 615 and 715, the first HBL 317, 617 and 717, the first ETL 319, 619 and 719, the second HTL 351, 651 and 751, the second EBL 353, 653 and 753, the second HBL 355, 655 and 755, the second HTL 357, 657 and 757 and the EIL 359, 659 and 759 may be continuously formed as one-body, respectively.

The second blue EML 360 as the PSF emitting layer includes a first compound 362, a second compound 364, a third compound 366 and a fourth compound 368. The first compound 362 is a fluorescent compound as a fluorescent emitter or a fluorescent dopant, and the second compound 364 is a phosphorescent compound as an auxiliary dopant. The third compound 366 is a p-type host, e.g., a first host, and the fourth compound 368 is an n-type host, e.g., a second host.

The first compound 362 is represented by Formula 1.

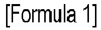

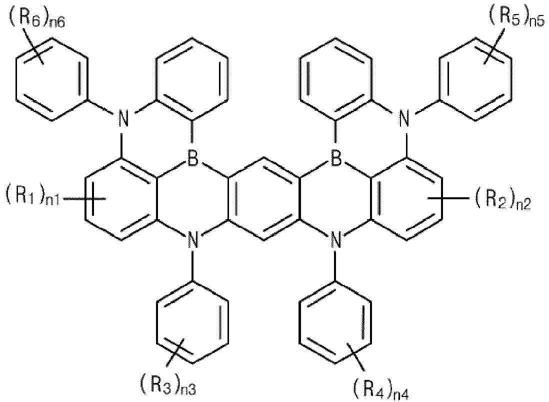

In Formula 1, each of R₁ and R₂ is independently selected from the group consisting of hydrogen, deuterium, a substituted or unsubstituted C5 to C30 heteroaryl group and a substituted or unsubstituted C6 to C30 arylamine (arylamino) group, and each of R₃, R₄, R₅ and R₆ is independently selected from the group consisting of hydrogen, deuterium, a substituted or unsubstituted C1 to C10 alkyl group and a substituted or unsubstituted C6 to C30 aryl group. Each of n1 and n2 is independently an integer of 1 to 3, and each of n3, n4, n5 and n6 is independently an integer of 0 to 5.

In the present disclosure, without specific definition, a substituent of an alkyl group, an aryl group, a heteroaryl group, an arylene group, a heteroarylene group and an arylamine group may be at least one of deuterium, a C1 to C10 alkyl group and a C6 to C30 aryl group. A group defined herein as being "substituted or unsubstituted" is preferably unsubstituted or substituted with a C1 to C10 alkyl group.

A group described as "substituted or unsubstituted" may be substituted with one or more groups defined herein (as valency allows).

In the present disclosure, the C6 to C30 aryl group (or C6 to C30 arylene group) may be selected from the group consisting of phenyl, biphenyl, terphenyl, naphthyl, anthracenyl, pentanenyl, indenyl, indenoindenyl, heptalenyl, biphenylenyl, indacenyl, phenanthrenyl, benzophenanthrenyl, dibenzophenanthrenyl, azulenyl, pyrenyl, fluoranthenyl, triphenylenyl, chrysenyl, tetraphenyl, tetrasenyl, picenyl, pentaphenyl, pentacenyl, fluorenyl, indenofluorenyl and spiro-fluorenyl.

In the present disclosure, the C5 to C30 heteroaryl group may be selected from the group consisting of pyrrolyl, pyridinyl, pyrimidinyl, pyrazinyl, pyridazinyl, triazinyl, tetrazinyl, imidazolyl, pyrazolyl, indolyl, isoindolyl, indazolyl, indolizinyl, pyrrolizinyl, carbazolyl, benzocarbazolyl, dibenzocarbazolyl, indolocarbazolyl, indenocarbazolyl, benzofurocarbazolyl, benzothienocarbazolyl, quinolinyl, isoquinolinyl, phthalazinyl, quinoxalinyl, cinnolinyl, quinazolinyl, quinozolinyl, quinolinyl, purinyl, phthalazinyl, quinoxalinyl, benzoquinolinyl, benzoisoquinolinyl, benzoquinazolinyl, benzoquinoxalinyl, acridinyl, phenanthrolinyl, perimidinyl, phenanthridinyl, pteridinyl, cinnolinyl, naphtharidinyl, furanyl, oxazinyl, oxazolyl, oxadiazolyl, triazolyl, dioxynyl, benzofuranyl, dibenzofuranyl, thiopyranyl, xanthenyl, chromanyl, isochromanyl, thioazinyl, thiophenyl, benzothiophenyl, dibenzothiophenyl, difuropyrazinyl, benzofurodibenzofuranyl, benzothienobenzothiophenyl, benzothienodibenzothiophenyl, benzothienobenzofuranyl, and benzothienodibenzofuranyl.

For example, in Formula 1, each of R₁ and R₂ may be independently selected from a C5 to C30 heteroaryl group, e.g., carbazolyl, unsubstituted or substituted with a C1 to C10 alkyl group, e.g., methyl. Each of R₃, R₄, R₅ and R₆ may be independently selected from a C6 to C30 aryl group, e.g., phenyl, unsubstituted or substituted with a C1 to C10 alkyl group, e.g., tert-butyl.

The first compound 362 in Formula 1 may be represented by Formula 1a.

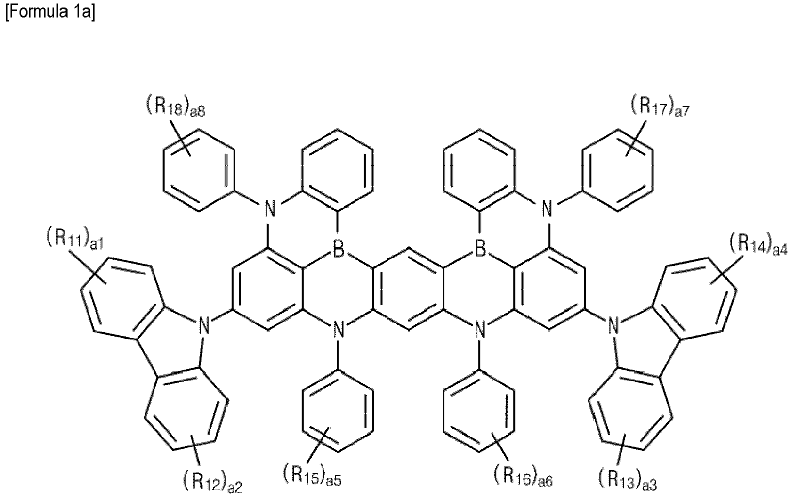

In Formula 1a, each of R₁₁, R₁₂, R₁₃, R₁₄, R₁₅, R₁₆, R₁₇ and R₁₈ is independently selected from the group consisting of deuterium, a substituted or unsubstituted C1 to C10 alkyl group and a substituted or unsubstituted C6 to C30 aryl group. Each of a1, a2, a3 and n4 is independently an integer of 0 to 4, and each of a5, a6, a7 and a8 is independently an integer of 0 to 5.

For example, in Formula 1a, each of R₁₁, R₁₂, R₁₃, R₁₄, R₁₅, R₁₆, R₁₇ and R₁₈ may be independently selected from a substituted or unsubstituted C1 to C10 alkyl group, e.g., methyl or tert-butyl, each of a1, a2, a3, a4, a5 and a6 may be independently 0 or 1, and each of a7 and a8 may be 0.

The first compound 362 in Formula 1 may be one of the compounds in Formula 2.

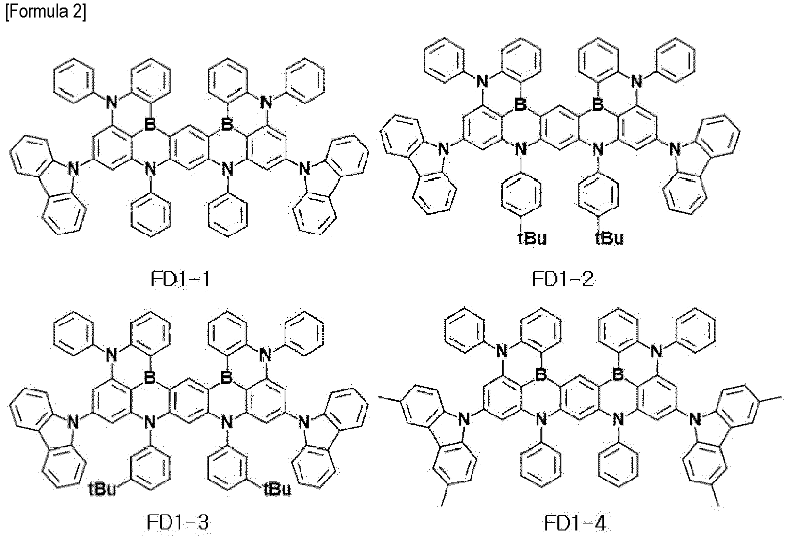

The second compound 364 is represented by Formula 3.

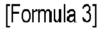

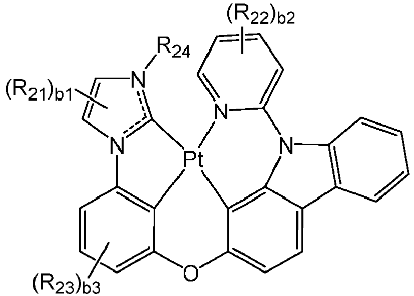

In Formula 3, each of R₂₁, R₂₂ and R₂₃ is independently selected from the group consisting of a substituted or unsubstituted C1 to C10 alkyl group, a substituted or unsubstituted C6 to C30 aryl group and a substituted or unsubstituted C5 to 30 heteroaryl group. b1 is an integer of 0 to 2, b2 is an integer of 0 to 4, and b3 is an integer of 0 to 3. R₂₄ is selected from the group consisting of absent, hydrogen, a substituted or unsubstituted C1 to C10 alkyl group, a substituted or unsubstituted C6 to C30 aryl group and a substituted or unsubstituted C5 to 30 heteroaryl group. R₂₄ may be selected from the group consisting of hydrogen, a substituted or unsubstituted C1 to C10 alkyl group, a substituted or unsubstituted C6 to C30 aryl group and a substituted or unsubstituted C5 to 30 heteroaryl group.

For example, in Formula 3, each of R₂₂, R₂₃ and R₂₄ may be independently selected from a substituted or unsubstituted C1 to C10 alkyl group, e.g., methyl or tert-butyl, b2 and b3 may be 1, and b1 may be 0.

The second compound 364 may be one of the compounds in Formula 4.

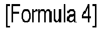

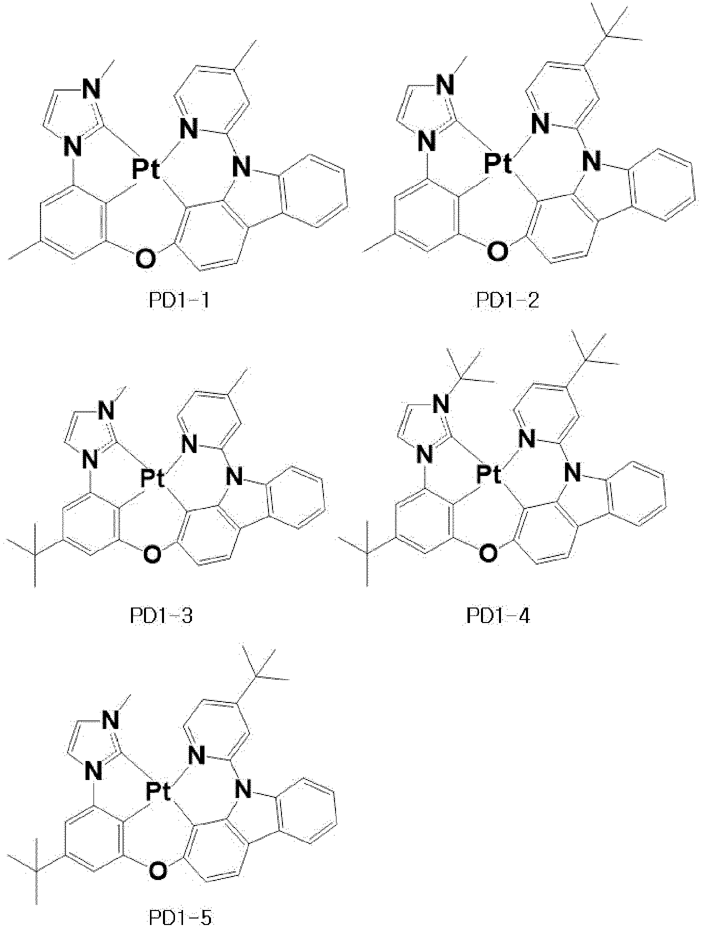

The third compound 366 may be represented by Formula 5.

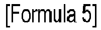

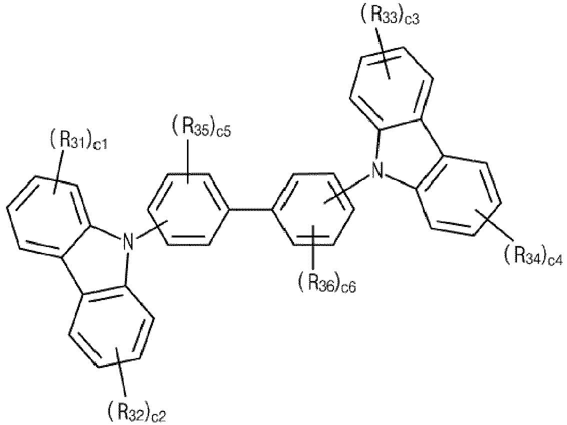

In Formula 5, each of R₃₁, R₃₂, R₃₃, R₃₄, R₃₅ and R₃₆ is independently selected from the group consisting of a substituted or unsubstituted C1 to C10 alkyl group, a substituted or unsubstituted C6 to C30 aryl group and a substituted or unsubstituted C5 to C30 heteroaryl group, and each of c1, c2, c3, c4, c5 and c6 is independently an integer of 0 to 4.

For example, each of R₃₁, R₃₂, R₃₃ and R₃₄ may be independently selected from a substituted or unsubstituted C1 to C10 alkyl group, e.g., methyl or tert-butyl and a substituted or unsubstituted C6 to C30 aryl group, e.g., phenyl unsubstituted or substituted with a C1 to C10 alkyl group, e.g., methyl, each of c1, c2, c3 and c4 may be independently 0 or 1, and c5 and c6 may be 0.

In Formula 5, a linking position of the carbazole moiety may be specified. Namely, Formula 5 may be represented by Formula 5a.

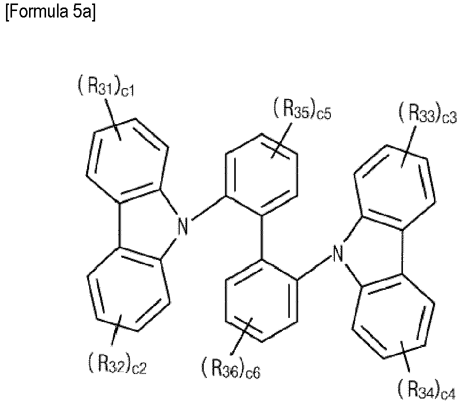

In Formula 5a, the definition of each of R₃₁, R₃₂, R₃₃, R₃₄, R₃₅, R₃₆, c1, c2, c3, c4, c5 and c6 is same as those in Formula 5.

For example, the third compound 366 may be one of the compounds in Formula 6.

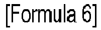

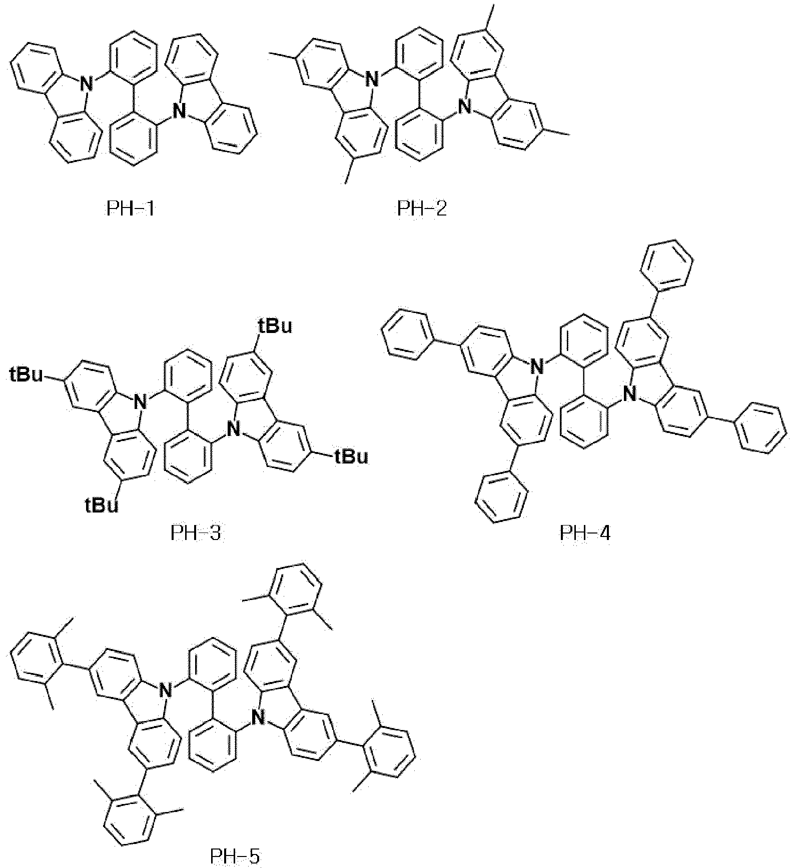

The fourth compound 368 is represented by Formula 7.

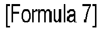

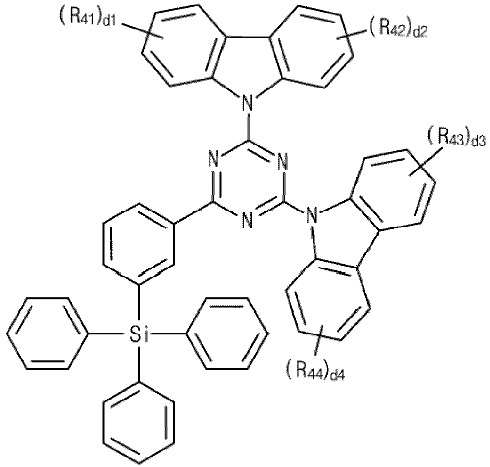

In Formula 7, each of R₄₁, R₄₂, R₄₃ and R₄₄ is independently selected from the group consisting of a substituted or unsubstituted C1 to C10 alkyl group, a substituted or unsubstituted C6 to C30 aryl group and a substituted or unsubstituted C5 to 30 heteroaryl group, and each of d1, d2, d3 and d4 is independently an integer of 0 to 4.

For example, each of R₄₁, R₄₂, R₄₃ and R₄₄ may be independently selected from a C1 to C10 alkyl group, e.g., methyl or tert-butyl, and a C6 to C30 aryl group, e.g., phenyl, unsubstituted or substituted with a C1 to C10 alkyl group, e.g., tert-butyl, and each of d1, d2, d3 and d4 may be independently 0 or 1.

The fourth compound 368 may be one of the compounds in Formula 8.

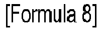

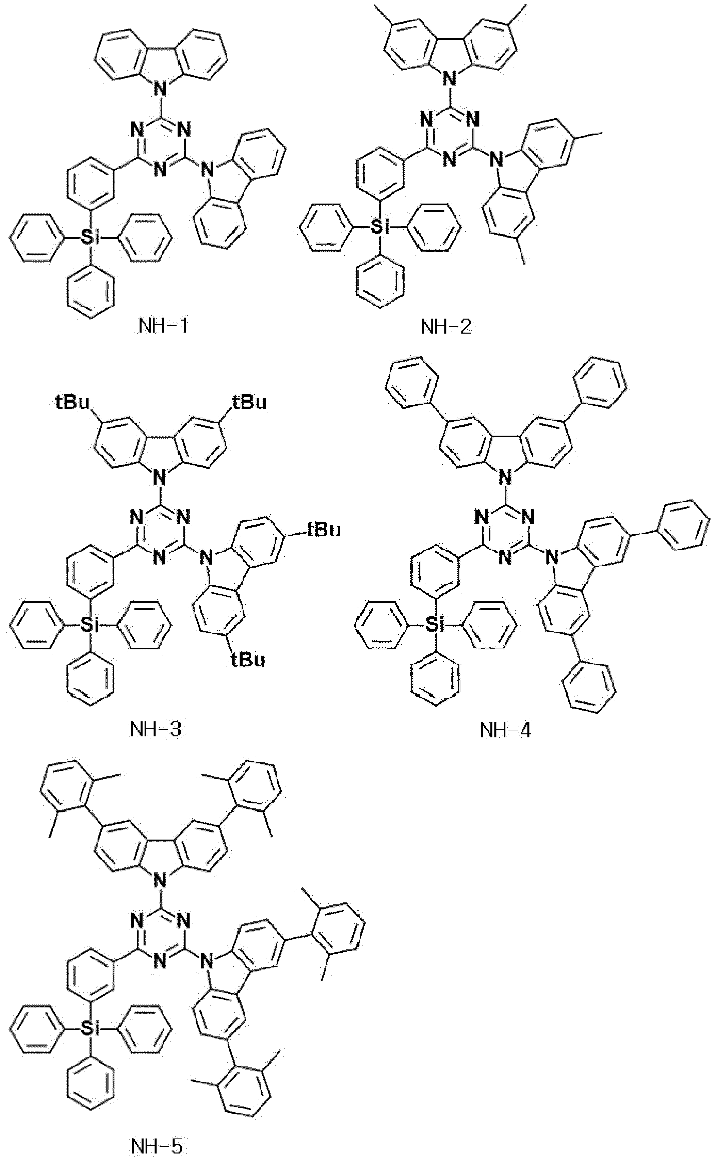

The second blue EML 360 being the PSF emitting layer consists of the first to fourth compounds 362, 364, 366 and 368. Namely, a summation of a weight % of the first compound 362, a weight % of the second compound 364, a weight % of the third compound 366 and a weight % of the fourth compound 368 in the second blue EML 360 is 100 wt%.

In the second blue EML 360, the weight % of the second compound 364 is greater than that of the first compound 362 and is smaller than each of the weight % of the third compound 366 and the weight % of the fourth compound 368. The weight % of the third compound 366 and the weight % of the fourth compound 368 may be same or different. For example, in the second blue EML 360, with respect to the first compound 362, the second compound 364 may have a weight % of about 500 to 2000, and each of the third and fourth compounds 366 and 368 may have a weight % of about 3000 to 6000.

In the second blue EML 360, a difference" I λmax(FD1_Abs)-λmax(PD_PL) I " between a maximum absorption wavelength "λmax(FD1_Abs)" of the first compound 362 "FD1" and a maximum emission wavelength "λmax(PD_PL)" of the second compound 364 "PD" is 10nm or less. As a result, the emission property of the OLED D1-B is significantly improved.

The first blue EML 320 being the fluorescent emitting layer includes a fifth compound 322 and a sixth compound 324. The fifth compound 322 is a fluorescent compound, e.g., a fluorescent emitter or a fluorescent dopant, and the sixth compound 324 is a host.

The fifth compound 322 is represented by Formula 9.

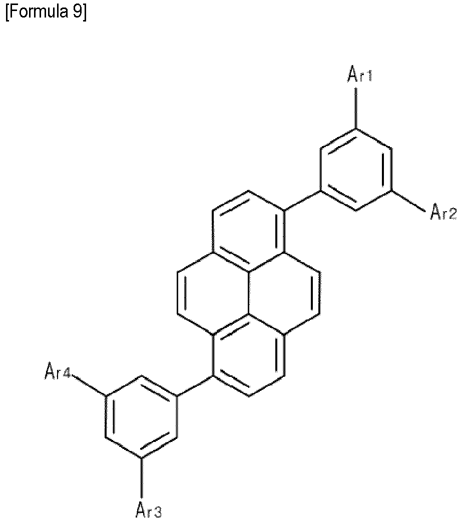

In Formula 9, each of Ar₁, Ar₂, Ar₃ and Ar₄ is independently selected from the group consisting of a substituted or unsubstituted C1 to C10 alkyl group, a substituted or unsubstituted C6 to C30 aryl group and a substituted or unsubstituted C6 to C30 arylamine (arylamino) group.

For example, each of Ar₁, Ar₂, Ar₃ and Ar₄ may be independently selected from a C1 to C10 alkyl group, e.g., tert-butyl, and a C6 to C30 aryl group, e.g., phenyl or naphthyl.

The fifth compound 322 may be one of the compounds in Formula 10.

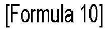

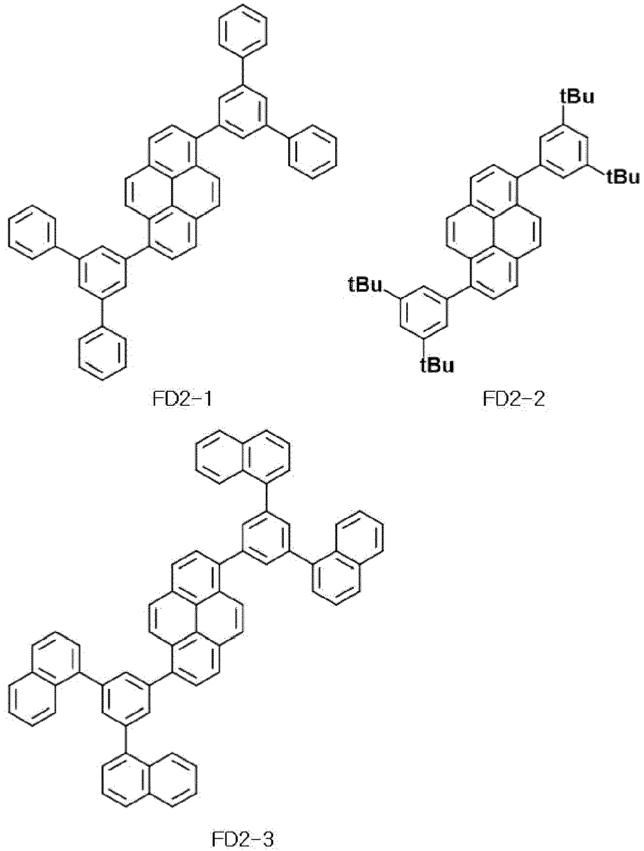

The sixth compound 324 is represented by Formula 5. The sixth compound 324 and the third compound 366 may be different.

In Formula 5, a linking position of the carbazole moiety may be specified. Namely, the sixth compound 324 may be represented by Formula 11.

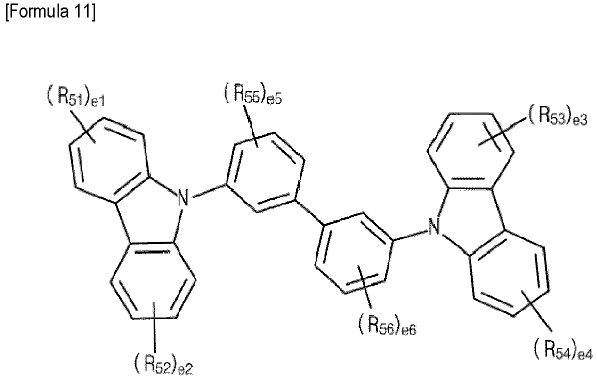

In Formula 11, each of R₅₁, R₅₂, R₅₃, R₅₄, R₅₅ and R₅₆ is independently selected from the group consisting of a substituted or unsubstituted C1 to C10 alkyl group, a substituted or unsubstituted C6 to C30 aryl group and a substituted or unsubstituted C5 to C30 heteroaryl group, and each of e1, e2, e3, e4, e5 and e6 is independently an integer of 0 to 4.

For example, each of R₅₁, R₅₂, R₅₃, R₅₄, R₅₅ and R₅₆ may be independently selected from a substituted or unsubstituted C1 to C10 alkyl group, e.g., methyl or tert-butyl and a substituted or unsubstituted C6 to C30 aryl group, e.g., phenyl unsubstituted or substituted with a C1 to C10 alkyl group, e.g., methyl, and each of e1, e2, e3, e4, e5 and e6 may be independently 0 or 1.

For example, the sixth compound 324 may be one of the compounds in Formula 12.

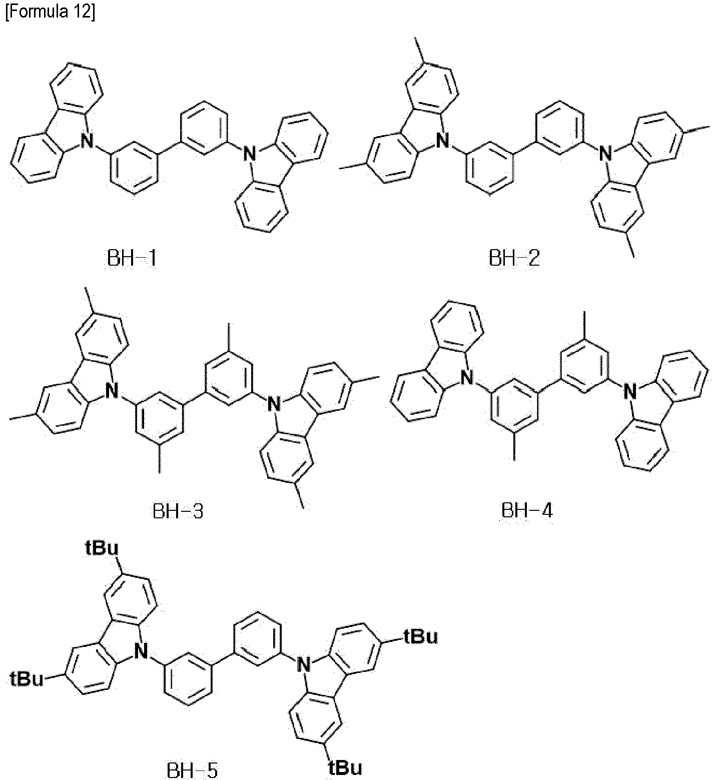

In the blue OLED D1-B, the second blue EML 360 being the PSF emitting layer is disposed to be closer to the second electrode 230 being the transparent electrode. Namely, the second blue EML 360 being the PSF emitting layer is positioned between the second electrode 230 being the transparent electrode and the first blue EML 320 being the fluorescent emitting layer.

The first blue EML 320 being the fluorescent emitting layer consists of the fifth and sixth compounds 322 and 324. Namely, a summation of a weight % of the fifth compound 322 and a weight % of the sixth compound 324 in the first blue EML 320 is 100 wt%.

In the first blue EML 320, the weight % of the fifth compound 233 is smaller than that of the sixth compound 324. For example, in the first blue EML 320, the fifth compound 322 may have a weight % of 0.1 to 10.

A difference" | I_{2nd}(EML2)-I_{2nd}(EML1) | " between a second emission peak intensity "I_{2nd}(EML2)" of the second blue EML 360 being the PSF emitting layer and a second emission peak intensity "I_{2nd}(EML1)" of the first blue EML 320 being the fluorescent emitting layer is 0.1 or less. As a result, strong cavity effect is provided in the blue OLED D1-B so that the blue OLED D1-B has lower driving voltage and significantly improved blue emitting efficiency.

In addition, a difference" I Amax(FD2_PL)-Amax(FD1_PL) I " between a maximum emission wavelength "Amax(FD2_PL)" of the fifth compound 322 "FD2" in the first blue EML 320 being the fluorescent emitting layer and a maximum emission wavelength "Amax(FD1_PL)" of the first compound 362 "FD1" in the second blue EML 360 being the PSF emitting layer is 15nm or less. As a result, the emitting property of the blue OLED D1-B is further improved.

In the specification, "the second emission peak" means that an emission peak having a second greatest intensity or an emission peak at an emission wavelength obtained by adding 30 nm to the maximum emission wavelength.

The first blue EML 320 has a first thickness t1, and the second blue EML 360 has a second thickness t2 being greater than the first thickness t1. For example, the first thickness t1 may have a range of 15 to 30nm, and the second thickness t2 may have a range of 25 to 40nm.

In the blue OLED D1-B, in which the first electrode 210 is a transparent electrode and the second electrode 230 is a reflective electrode, the second emitting part 350 including the second blue EML 360 being the PSF emitting layer is disposed to be closer to the first electrode 210. Namely, the second emitting part 350 including the second blue EML 360 being the PSF emitting layer is positioned between the first electrode 210 and the first emitting part 310 including the first blue EML 320 being the fluorescent emitting layer.

The first red EML 620 being the fluorescent emitting layer includes a seventh compound 622, an eighth compound 624 and a ninth compound 626. The seventh compound 622 is a fluorescent compound, e.g., a fluorescent emitter or a fluorescent dopant, the eighth compound 524 is a delayed fluorescent compound, e.g., an auxiliary dopant or an auxiliary host, and the ninth compound 626 is a host.

The second red EML 660 being the phosphorescent emitting layer includes a tenth compound 662 and an eleventh compound 664. The tenth compound 662 is a phosphorescent compound, e.g., a phosphorescent emitter or a phosphorescent dopant, and the eleventh compound 664 is a host.

In the red OLED D1-R, the second red EML 660 being the phosphorescent emitting layer is disposed to be closer to the second electrode 230 being the transparent electrode. Namely, the second red EML 660 being the phosphorescent emitting layer is positioned between the second electrode 230 being the transparent electrode and the first red EML 620 being the fluorescent emitting layer. Since the second red EML 660 being the phosphorescent emitting layer, which has higher emitting efficiency (cd/A) than the first red EML 620 being the fluorescent emitting layer, is disposed to be closer to the second electrode 230 being the transparent electrode, the emitting property of the red OLED D1-R is improved. For example, a quantum efficiency of the tenth compound 662 in the second red EML 660 may be greater than that of the seventh compound 622 in the first red EML 620.

The first green EML 720 being the phosphorescent emitting layer includes a twelfth compound 722 and a thirteenth compound 724. The twelfth compound 722 is a phosphorescent compound, e.g., a phosphorescent emitter or a phosphorescent dopant, and the thirteenth compound 724 is a host.

The second green EML 760 being the fluorescent emitting layer includes a fourteenth compound 762, a fifteenth compound 764 and a sixteenth compound 766. The fourteenth compound 762 is a fluorescent compound e.g., a fluorescent emitter or a fluorescent dopant, the fifteenth compound 764 is a delayed fluorescence compound e.g., an auxiliary dopant or an auxiliary host, and the sixteenth compound 766 is a host.

In the red OLED D1-R, in which the first electrode 210 is a transparent electrode and the second electrode 230 is a reflective electrode, the second emitting part 650 including the second red EML 660 being the phosphorescent emitting layer is disposed to be closer to the first electrode 210 being the transparent electrode. Namely, the second emitting part 650 including the second red EML 660 being the phosphorescent emitting layer is positioned between the first electrode 210 being the transparent electrode and the first emitting part 610 including the first red EML 620 being the fluorescent emitting layer.

In the green OLED D1-G, the second green EML 760 being the fluorescent emitting layer is disposed to be closer to the second electrode 230 being the transparent electrode. Namely, the second green EML 760 being the fluorescent emitting layer is positioned between the second electrode 230 being the transparent electrode and the first green EML 720 being the phosphorescent emitting layer. Since the second green EML 760 being the fluorescent emitting layer, which has higher emitting efficiency (cd/A) than the first green EML 720 being the phosphorescent emitting layer, is disposed to be closer to the second electrode 230 being the transparent electrode, the emitting property of the green OLED D1-G is improved. For example, a quantum efficiency of the fifteenth compound 762 in the second green EML 760 may be greater than that of the twelfth compound 722 in the first green EML 720.

In the green OLED D1-R, in which the first electrode 210 is a transparent electrode and the second electrode 230 is a reflective electrode, the second emitting part 750 including the second green EML 760 being the fluorescent emitting layer is disposed to be closer to the first electrode 210 being the transparent electrode. Namely, the second emitting part 750 including the second green EML 760 being the fluorescent emitting layer is positioned between the first electrode 210 being the transparent electrode and the first emitting part 710 including the first green EML 720 being the phosphorescent emitting layer.

The seventh compound 622 in the first red EML 620 may be represented by Formula 13.

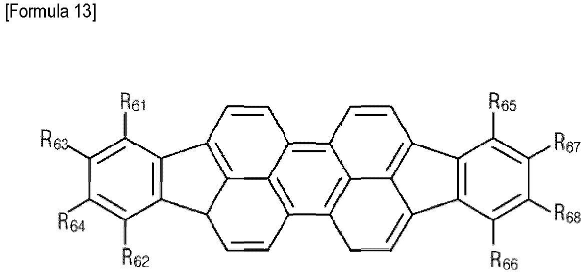

In Formula 13, each of R₆₁ and R₆₂ is independently selected from the group consisting of hydrogen and a substituted or unsubstituted C6 to C30 aryl group. Each of R₆₃ and R₆₄ is independently selected from the group consisting of hydrogen, a substituted or unsubstituted C1 to C10 alkyl group and a substituted or unsubstituted C6 to C30 aryl group, or R₆₃ and R₆₄ are connected to each other to form a substituted or unsubstituted aromatic ring or a substituted or unsubstituted fused-ring. Each of R₆₅ and R₆₆ is independently selected from the group consisting of hydrogen and a substituted or unsubstituted C6 to C30 aryl group. Each of R₆₇ and R₆₈ is independently selected from the group consisting of hydrogen, a substituted or unsubstituted C1 to C10 alkyl group and a substituted or unsubstituted C6 to C30 aryl group, or R₆₇ and R₆₈ are connected to each other to form a substituted or unsubstituted aromatic ring or a substituted or unsubstituted fused-ring.

For example, the seventh compound 622 in the first red EML 620 may be one of the compounds in Formula 14.

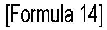

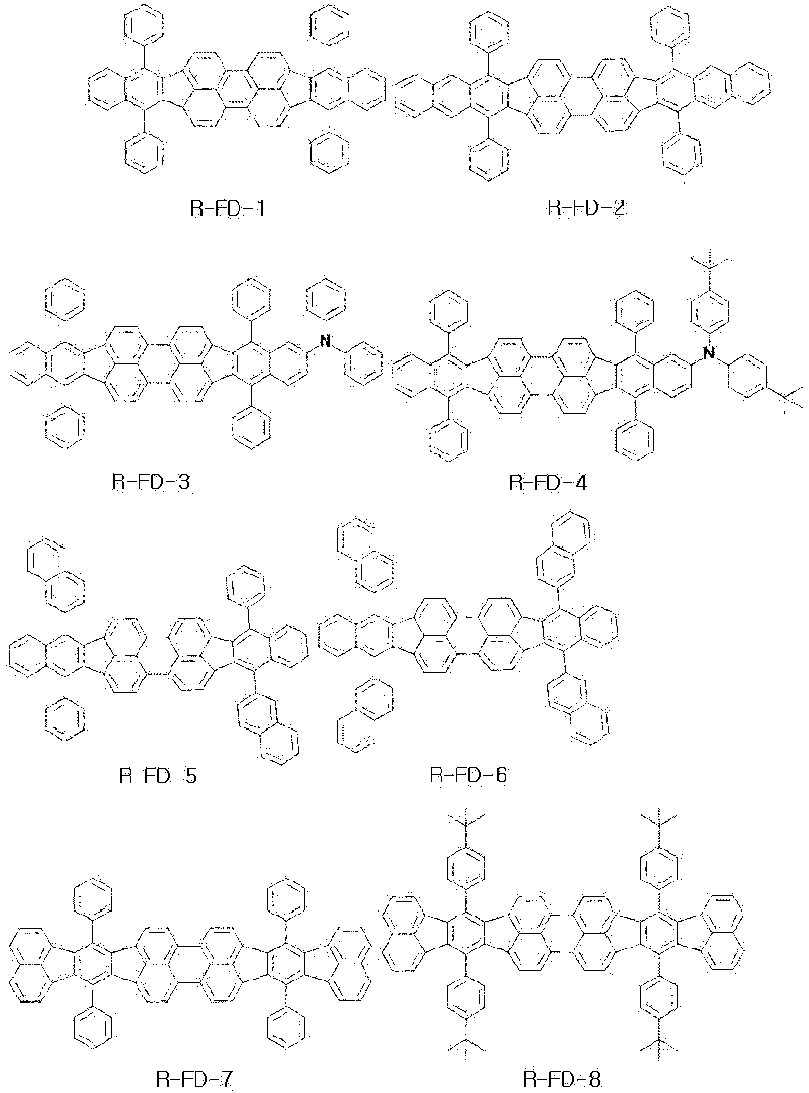

Each of the eighth compound 624 in the first red EML 620 and the fifteenth compound 764 in the second green EML 760 is represented by Formula 15.

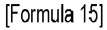

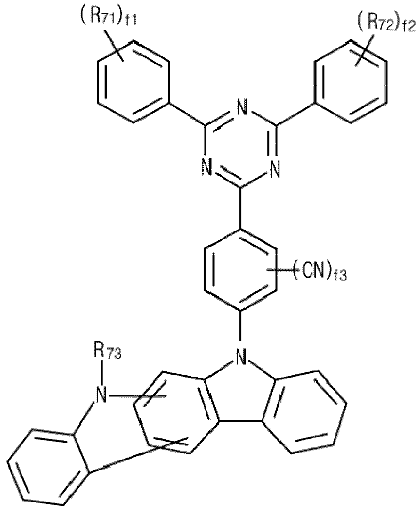

In Formula 15, each of R₇₁ and R₇₂ is independently selected from the group consisting of a substituted or unsubstituted C1 to C10 alkyl group and a substituted or unsubstituted C6 to C30 aryl group, and R₇₃ is selected from the group consisting of hydrogen, a substituted or unsubstituted C1 to C10 alkyl group and a substituted or unsubstituted C6 to C30 aryl group. Each of f1 and f2 is independently an integer of 0 to 5, and f3 is an integer of 1 to 4.

For example, each of R₇₁ and R₇₂ may be a C1 to C10 alkyl group, e.g., methyl or tert-butyl, and each of f1 and f2 may be independently 0 or 1. R₇₃ may be a C6 to C30 aryl group, e.g., phenyl, unsubstituted or substituted with a C1 to C10 alkyl group, e.g., methyl, and f3 may be 1.

The eighth compound 624 in the first red EML 620 and the fifteenth compound 764 in the second green EML 760 may be same or different. For example, each of the eighth compound 624 in the first red EML 620 and the fifteenth compound 764in the second green EML 760 may be independently selected from the compounds in Formula 16.

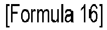

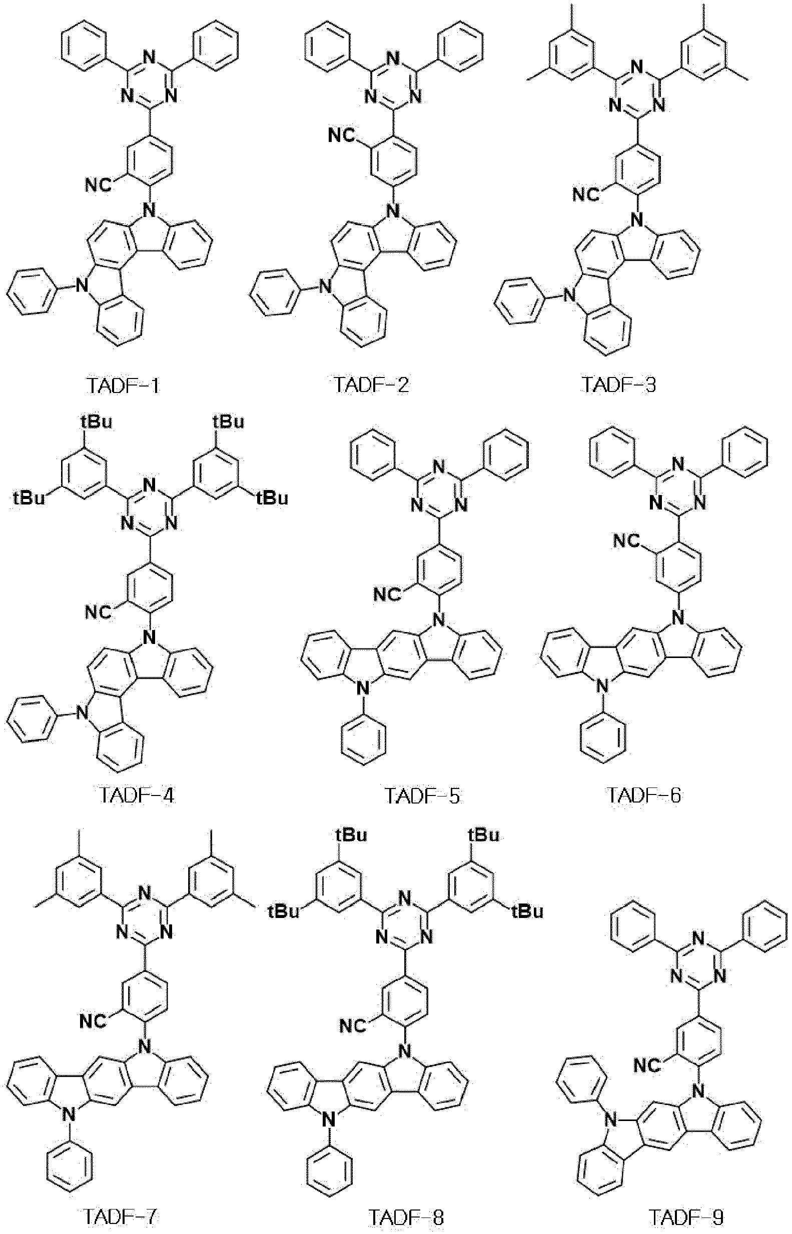

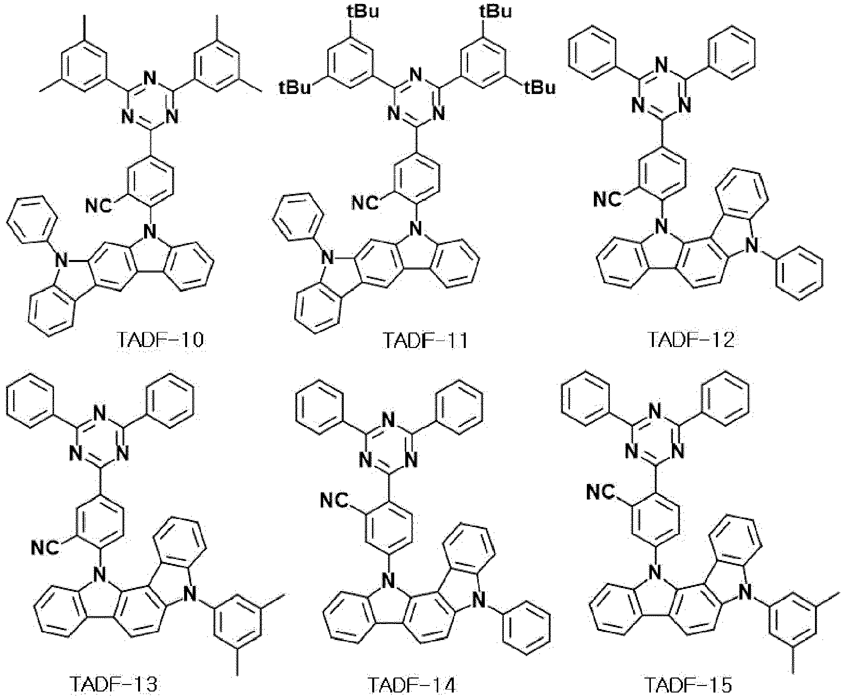

The tenth compound 662 in the second red EML 660 is one of the compounds in Formula 17.

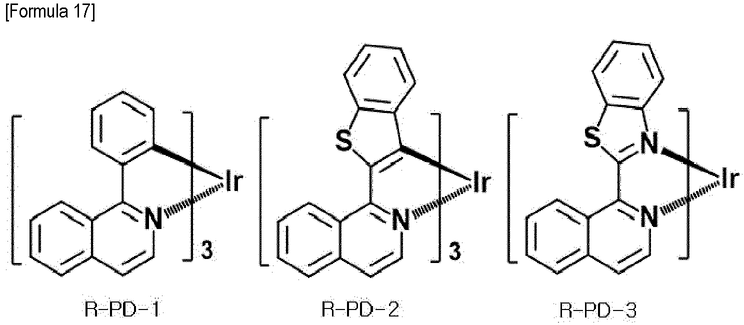

The twelfth compound 722 in the first green EML 720 is one of the compounds in Formula 18.

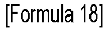

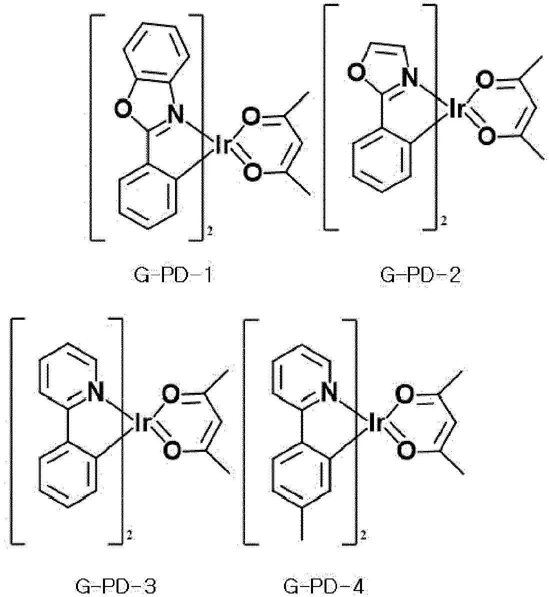

The fourteenth compound 762 in the second green EML 760 is represented by Formula 19.

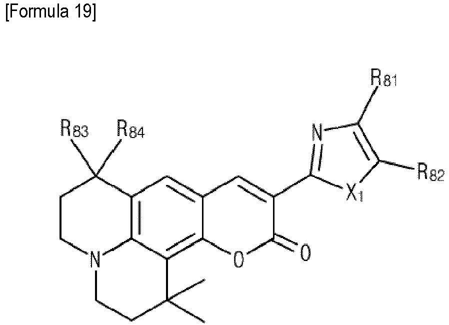

In Formula 19, X1 is O or S. Each of R₈₁ and R₈₂ is independently selected from the group consisting of hydrogen, a substituted or unsubstituted C1 to C10 alkyl group and a substituted or unsubstituted C6 to C30 aryl group, or R₈₁ and R₈₂ are connected to each other to form a substituted or unsubstituted aromatic ring. Each of R₈₃ and R₈₄ is independently selected from the group consisting of hydrogen, a substituted or unsubstituted C1 to C10 alkyl group and a substituted or unsubstituted C6 to C30 aryl group, or R₈₃ and R₈₄ are connected to each other to form a substituted or unsubstituted aromatic ring.

For example, the fourteenth compound 762 in the second green EML 760 may be one of the compounds in Formula 20.

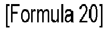

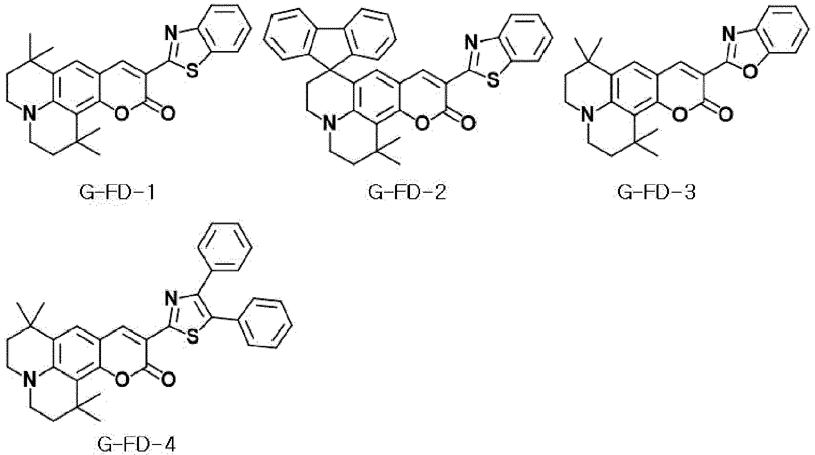

Each of the ninth compound 626 in the first red EML 620 and the eleventh compound 664 in the second red EML 660 is represented by Formula 21.

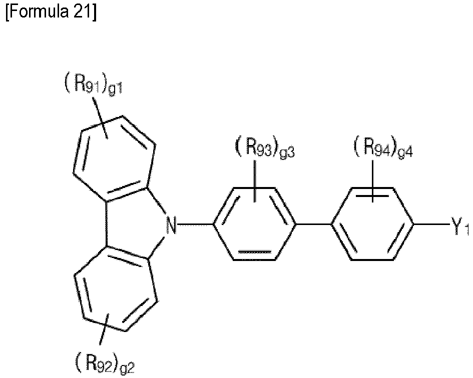

In Formula 21, each of R₉₁, R₉₂, R₉₃ and R₉₄ is independently selected from the group consisting of a substituted or unsubstituted C1 to C10 alkyl group and a substituted or unsubstituted C6 to C30 aryl group, and each of g1, g2, g3 and g4 is independently an integer of 0 to 4. Y₁ is represented by Formula 21a or Formula 21b.

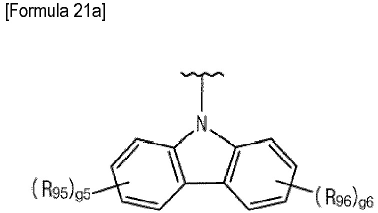

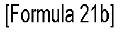

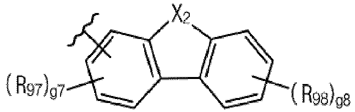

In Formula 21a, each of R₉₅ and R₉₆ is independently selected from the group consisting of a substituted or unsubstituted C1 to C10 alkyl group and a substituted or unsubstituted C6 to C30 aryl group, and each of g5 and g6 is independently an integer of 0 to 4.

In Formula 21b, each of R₉₇ and R₉₈ is independently selected from the group consisting of a substituted or unsubstituted C1 to C10 alkyl group and a substituted or unsubstituted C6 to C30 aryl group, g7 is an integer of 0 to 3, and g8 is an integer of 0 to 4. X₂ is NR₉₉, O or S, and R₉₉ is selected from the group consisting of hydrogen, a substituted or unsubstituted C1 to C10 alkyl group and a substituted or unsubstituted C6 to C30 aryl group.

The ninth compound 626 in the first red EML 620 and the eleventh compound 664 in the second red EML 660 may be same or different.

Each of the ninth compound 626 in the first red EML 620 and the eleventh compound 664 in the second red EML 660 may be independently selected from the compounds in Formula 22.

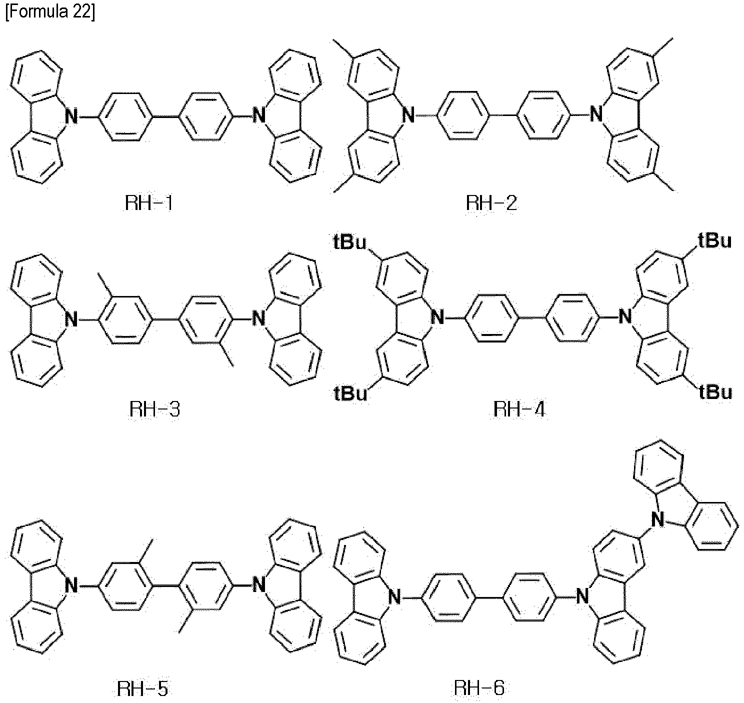

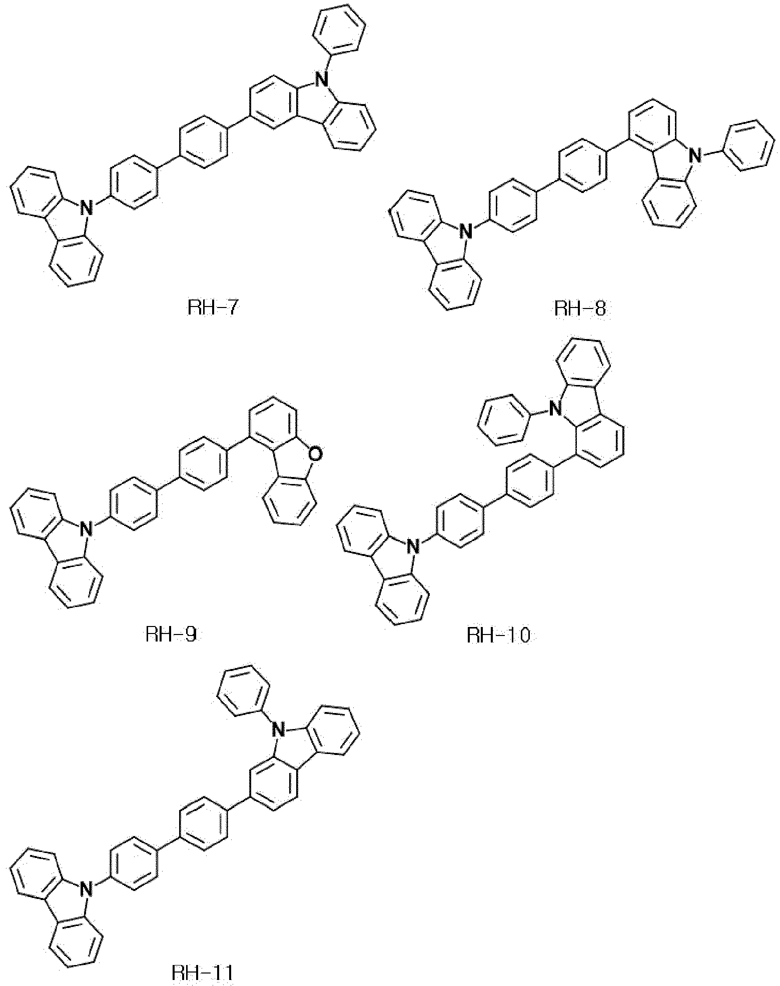

Each of the thirteenth compound 724 in the first green EML 720 and the sixteenth compound 766 in the second green EML 760 is represented by Formula 23.

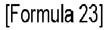

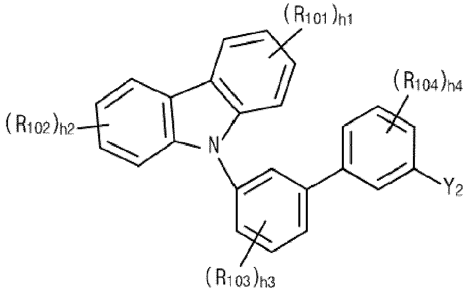

In Formula 23, each of R₁₀₁ and R₁₀₂ is independently selected from the group consisting of a substituted or unsubstituted C1 to C10 alkyl group and a substituted or unsubstituted C6 to C30 aryl group. Each of R₁₀₃ and R₁₀₄ is independently selected from the group consisting of a substituted or unsubstituted C1 to C10 alkyl group and a substituted or unsubstituted C6 to C30 aryl group, or R₁₀₃ and R₁₀₄ are connected to each other to form a substituted or unsubstituted hetero ring. Each of h1, h2, h3 and h4 is independently an integer of 0 to 4, and Y₂ is represented by Formula 23a or Formula 23b.

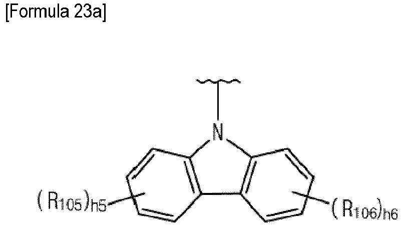

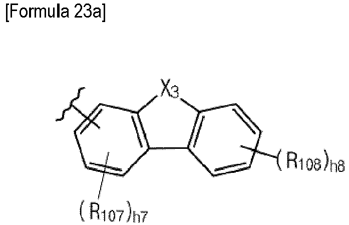

In Formula 23a, each of R₁₀₅ and R₁₀₆ is independently selected from the group consisting of a substituted or unsubstituted C1 to C10 alkyl group and a substituted or unsubstituted C6 to C30 aryl group, and each of h5 and h6 is independently an integer of 0 to 4.

In Formula 23b, each of R₁₀₇ and R₁₀₈ is independently selected from the group consisting of a substituted or unsubstituted C1 to C10 alkyl group and a substituted or unsubstituted C6 to C30 aryl group, h7 is an integer of 0 to 3, and h8 is an integer of 0 to 4. X₃ is NR₁₀₉, O or S, and R₁₀₉ is selected from the group consisting of hydrogen, a substituted or unsubstituted C1 to C10 alkyl group and a substituted or unsubstituted C6 to C30 aryl group.

The thirteenth compound 724 in the first green EML 720 and the sixteenth compound 766 in the second green EML 760 may be same or different. In addition, the thirteenth compound 724 in the first green EML 720 and the sixteenth compound 766 in the second green EML 760 may be same as or different from the sixth compound 324 in the first blue EML 320.

Each of the thirteenth compound 724 in the first green EML 720 and the sixteenth compound 766 in the second green EML 760 may be independently selected from the compounds in Formula 24.

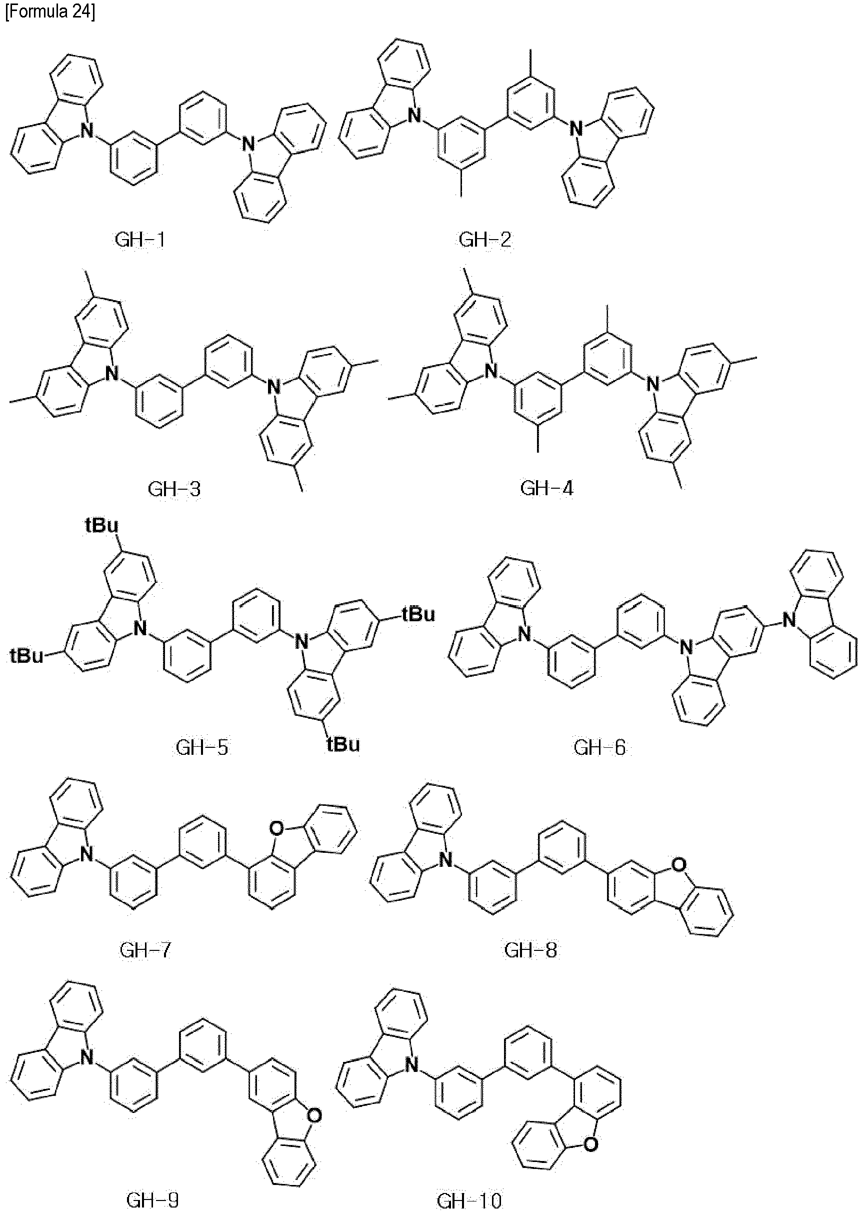

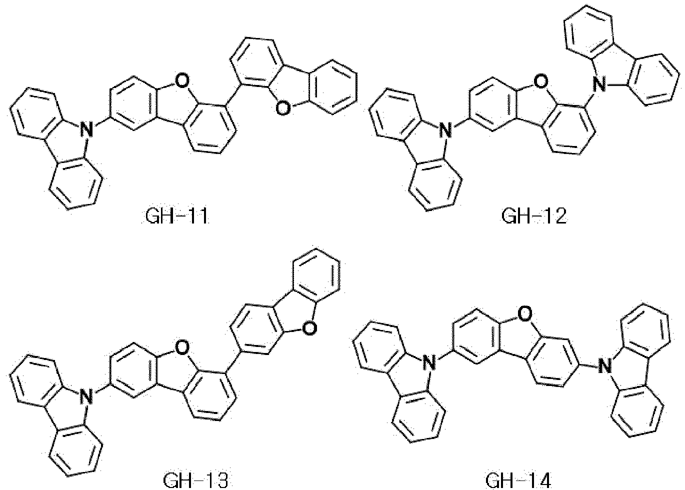

The first red EML 620 in the red OLED D1-R consists of the seventh to ninth compounds 622, 624 and 626. Namely, a summation of a weight % of the seventh compound 622, a weight % of the eighth compound 624 and a weight % of ninth compound 626 in the first red EML 620 is 100wt%.

In the first red EML 620 of the red OLED D1-R, the weight % of the eighth compound 624 is greater than that of the seventh compound 622 and is equal to or smaller than that of the ninth compound 626. For example, in the first red EML 620, with respect to the seventh compound 622, each of the eighth compound 624 the ninth compound 626 may have a weight % of about 4000 to 6000.

The second red EML 660 in the red OLED D1-R consists of the tenth and eleventh compounds 662 and 664. Namely, a summation of a weight % of the tenth compound 664 and a weight % of the eleventh compound 664 in the second red EML 660 is 100wt%.

In the second red EML 660 of the red OLED D1-R, the weight % of the eleventh compound 664 is greater than that of the tenth compound 662. For example, in the second red EML 660, the tenth compound 662 may have a weight % of about 0.1 to 10.

The first red EML 620 may have the same thickness as the first blue EML 320, and the second red EML 660 may have the same thickness as the second blue EML 360. Namely, the second red EML 660 may have a thickness being greater than the first red EML 620. For example, the first red EML 620 may have a thickness with a range of 15 to 30nm, and the second red EML 660 may have a thickness with a range of 25 to 40nm.

The first green EML 720 in the green OLED D1-G consists of the twelfth and thirteenth compounds 722 and 724. Namely, a summation of a weight % of the twelfth compound 724 and a weight % of the thirteenth compound 724 in the first green EML 720 is 100wt%.

In the first green EML 720 of the green OLED D1-G, the weight % of the thirteenth compound 724 is greater than that of the twelfth compound 722. For example, in the first green EML 720, the twelfth compound 722 may have a weight % of about 0.1 to 15.

The second green EML 760 in the green OLED D1-G consists of the fourteenth to sixteenth compounds 762, 764 and 766. Namely, a summation of a weight % of the fourteenth compound 762, a weight % of the fifteenth compound 764 and a weight % of sixteenth compound 766 in the second green EML 760 is 100wt%.

In the second green EML 760 of the green OLED D1-G, the weight % of the fifteenth compound 764 is greater than that of the fourteenth compound 762 and is equal to or smaller than that of the sixteenth compound 766. For example, in the second green EML 760, with respect to the fourteenth compound 762, each of the fifteenth compound 764 the sixteenth compound 766 may have a weight % of about 4000 to 6000.

The first green EML 720 may have the same thickness as the first blue EML 320, and the second green EML 760 may have the same thickness as the second blue EML 360. Namely, the second green EML 760 may have a thickness being greater than the first green EML 720. For example, the first green EML 720 may have a thickness with a range of 15 to 30nm, and the second green EML 760 may have a thickness with a range of 25 to 40nm.

Each of the HILs 311, 611 and 711 may include the compound (HAT-CN) in Formula 25.

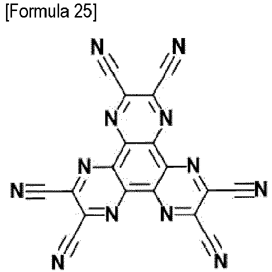

Alternatively, each of the HILs 311, 611 and 711 may include one of the compounds selected from the group consisting of 4,4',4"-tris(3-methylphenylamino)triphenylamine (MTDATA), 4,4',4"-tris(N,N-diphenyl-amino)triphenylamine (NATA), 4,4',4"-tris(N-(naphthalene-1-yl)-N-phenyl-amino)triphenylamine (1T-NATA), 4,4',4"-tris(N-(naphthalene-2-yl)-N-phenyl-amino)triphenylamine (2T-NATA), copper phthalocyanine (CuPc), tris(4-carbazoyl-9-yl-phenyl)amine (TCTA), N,N'-diphenyl-N,N'-bis(1-naphthyl)-1,1'-biphenyl-4,4"-diamine (NPB or NPD), 1,4,5,8,9,11-hexaazatriphenylenehexacarbonitrile(dipyrazino[2,3-f:2'3'-h]quinoxaline-2,3,6,7,10,11-hexacarbonitrile (HAT-CN), 1,3,5-tris[4-(diphenylamino)phenyl]benzene (TDAPB), poly(3,4-ethylenedioxythiphene)polystyrene sulfonate (PEDOT/PSS) and N-(biphenyl-4-yl)-9,9-dimethyl-N-(4-(9-phenyl-9H-carbazol-3-yl)phenyl)-9H-fluoren-2-amine. Each of the HILs 311, 611 and 711 may have a thickness of 1 to 10nm.

Each of the first HTLs 313, 613 and 713 and the second HTLs 351, 651 and 751 may include the compound (NPB) in Formula 26.

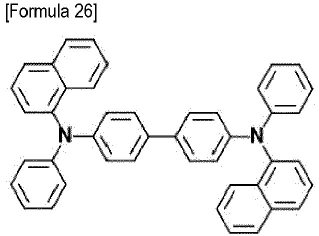

Alternatively, each of the first HTLs 313, 613 and 713 and the second HTLs 351, 651 and 751 may include one of the compounds selected from the group consisting of N,N'-diphenyl-N,N'-bis(3-methylphenyl)-1,1'-biphenyl-4,4'-diamine (TPD), NPB (or NPD), 4,4'-bis(N-carbazolyl)-1,1'-biphenyl (CBP), poly[N,N'-bis(4-butylphenyl)-N,N'-bis(phenyl)-benzidine] (Poly-TPD), (poly[(9,9-dioctylfluorenyl-2,7-diyl)-co-(4,4'-(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine and N-(biphenyl-4-yl)-N-(4-(9-phenyl-9H-carbazol-3-yl)phenyl)biphenyl-4-amine.

Each of the first HTLs 313, 613 and 713 and the second HTLs 351, 651 and 751 may have a thickness of 10 to 70nm. For example, a thickness of each of the first HTLs 313, 613 and 713 may be smaller than that of each of the second HTLs 351, 651 and 751, respectively.

Each of the first ETLs 319, 619 and 719 and the second ETLs 357, 657 and 757 may include the compound (TPBi) in Formula 27.

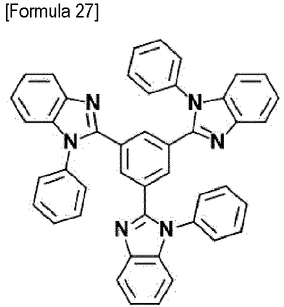

Alternatively, each of the first ETLs 319, 619 and 719 and the second ETLs 357, 657 and 757 may include one of the compounds selected from the group consisting of tris-(8-hydroxyquinoline aluminum (Alq₃), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,O8)-(1,1'-biphenyl-4-olato)aluminum(BAIq), 4,7-diphenyl-1,10-phenanthroline (Bphen), 2,9-bis(naphthalene-2-yl)4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(naphthalen-1-yl)-3,5-diphenyl-4H-1,2,4-triazole(NTAZ), 1,3,5-tri(p-pyrid-3-yl-phenyl)benzene (TpPyPB), 2,4,6-tris(3'-(pyridin-3-yl)biphenyl-3-yl)1,3,5-triazine (TmPPPyTz), poly[9,9-bis(3'-((N,N-dimethyl)-N-ethylammonium)-propyl)-2,7-fluorene]-alt-2,7-(9,9-dioctylfluorene)] (PFNBr), tris(phenylquinoxaline (TPQ) and diphenyl-4-triphenylsilyl-phenylphosphine oxide (TSPO1).

Each of the first ETLs 319, 619 and 719 and the second ETLs 357, 657 and 757 may have a thickness of 5 to 50nm. For example, a thickness of each of the first ETLs 319, 619 and 719 may be smaller than that of each of the second ETLs 357, 657 and 757, respectively.

Each of the EILs 359, 659 and 759 may include the compound (Liq) in Formula 28.

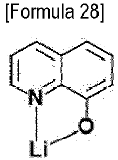

Alternatively, each of the EILs 359, 659 and 759 may include at least one of an alkali halide compound, such as LiF, CsF, NaF, or BaF₂, and an organo-metallic compound, such as lithium benzoate or sodium stearate. Each of the EILs 359, 659 and 759 may have a thickness of 1 to 10nm.

Each of the first EBLs 315, 615 and 715 and the second EBLs 353, 653, 753 may include the compound (TAPC) in Formula 29.

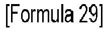

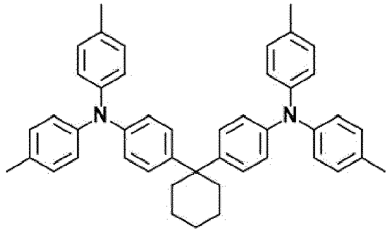

Alternatively, each of the first EBLs 315, 615 and 715 and the second EBLs 353, 653, 753 may include one of compounds selected from the group consisting of TCTA, tris[4-(diethylamino)phenyl]amine, N-(biphenyl-4-yl)-9,9-dimethyl-N-(4-(9-phenyl-9H-carbazol-3-yl)phenyl)-9H-fluoren-2-amine, TAPC, MTDATA, 1,3-bis(carbazol-9-yl)benzene (mCP), 3,3'-bis(N-carbazolyl)-1,1'-biphenyl (mCBP), CuPc, N,N'-bis[4-[bis(3-methylphenyl)amino]phenyl]-N,N'-diphenyl-[1,1'-biphenyl]-4,4'-diamine (DNTPD), TDAPB, DCDPA and 2,8-bis(9-phenyl-9H-carbazol-3-yl)dibenzo[b,d]thiophene).

Each of the first EBLs 315, 615 and 715 and the second EBLs 353, 653, 753 may have a thickness of 1 to 10nm. For example, a thickness of each of the first EBLs 315, 615 and 715 may be equal to that of each of the second EBLs 353, 653, 753, respectively.

Each of the first HBLs 317, 617 and 717 and the second HBLs 355, 655 and 755 may include the compound (B3PYMPM) in Formula 30.

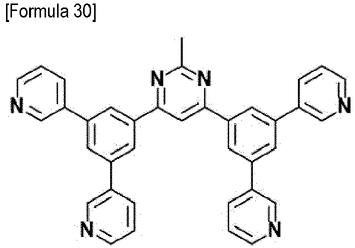

Alternatively, each of the first HBLs 317, 617 and 717 and the second HBLs 355, 655 and 755 may include one of BCP, BAIq, Alq3, PBD, spiro-PBD, Liq, bis-4,6-(3,5-di-3-pyridylphenyl)-2-methylpyrimidine (B3PYMPM), bis[2-(diphenylphosphino)phenyl]ether oxide (DPEPO), 9-(6-9H-carbazol-9-yl)pyridine-3-yl)-9H-3,9'-bicarbazole and TSPO1.

Each of the first HBLs 317, 617 and 717 and the second HBLs 355, 655 and 755 may have a thickness of 1 to 10nm. For example, a thickness of each of the first HBLs 317, 617 and 717 may be equal to that of each of the second HBLs 355, 655 and 755.

Each of the n-type CGLs 392, 692 and 792 may include a host, which is the material of the ETLs 319, 619, 719, 357, 657 and 757, and an n-type dopant. For example, the n-type dopant may be lithium (Li) and may be dopant with a weight % of 0.1 to 10.

Each of the p-type CGLs 394, 694 and 794 may include a host, which is the material of the HTLs 313, 613, 713, 351, 651 and 751, and a p-type dopant. For example, the p-type dopant may the compound in Formula 25 and may be dopant with a weight % of 10 to 30.

Each of the n-type CGLs 392, 692 and 792 and the p-type CGLs 394, 694 and 794 may have a thickness of 1 to 20nm. A thickness of each of the n-type CGLs 392, 692 and 792 may be greater than that of each of the p-type CGLs 394, 694 and 794, respectively.

The capping layer 290 is positioned on or over the second electrode 230 being the transparent electrode. For example, the capping layer 290 may include the material of the HTLs 313, 613, 713, 351, 651 and 751 and may have a thickness of 10 to 199nm.

As illustrated above, the blue OLED D1-B includes the first emitting part 310 including a fluorescent emitting layer and the second emitting part 350 including a PSF emitting layer, and the second emitting part 350 is disposed to be closer to the transparent electrode. In this instance, a difference" | I_{2nd}(EML2)-I_{2nd}(EML1) | " between a second emission peak intensity of the second blue EML 360 being the PSF emitting layer and a second emission peak intensity of the first blue EML 320 being the fluorescent emitting layer is 0.1 or less. As result, strong cavity effect is provided in the blue OLED D1-B so that the blue OLED D1-B has lower driving voltage and significantly-improved blue emitting efficiency.

In addition, the second blue EML 360 being the PSF emitting layer has higher emitting efficiency than the first blue EML 320 being the fluorescent emitting layer so that the cavity effect in the blue OLED D1-B is further strengthened.

Moreover, a difference" I Amax(FD2_PL)-Amax(FD1_PL) I " between a maximum emission wavelength "Amax(FD2_PL)" of the fifth compound 322 "FD2" in the first blue EML 320 being the fluorescent emitting layer and a maximum emission wavelength "Amax(FD1_PL)" of the first compound 362 "FD1" in the second blue EML 360 being the PSF emitting layer is 15nm or less. As a result, the emitting property of the blue OLED D1-B is further improved.

Furthermore, in the second blue EML 360 being the PSF emitting layer, a difference" | Amax(FD1_Abs)-λmax(PD_PL) | " between a maximum absorption wavelength "λmax(FD1_Abs)" of the first compound 362 "FD1" and a maximum emission wavelength "λmax(PD_PL)" of the second compound 364 "PD" is 10nm or less. As a result, the emitting property of the blue OLED D1-B is significantly improved.

Accordingly, the display performance of the organic light emitting display device including the blue OLED D1-B is improved.

The red OLED D1-R includes the first emitting part 610 including a fluorescent emitting layer and the second emitting part 650 including a phosphorescent emitting layer, which has a higher emitting efficiency than the fluorescent emitting layer in the first emitting part 610, and the second emitting part 650 is disposed to be closer to the transparent electrode. As a result, strong cavity effect is provided in the red OLED D1-R so that the red OLED D1-R has low driving voltage and significantly-improved red emitting efficiency.

The green OLED D1-G includes the first emitting part 710 including a phosphorescent emitting layer and the second emitting part 750 including a fluorescent emitting layer, which has a higher emitting efficiency than the phosphorescent emitting layer in the first emitting part 710, and the second emitting part 750 is disposed to be closer to the transparent electrode. As a result, strong cavity effect is provided in the green OLED D1-G so that the green OLED D1-G has low driving voltage and significantly-improved red emitting efficiency.

Accordingly, the display performance of the organic light emitting display device including the blue OLED D1-B, the red OLED D1-R and the green OLED D1-G is improved.

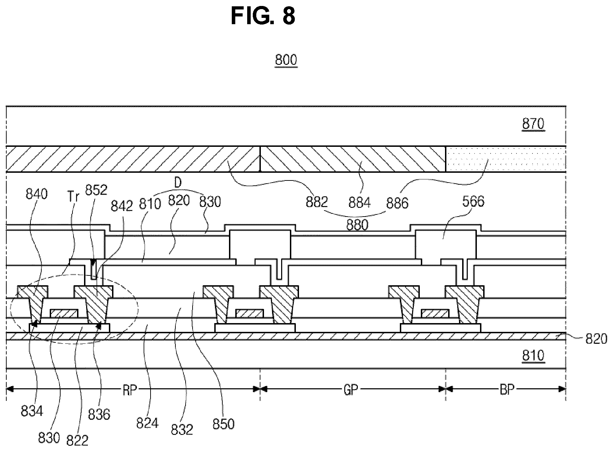

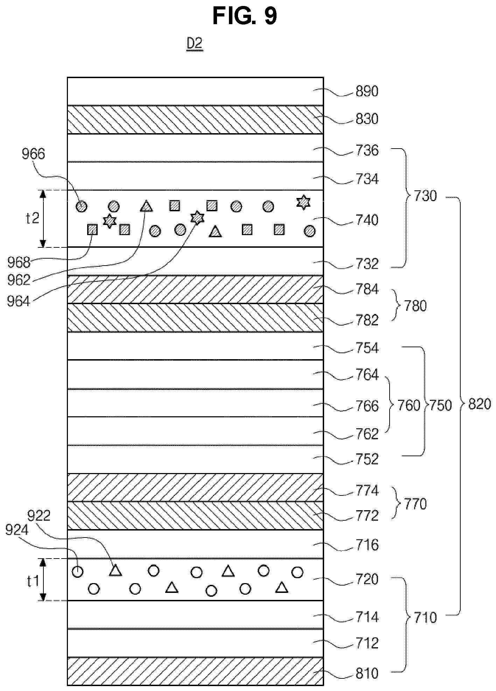

FIG. 8 is a schematic cross-sectional view of an organic light emitting display device according to a fourth embodiment of the present disclosure, and FIG. 9 is a schematic cross-sectional view of a white OLED of the present disclosure.

As shown in FIG. 8, the organic light emitting display device 800 includes a first substrate 810, where a red pixel region RP, a green pixel region GP and a blue pixel region BP are defined, a second substrate 870 facing the first substrate 810, an OLED D, which is positioned between the first and second substrates 810 and 870 and providing white emission, and a color filter layer 880 between the OLED D and the second substrate 870.

Each of the first and second substrates 810 and 870 may be a glass substrate or a flexible substrate. For example, each of the first and second substrates 810 and 870 may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 820 is formed on the substrate, and the TFT Tr corresponding to each of the red, green and blue pixel regions RP, GP and BP is formed on the buffer layer 820. The buffer layer 820 may be omitted.

A semiconductor layer 822 is formed on the buffer layer 820. The semiconductor layer 822 may include an oxide semiconductor material or polycrystalline silicon.

A gate insulating layer 824 is formed on the semiconductor layer 822. The gate insulating layer 824 may be formed of an inorganic insulating material such as silicon oxide or silicon nitride.

A gate electrode 830, which is formed of a conductive material, e.g., metal, is formed on the gate insulating layer 824 to correspond to a center of the semiconductor layer 822.

An interlayer insulating layer 832, which is formed of an insulating material, is formed on the gate electrode 830. The interlayer insulating layer 832 may be formed of an inorganic insulating material, e.g., silicon oxide or silicon nitride, or an organic insulating material, e.g., benzocyclobutene or photo-acryl.

The interlayer insulating layer 832 includes first and second contact holes 834 and 836 exposing both sides of the semiconductor layer 822. The first and second contact holes 834 and 836 are positioned at both sides of the gate electrode 830 to be spaced apart from the gate electrode 830.

A source electrode 840 and a drain electrode 842, which are formed of a conductive material, e.g., metal, are formed on the interlayer insulating layer 832.

The source electrode 840 and the drain electrode 842 are spaced apart from each other with respect to the gate electrode 830 and respectively contact both sides of the semiconductor layer 822 through the first and second contact holes 834 and 836.

The semiconductor layer 822, the gate electrode 830, the source electrode 840 and the drain electrode 842 constitute the TFT Tr. The TFT Tr serves as a driving element. Namely, the TFT Tr may correspond to the driving TFT Td (of FIG. 1).

Although not shown, the gate line and the data line cross each other to define the pixel region, and the switching TFT is formed to be connected to the gate and data lines. The switching TFT is connected to the TFT Tr as the driving element.

In addition, the power line, which may be formed to be parallel to and spaced apart from one of the gate and data lines, and the storage capacitor for maintaining the voltage of the gate electrode of the TFT Tr in one frame may be further formed.

A planarization layer 850, which includes a drain contact hole 852 exposing the drain electrode 842 of the TFT Tr, is formed to cover the TFT Tr.

A first electrode 810, which is connected to the drain electrode 842 of the TFT Tr through the drain contact hole 852, is separately formed in each pixel region and on the planarization layer 850. The first electrode 810 may be an anode and may include a transparent conductive oxide material layer, which is formed of a conductive material, e.g., a transparent conductive oxide (TCO), having a relatively high work function and a reflective layer. Namely, the first electrode 810 is a reflective electrode.

Alternatively, the first electrode 810 may have a single-layered structure of transparent conductive oxide material layer. Namely, the first electrode 810 may a transparent electrode.

For example, the transparent conductive oxide material layer of the first electrode 810 may be formed of one of indium-tin-oxide (ITO), indium-zinc-oxide (IZO), indium-tin-zinc-oxide (ITZO), tin oxide (SnO), zinc oxide (ZnO), indium-copper-oxide (ICO) and aluminum-zinc-oxide (AI:ZnO, AZO), and the reflective layer of the first electrode 810 may be formed of one of silver (Ag), an alloy of Ag and one of palladium (Pd), copper (Cu), indium (In) and neodymium (Nd), and aluminum-palladium-copper (APC) alloy. For example, the first electrode 810 may have a structure of ITO/Ag/ITO or ITO/APC/ITO.

A bank layer 866 is formed on the planarization layer 850 to cover an edge of the first electrode 810. Namely, the bank layer 866 is positioned at a boundary of the pixel region and exposes a center of the first electrode 810 in each of the red, green and blue pixel regions RP, GP and BP. The bank layer 866 may be omitted.

An organic light emitting layer 820 is formed on the first electrode 810, and the second electrode 830 is formed over the substrate 810 including the organic light emitting layer 820.

In the organic light emitting display device 800, since the light emitted from the organic light emitting layer 820 is incident to the color filter layer 880 through the second electrode 830, the second electrode 830 has a thin profile for transmitting the light.

The second electrode 830 covers an entire surface of the display area and may be formed of a conductive material having a relatively low work function to serve as a cathode. For example, the second electrode 830 may be formed of aluminum (Al), magnesium (Mg), calcium (Ca), silver (Ag) or their alloy, e.g., Mg-Ag alloy (MgAg). The second electrode 830 may have a thin profile, e.g., 10 to 30nm, to be transparent (or semi-transparent).

The first electrode 810, the organic emitting layer 820 and the second electrode 830 constitute the OLED D. The OLED D may further include a capping layer 890 (of FIG. 9) for enhancing the light extraction.

Referring to FIG. 9, the organic light emitting layer 820 includes a first emitting part 710 including a first blue EML 720, which is a fluorescent emitting layer, a second emitting part 730 including a second blue EML 740, which is a PSF emitting layer, and a third emitting part 750 including a third EML 760, which emits red light and yellow-green light. It will be appreciated, that the third EML 760 may comprise sublayers, a sublayer emitting red light and a sublayer emitting yellow-green light In addition, the organic light emitting layer 820 may further include a first CGL 770 between the first and third emitting parts 710 and 750 and a second CGL 780 between the second and third emitting parts 730 and 750.

The organic light emitting display device 800 includes the red, green and blue pixel regions RP, GP and BP, and the OLED D2 emits white light in the red, green and blue pixel regions RP, GP and BP.

The first emitting part 710 may further include at least one of a first HTL 714 under the first blue EML 720 and a first ETL 716 on the first blue EML 720. In addition, the first emitting part 710 may further include an HIL 712 under the first HTL 714.

Although not shown, the first emitting part 710 may further include at least one of a first EBL between the first blue EML 720 and the first HTL 714 and a first HBL between the first blue EML 720 and the first ETL 716.

The second emitting part 730 may further include at least one of a second HTL 732 under the second blue EML 740 and a second ETL 734 on the second blue EML 740. In addition, the second emitting part 730 may further include an EIL 736 on the second ETL 734.

Although not shown, the second emitting part 730 may further include at least one of a second EBL between the second blue EML 740 and the second HTL 732 and a second HBL between the second blue EML 740 and the second ETL 734.

In the third emitting part 750, the third EML 760 may include a red EML 762 and a green EML 764. The green EML 764 may be positioned between the red EML 762 and the second emitting part 730. In addition, the third EML 760 may further include a yellow-green EML between the red EML 762 and the green EML 764.

The red EML 762 may include a red host and a red dopant (emitter), the green EML 764 may include a green host and a green dopant, and the yellow-green EML may include a yellow-green host and a yellow-green dopant. Each of the red dopant, the green dopant and the yellow-green dopant may be a fluorescent compound, a phosphorescent compound and a delayed fluorescent compound.

The third emitting part 750 may further include at least one of a third HTL 752 under the third EML 760 and a third ETL 754 on the third EML 760.

Although not shown, the third emitting part 750 may further include at least one of a third EBL between the third EML 760 and the third HTL 752 and a third HBL between the third EML 760 and the third ETL 754.

The first CGL 770 is positioned between the first and third emitting parts 710 and 750, and the second CGL 780 is positioned between the second and third emitting parts 730 and 750. Namely, the first emitting part 710, the first CGL 770, the third emitting part 750, the second CGL 780 and the second emitting part 730 are sequentially stacked on the first electrode 810. In other words, the first emitting part 710 is positioned between the first electrode 810 and the first CGL 770, the third emitting part 750 is positioned between the first and second CGLs 770 and 780, and the second emitting part 730 is positioned between the second electrode 830 and the second CGL 780.

The first CGL 770 may be a P-N junction CGL of a first N-type CGL 772 and a first P-type CGL 774, and the second CGL 780 may be a P-N junction CGL of a second N-type CGL 782 and a second P-type CGL 784.

In the first CGL 770, the first N-type CGL 772 is positioned between the first ETL 716 and the third HTL 752, and the first P-type CGL 774 is positioned between the first N-type CGL 772 and the third HTL 752.

In the second CGL 780, the second N-type CGL 782 is positioned between the third ETL 754 and the second HTL 732, and the second P-type CGL 784 is positioned between the second N-type CGL 782 and the second HTL 732.

The second blue EML 740 includes a first compound 742 represented by Formula 1, a second compound 744 represented by Formula 3, a third compound 746 represented by Formula 5 and a fourth compound 748 represented by Formula 7, and the first blue EML 720 includes a fifth compound 722 represented by Formula 9 and a sixth compound 724 represented by Formula 11.

Namely, the first blue EML 720 is a fluorescent emitting layer, and the second blue EML 740 is a PSF emitting layer.

A difference" | I_{2nd}(EML2)-I_{2nd}(EML1) | " between a second emission peak intensity of the second blue EML 740 being the PSF emitting layer and a second emission peak intensity of the first blue EML 720 being the fluorescent emitting layer is 0.1 or less. As result, strong cavity effect is provided in the OLED D2 so that the OLED D2 has lower driving voltage and significantly-improved blue emitting efficiency.

In addition, the second blue EML 740 being the PSF emitting layer has higher emitting efficiency than the first blue EML 720 being the fluorescent emitting layer so that the cavity effect in the OLED D2 is further strengthened.

Moreover, a difference" I Amax(FD2_PL)-Amax(FD1_PL) I " between a maximum emission wavelength "Amax(FD2_PL)" of the fifth compound 722 "FD2" in the first blue EML 720 being the fluorescent emitting layer and a maximum emission wavelength "Amax(FD1_PL)" of the first compound 742 "FD1" in the second blue EML 740 being the PSF emitting layer is 15nm or less. As a result, the emitting property of the OLED D2 is further improved.

Furthermore, in the second blue EML 740 being the PSF emitting layer, a difference" | Amax(FD1_Abs)-λmax(PD_PL) | " between a maximum absorption wavelength "λmax(FD1_Abs)" of the first compound 742 "FD1" and a maximum emission wavelength "λmax(PD_PL)" of the second compound 744 "PD" is 10nm or less. As a result, the emitting property of the OLED D2 is significantly improved.

Referring back to FIG. 8, the color filter layer 880 is disposed over the OLED D2 and includes a red color filter 882, a green color filter 884 and a blue color filter 886 respectively corresponding to the red, green and blue pixels RP, GP and BP.

The red color filter 882 may include at least one of red dye and red pigment, the green color filter 884 may include at least one of green dye and green pigment, and the blue color filter 886 may include at least one of blue dye and blue pigment.

Although not shown, the color filter layer 880 may be attached to the OLED D2 by using an adhesive layer. Alternatively, the color filter layer 880 may be formed directly on the OLED D2.

An encapsulation film (not shown) may be formed to prevent penetration of moisture into the OLED D2. For example, the encapsulation film may include a first inorganic insulating layer, an organic insulating layer and a second inorganic insulating layer sequentially stacked, but it is not limited thereto. The encapsulation film may be omitted.

A polarization plate (not shown) for reducing an ambient light reflection may be attached to an outer side of the second substrate 870. For example, the polarization plate may be a circular polarization plate.

In the OLED of FIG. 8, the light from the OLED D2 passes through the second electrode 830, and the color filter layer 880 is disposed over the OLED D2. Alternatively, the light from the OLED D2 passes through the first electrode 810, and the color filter layer 880 may be disposed between the OLED D2 and the first substrate 710. In this instance, the second emitting part 730 including the second blue EML 740 being the PSF emitting layer is disposed to be closer to the first electrode 810, and the first emitting part 710 including the first blue EML 720 being the fluorescent emitting layer is disposed between the third emitting part 750 and the second electrode 830.

A color conversion layer (not shown) may be formed between the OLED D2 and the color filter layer 880. The color conversion layer may include a red color conversion layer, a green color conversion layer and a blue color conversion layer respectively corresponding to the red, green and blue pixels RP, GP and BP. The white light from the OLED D2 is converted into the red light, the green light and the blue light by the red, green and blue color conversion layer, respectively. For example, the color conversion layer may include a quantum dot.

As described above, in the organic light emitting display device 800, the OLED D2 in the red, green and blue pixels RP, GP and BP emits the white light, and the white light from the OLED D2 passes through the red color filter 882, the green color filter 884 and the blue color filter 886. As a result, the red light, the green light and the blue light are provided from the red pixel RP, the green pixel GP and the blue pixel BP, respectively.

In FIG. 8, the OLED D2 emitting the white light is used for a display device. Alternatively, the OLED D2 may be formed on an entire surface of a substrate without at least one of the driving element and the color filter layer to be used for a lightening device. The display device and the lightening device each including the OLED D2 of the present disclosure may be referred to as an organic light emitting device.

In the organic light emitting display device 800, the white OLED D2 is formed in all of the red, green and blue pixel regions RP, GP and BP, and a full color image is provided by using the color filter layer 880.

### [OLED]

An anode (ITO/Ag/ITO, 10nm), an HIL (the compound in Formula 25, 3nm), a first HTL (the compound in Formula 26, 27nm), a first EBL (the compound in Formula 29, 5nm), a first EML (23nm), a first HBL (the compound in Formula 30, 5nm), a first ETL (the compound in Formula 27, 12nm), an N-type CGL (the compound in Formula 27 and Li (0.5wt% doping), 12nm), a P-type CGL (the compound in Formula 26 and the compound in Formula 25 (20wt% doping), 5nm), a second HTL (the compound in Formula 26, 55nm), a second EBL (the compound in Formula 29, 5nm), a second EML (30nm), a second HBL (the compound in Formula 30, 5nm), a second ETL (the compound in Formula 27, 25nm), an EIL (the compound in Formula 28, 12nm), a cathode (AgMg, 12nm) and a capping layer (the compound in Formula 26, 75nm) are sequentially deposited to form an OLED.

### 1. Red OLED

### (1) Comparative Example 1 (Ref1)

The compound R-PD-1 (2wt%) in Formula 17 and the compound RH-1 (98wt%) in Formula 22 are used to form the first EML, and the compound R-FD-1 (1wt%) in Formula 14, the compound TADF-1 (49wt%) in Formula 16 and the compound RH-1 (50wt%) in Formula 22 are used to form the second EML.

### (2) Example 1 (Ex1)

The compound R-FD-1 (1wt%) in Formula 14, the compound TADF-1 (49wt%) in Formula 16 and the compound RH-1 (50wt%) in Formula 22 are used to form the first EML, and the compound R-PD-1 (2wt%) in Formula 17 and the compound RH-1 (98wt%) in Formula 22 are used to form the second EML.

### (3) Quantum efficiency

The compound R-PD-1 (2wt%) in Formula 17 and the compound RH-1 (98wt%) in Formula 22 are used to form a film, and the quantum efficiency of the compound R-PD-1 is measured. In addition, the compound R-FD-1 (2wt%) in Formula 14, the compound TADF-1 (49wt%) in Formula 16 and the compound RH-1 (50wt%) in Formula 22 are used to form a film, and the quantum efficiency of the compound R-FD-1 is measured. As a result of the measurement, the red phosphorescent emitting layer has a quantum efficiency of 93.2%, and the red fluorescent emitting layer has a quantum efficiency of 93.0%.

### 2. Green OLED

### (1) Comparative Example 2 (Ref2)

The compound G-FD-1 (1wt%) in Formula 20, the compound TADF-12 (29wt%) in Formula 16 and the compound GH-11 (70wt%) in Formula 24 are used to form the first EML, and the compound G-PD-1 (8wt%) in Formula 18 and the compound GH-1 (92wt%) in Formula 24 are used to form the second EML.

### (2) Example 2 (Ex2)

The compound G-PD-1 (8wt%) in Formula 18 and the compound GH-1 (92wt%) in Formula 24 are used to form the first EML, and the compound G-FD-1 (1wt%) in Formula 20, the compound TADF-12 (29wt%) in Formula 16 and the compound GH-11 (70wt%) in Formula 24 are used to form the second EML.

### (3) Quantum efficiency

The compound G-PD-1 (8wt%) in Formula 18 and the compound GH-1 (92wt%) in Formula 24 are used to form a film, and the quantum efficiency of the compound G-PD-1 is measured. In addition, the compound G-FD-1 (1wt%) in Formula 20, the compound TADF-12 (29wt%) in Formula 16 and the compound GH-11 (70wt%) in Formula 24 are used to form a film, and the quantum efficiency of the compound G-FD-1 is measured. As a result of the measurement, the green phosphorescent emitting layer had a quantum efficiency of 91.6%, and the green fluorescent emitting layer had a quantum efficiency of 95.2%.

### 3. Blue OLED

### (1) Comparative Example 3 (Ref3)

The compound FD2-1 (1wt%) in Formula 10 and the compound BH-1 (99wt%) in Formula 12 are used to form the first and second EMLs.

### (2) Comparative Example 4 (Ref4)

The compound FD1-1 (1wt%) in Formula 2, the compound PD1-5 (12wt%) in Formula 4, the compound PH-1 (43.5wt%) in Formula 6 and the compound NH-1 (43.5wt%) in Formula 8 are used to form the first EML, and the compound FD2-1 (1wt%) in Formula 10 and the compound BH-1 (99wt%) in Formula 12 are used to form the second EML.

### (3) Example 3 (Ex3)

The compound FD2-1 (1wt%) in Formula 10 and the compound BH-1 (99wt%) in Formula 12 are used to form the first EML, and the compound FD1-1 (1wt%) in Formula 2, the compound PD1-5 (12wt%) in Formula 4, the compound PH-1 (43.5wt%) in Formula 6 and the compound NH-1 (43.5wt%) in Formula 8 are used to form the second EML.

### (4) Quantum efficiency

The compound FD2-1 (1wt%) in Formula 10 and the compound BH-1 (99wt%) in Formula 12 are used to form a film, and the quantum efficiency of the compound FD2-1 is measured. In addition, the compound FD1-1 (1wt%) in Formula 2, the compound PD1-5 (12wt%) in Formula 4, the compound PH-1 (43.5wt%) in Formula 6 and the compound NH-1 (43.5wt%) in Formula 8 are used to form a film, and the quantum efficiency of the compound G-FD-1 is measured. As a result of the measurement, the blue emitting layer has a quantum efficiency of 94.0%, and the blue PSF emitting layer has a quantum efficiency of 98.5%.

The emitting properties, i.e., the driving voltage (V), the color coordinate index (CIE) and the luminance (cd/A), of the red, green and blue OLEDs in Comparative Examples 1 to 4 and Examples 1 to 3 are measured and listed in Table 1.

In addition, the emitting properties of the white organic light emitting display device "Tandem Structure" including the red OLED of Ex1 in the red pixel region, the green OLED of Ex2 in the green pixel region and the blue OLED of Ref1, Ref2 or Ex3 in the blue pixel region are measured and listed in Table 2.

**Table 1**

| | R | | G | | B | | |
|---|---|---|---|---|---|---|---|
| | Ex1 | Ref1 | Ref2 | Ex2 | Ref3 | Ref4 | Ex3 |
| V | 7.11 | 7.31 | 8.2 | 8.10 | 6.1 | 6.0 | 5.9 |
| CIE (x,y) | (0.683, 0.316) | (0.682, 0.317) | (0.287, 0.691) | (0.227, 0.734) | (0.149, 0.049) | (0.133, 0.064) | (0.133, 0.057) |
| cd/A | 82.2 | 79.6 | 191.1 | 208.0 | 16.9 | 23.7 | 28.2 |

**Table 2**

| | R | G | B | W | |
|---|---|---|---|---|---|
| | | | | CIE(x, y) | cd/A |
| Tandem Structure | Ex1 | Ex2 | Ref3 | (0.323, 0.329) | 98.1 |
| | Ex1 | Ex2 | Ref4 | | 100.5 |
| | Ex1 | Ex2 | Ex3 | | 109.8 |

As shown in Table 1, in comparison to the red OLED of Ref1, in which the fluorescent emitting layer is disposed to be closer to the second electrode, i.e., the cathode, being the transparent electrode, in the red OLED of Ex1, in which the phosphorescent emitting layer is disposed to be closer to the second electrode being the transparent electrode, the driving voltage is reduced, and the emitting efficiency is improved. Namely, when the phosphorescent emitting layer, which has a relatively high emitting efficiency (quantum efficiency), is disposed to be closer to the second electrode being the transparent electrode, the emitting efficiency of the red OLED is improved.

In addition, in comparison to the green OLED of Ref2, in which the phosphorescent emitting layer is disposed to be closer to the second electrode being the transparent electrode, in the green OLED of Ex2, in which the fluorescent emitting layer is disposed to be closer to the second electrode being the transparent electrode, the driving voltage is reduced, and the emitting efficiency is improved. Namely, when the fluorescent emitting layer, which has a relatively high emitting efficiency (quantum efficiency), is disposed to be closer to the second electrode being the transparent electrode, the emitting efficiency of the green OLED is improved.

Moreover, in comparison to the blue OLED of Ref3, which include only the fluorescent emitting layer, and the blue OLED of Ref4, in which the fluorescent emitting layer is disposed to be closer to the second electrode being the transparent electrode, in the blue OLED of Ex3, in which the PSF emitting layer is disposed to be closer to the second electrode being the transparent electrode, the driving voltage is reduced, and the emitting efficiency is improved. Namely, when the PSF emitting layer, which has a relatively high emitting efficiency (quantum efficiency), is disposed to be closer to the second electrode being the transparent electrode, the emitting efficiency of the blue OLED is improved.

As shown in Table 2, in the organic light emitting display device, in which the red OLED of Ex1, the green OLED of Ex2 and the blue OLED of Ex3 are respectively disposed in the red, green and blue pixel regions, the emitting efficiency is significantly improved.

### 4. Comparative Examples

### (1) Comparative Example 5 (Ref5)

In the blue OLED of Ex3, the compound in Formula 31 is used instead of the compound FD1-1 in the second blue EML.

### (2) Comparative Example 6 (Ref6)

In the blue OLED of Ex3, the compound in Formula 32 is used instead of the compound FD1-1 in the second blue EML.

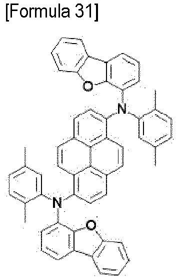

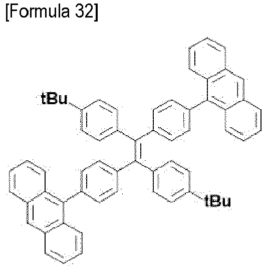

The emitting properties, i.e., the driving voltage (V), the color coordinate index (CIE) and the luminance (cd/A), of the red, green and blue OLEDs in Comparative Examples 5 and 6 and Example 3 are measured and listed in Table 3.

In addition, the emitting properties of the white organic light emitting display device "Tandem Structure" including the red OLED of Ex1 in the red pixel region, the green OLED of Ex2 in the green pixel region and the blue OLED of Ref5, Ref6 or Ex3 in the blue pixel region are measured and listed in Table 4.

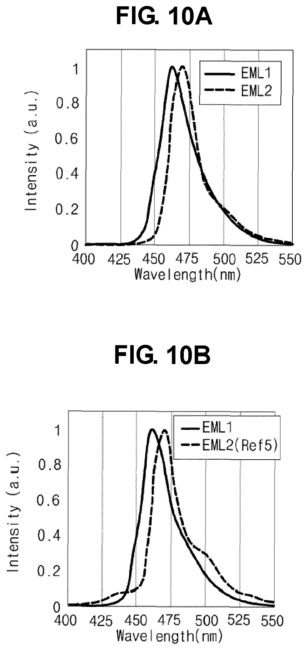

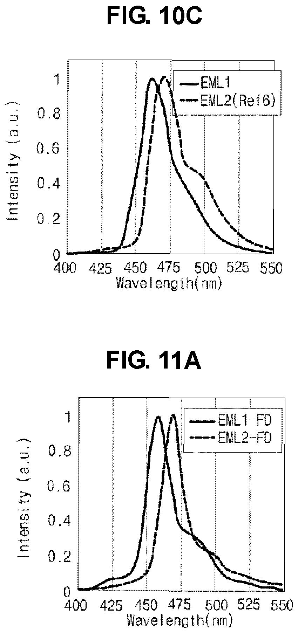

Moreover, the EL spectrum of the blue OLED of Ex3, Ref5 and Ref6 are shown in FIGs. 10A to 10C, respectively.

**Table 3**

| | R | G | B | | |
|---|---|---|---|---|---|
| | Ex1 | Ex2 | Ex3 | Ref5 | Ref6 |
| V | 7.11 | 8.10 | 5.9 | 5.9 | 6.3 |
| CIE (x,y) | (0.683, 0.316) | (0.227, 0.734) | (0.133, 0.057) | (0.130, 0.072) | (0.118, 0.116) |
| cd/A | 82.2 | 208.0 | 28.2 | 29.4 | 30.7 |

**Table 4**

| | R | G | B | W | |
|---|---|---|---|---|---|
| | | | | CIE(x, y) | cd/A |
| Tandem Structure | Ex1 | Ex2 | Ex3 | (0.323, 0.329) | 109.8 |
| | Ex1 | Ex2 | Ref5 | | 103.9 |
| | Ex1 | Ex2 | Ref6 | | 88.0 |

As shown in Tables 3 and 4, in comparison to the OLED of Ref5 and Ref6 and the display device including the same, the emitting efficiency of the OLED of Ex3 and the display device including the same is improved.

Namely, although the OLED of Ref5, Ref6 and Ex3 includes a first bule EML being the fluorescent emitting layer and a second blue EML being the PSF emitting layer, the OLED of Ref5 and Ref6 does not meet the above condition in that a difference" | I_{2nd}(EML2)-I_{2nd}(EML1) | " between a second emission peak intensity "I_{2nd}(EML2)" of the second blue EML being the PSF emitting layer and a second emission peak intensity "I_{2nd}(EML1)" of the first blue EML being the fluorescent emitting layer is 0.1 or less.

Referring to FIG. 10B, in the OLED of Ref5, a difference between a second emission peak intensity " I_{2nd}(EML2)" of the second blue EML being the PSF emitting layer and a second emission peak intensity "I_{2nd}(EML1)" of the first blue EML being the fluorescent emitting layer is 0.1. Referring to FIG. 10B, in the OLED of Ref6, a difference between a second emission peak intensity " I_{2nd}(EML2)" of the second blue EML being the PSF emitting layer and a second emission peak intensity "I_{2nd}(EML1)" of the first blue EML being the fluorescent emitting layer is greater than 0.1.

### 5. Comparative Examples

### (1) Comparative Example 7 (Ref7)

In the blue OLED of Ex3, the compound in Formula 33 is used instead of the compound FD1-1 in the second blue EML.

### (2) Comparative Example 8 (Ref8)

In the blue OLED of Ex3, the compound in Formula 34 is used instead of the compound FD1-1 in the second blue EML.

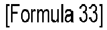

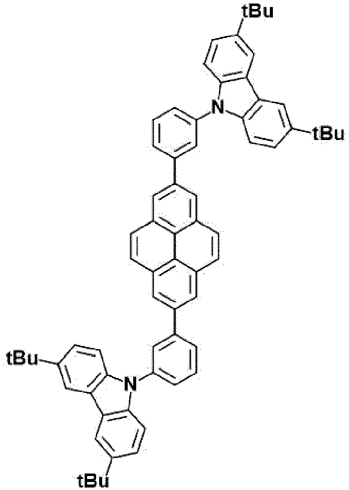

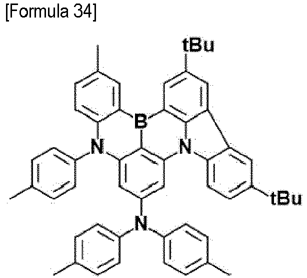

The emitting properties, i.e., the driving voltage (V), the color coordinate index (CIE) and the luminance (cd/A), of the red, green and blue OLEDs in Comparative Examples 7 and 8 and Example 3 are measured and listed in Table 5.

In addition, the emitting properties of the white organic light emitting display device "Tandem Structure" including the red OLED of Ex1 in the red pixel region, the green OLED of Ex2 in the green pixel region and the blue OLED of Ref7, Ref8 or Ex3 in the blue pixel region are measured and listed in Table 6.

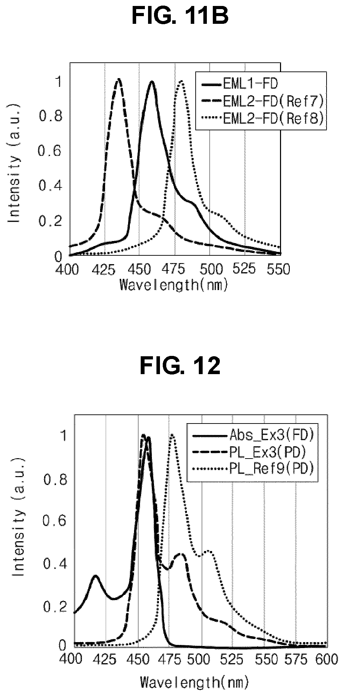

Moreover, the PL spectrum of the fluorescent compound used in the blue OLED of Ex3 is shown in FIG. 11A, and the PL spectrums of the fluorescent compounds used in the blue OLED of Ref7 and Ref8 are shown in FIG. 11B.

**Table 5**

| | R | G | B | | |
|---|---|---|---|---|---|
| | Ex1 | Ex2 | Ex3 | Ref7 | Ref8 |
| V | 7.11 | 8.10 | 5.9 | 6.0 | 6.2 |
| CIE (x,y) | (0.683, 0.316) | (0.227, 0.734) | (0.133, 0.057) | (0.144, 0.038) | (0.119, 0.106) |
| cd/A | 82.2 | 208.0 | 28.2 | 9.6 | 30.9 |

**Table 6**

| | R | G | B | W | |
|---|---|---|---|---|---|
| | | | | CIE(x, y) | cd/A |
| Tandem Structure | Ex1 | Ex2 | Ex3 | (0.323, 0.329) | 109.8 |
| | Ex1 | Ex2 | Ref7 | | 86.7 |
| | Ex1 | Ex2 | Ref8 | | 91.8 |

As shown in Tables 5 and 6, in comparison to the OLED of Ref7 and Ref8 and the display device including the same, the emitting efficiency of the OLED of Ex3 and the display device including the same is improved. In the OLED of Ref8, although the luminance is slightly increased, the driving voltage is increased and the emission peak is shifted toward long wavelength.

Namely, although the OLED of Ref7, Ref8 and Ex3 includes a first bule EML being the fluorescent emitting layer and a second blue EML being the PSF emitting layer, the OLED of Ref7 and Ref8 does not meet the above condition in that a difference between a maximum emission wavelength of the fluorescent compound as the emitter or dopant in the first blue EML being the fluorescent emitting layer and a maximum emission wavelength of the fluorescent compound in the second blue EML being the PSF emitting layer is 15nm or less.

Namely, referring to FIG. 11A, in the OLED of Ex3, a difference between a maximum emission wavelength of the fluorescent compound as the emitter or dopant in the first blue EML being the fluorescent emitting layer and a maximum emission wavelength of the fluorescent compound in the second blue EML being the PSF emitting layer is 15nm or less so that the cavity effect in the OLED is improved.

However, referring to FIG. 11B, the OLED of Ref7 and Ref8 does not meet the above condition so that the cavity effect in the OLED is decreased and/or the emission wavelength shift problem occurs.

### 6. Comparative Example 9 (Ref9)

In the blue OLED of Ex3, the compound in Formula 35 is used instead of the compound PD1-5 in the second blue EML.

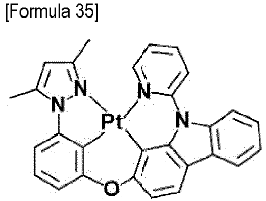

The emitting properties, i.e., the driving voltage (V), the color coordinate index (CIE) and the luminance (cd/A), of the red, green and blue OLEDs in Comparative Example 9 and Example 3 are measured and listed in Table 7.

In addition, the emitting properties of the white organic light emitting display device "Tandem Structure" including the red OLED of Ex1 in the red pixel region, the green OLED of Ex2 in the green pixel region and the blue OLED of Ref9 or Ex3 in the blue pixel region are measured and listed in Table 8.

Moreover, the absorption wavelength of the fluorescent compound and the emission wavelength of the phosphorescent compound in the OLED of Ex3 and Ref9 are shown in FIG. 12.

**Table 7**

| | R | G | B | |
|---|---|---|---|---|
| | Ex1 | Ex2 | Ex3 | Ref9 |
| V | 7.11 | 8.10 | 5.9 | 5.9 |
| CIE (x,y) | (0.683, 0.316) | (0.227, 0.734) | (0.133, 0.057) | (0.130, 0.072) |
| cd/A | 82.2 | 208.0 | 28.2 | 24.4 |

**Table 8**

| | R | G | B | W | |
|---|---|---|---|---|---|
| | | | | CIE(x, y) | cd/A |
| Tandem Structure | Ex1 | Ex2 | Ex3 | (0.323, 0.329) | 109.8 |
| | Ex1 | Ex2 | Ref9 | | 97.3 |

As shown in Tables 7 and 8, in comparison to the OLED of Ref7 and Ref8 and the display device including the same, the emitting efficiency of the OLED of Ex3 and the display device including the same is improved.

Namely, although the OLED of Ref7, Ref8 and Ex3 includes a first bule EML being the fluorescent emitting layer and a second blue EML being the PSF emitting layer, the OLED of Ref7 and Ref8 does not meet the above condition in that a difference between a maximum absorption wavelength of the fluorescent compound and a maximum emission wavelength of the phosphorescent compound is 10nm or less.

Namely, Referring to FIG. 12, in the second blue EML of the OLED of Ex3, a difference between a maximum absorption wavelength of the fluorescent compound and a maximum emission wavelength of the phosphorescent compound is 10nm or less.

However, referring to FIG. 12, the OLED of Ref9 does not meet the above condition so that the emitting efficiency of the OLED is decreased.

It will be apparent to those skilled in the art that various modifications and variations can be made in the present disclosure without departing from the spirit or scope of the present disclosure. Thus, it is intended that the present disclosure cover the modifications and variations of this disclosure provided they come within the scope of the appended claims and their equivalents.

Also disclosed are the following numbered clauses:
1. An organic light emitting diode, comprising:
   a reflective electrode;
   a transparent electrode facing the reflective electrode; and
   a first emitting part including a first blue emitting material layer and positioned between the reflective electrode and the transparent electrode, the first blue emitting material layer including a fluorescent compound; and
   a second emitting part including a second blue emitting material layer and positioned between the first emitting part and the transparent electrode, the second blue emitting material layer including a fluorescent compound and a phosphorescent compound,
   wherein a difference between a second emission peak intensity of the second blue emitting material layer and a second emission peak intensity of the first blue emitting material layer is 0.1 or less.
2. The organic light emitting diode according to clause 1, wherein a difference between a maximum emission wavelength of the fluorescent compound in the first blue emitting material layer and a maximum emission wavelength of the fluorescent compound in the second blue emitting material layer is 15nm or less.
3. The organic light emitting diode according to clause 1, wherein in the second blue emitting material layer, a difference between a maximum absorption wavelength of the fluorescent compound and a maximum emission wavelength of the phosphorescent compound is 10nm or less.
3. The organic light emitting diode according to clause 1, wherein in the second blue emitting material layer, the fluorescent compound is represented by Formula 1: 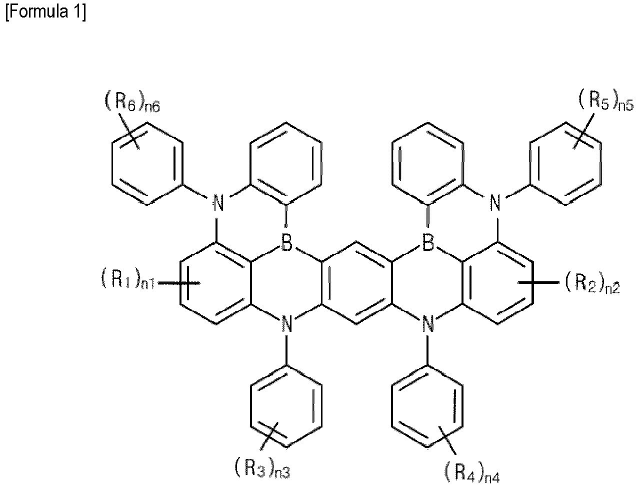
   wherein each of R₁ and R₂ is independently selected from the group consisting of hydrogen, deuterium, a substituted or unsubstituted C5 to C30 heteroaryl group and a substituted or unsubstituted C6 to C30 arylamine group,
   wherein each of R₃, R₄, R₅ and R₆ is independently selected from the group consisting of hydrogen, deuterium, a substituted or unsubstituted C1 to C10 alkyl group and a substituted or unsubstituted C6 to C30 aryl group,
   wherein each of n1 and n2 is independently an integer of 1 to 3, and each of n3, n4, n5 and n6 is independently an integer of 0 to 5,
   wherein the phosphorescent compound is represented by Formula 3: 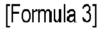 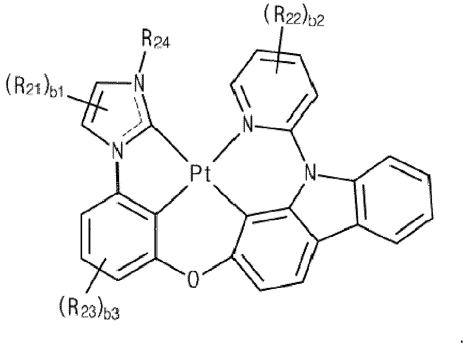
   wherein each of R₂₁, R₂₂ and R₂₃ is independently selected from the group consisting of a substituted or unsubstituted C1 to C10 alkyl group, a substituted or unsubstituted C6 to C30 aryl group and a substituted or unsubstituted C5 to 30 heteroaryl group,
   wherein b1 is an integer of 0 to 2, b2 is an integer of 0 to 4, and b3 is an integer of 0 to 3,
   wherein R₂₄ is selected from the group consisting of hydrogen, a substituted or unsubstituted C1 to C10 alkyl group, a substituted or unsubstituted C6 to C30 aryl group and a substituted or unsubstituted C5 to 30 heteroaryl group.
5. The organic light emitting diode according to clause 4, wherein the fluorescent compound in the second blue emitting material layer is one of compounds in Formula 2: 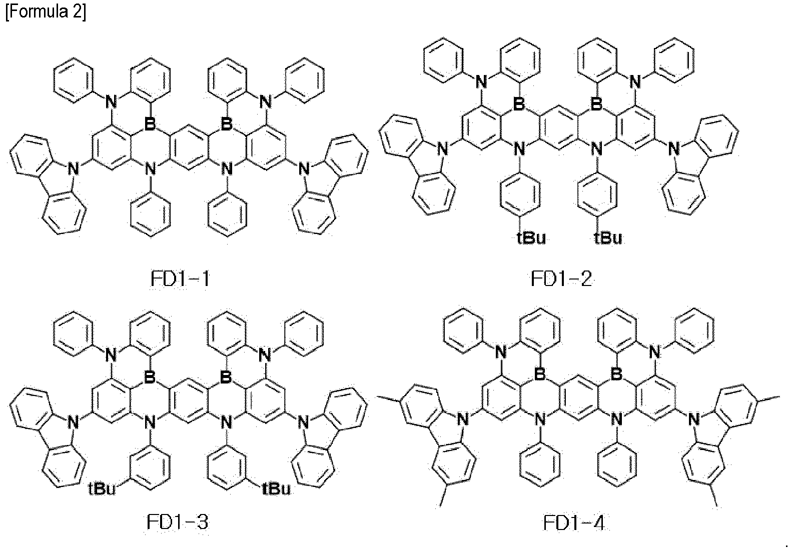
6. The organic light emitting diode according to clause 4, wherein the phosphorescent compound in the second blue emitting material layer is one of compounds in Formula 4: 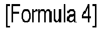 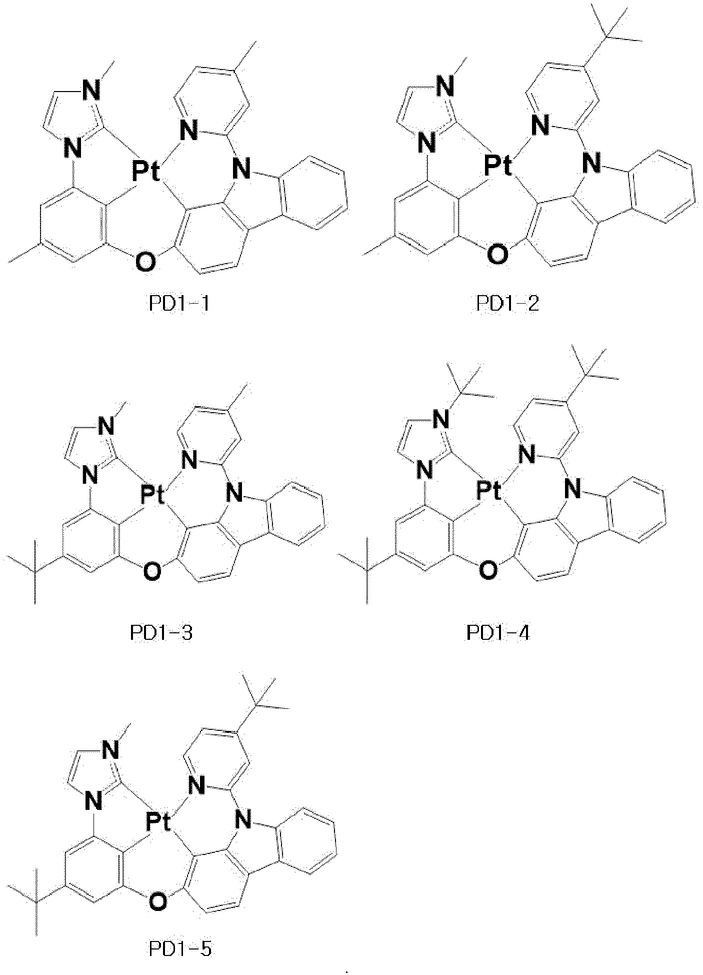
7. The organic light emitting diode according to clause 4, wherein the second blue emitting material layer further includes a first host and a second host,
   wherein the first host is represented by Formula 5: 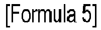 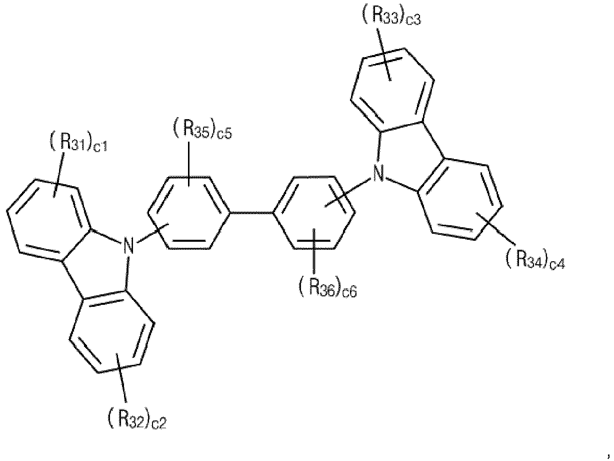
   wherein each of R₃₁, R₃₂, R₃₃, R₃₄, R₃₅ and R₃₆ is independently selected from the group consisting of a substituted or unsubstituted C1 to C10 alkyl group, a substituted or unsubstituted C6 to C30 aryl group and a substituted or unsubstituted C5 to C30 heteroaryl group,
   wherein each of c1, c2, c3, c4, c5 and c6 is independently an integer of 0 to 4,
   wherein the first host is represented by Formula 7: 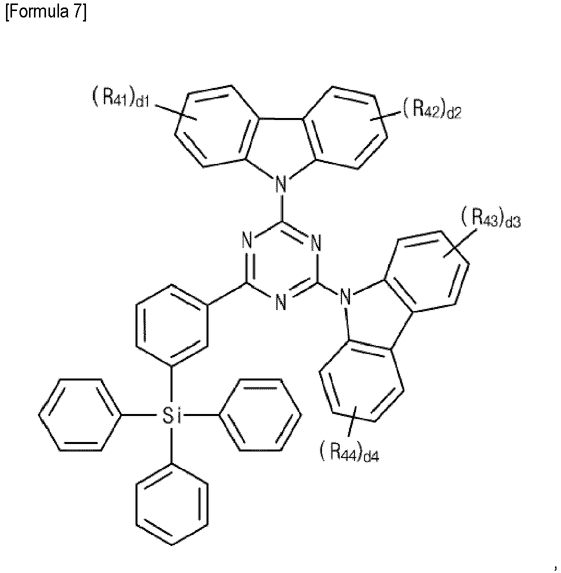
   wherein each of R₄₁, R₄₂, R₄₃ and R₄₄ is independently selected from the group consisting of a substituted or unsubstituted C1 to C10 alkyl group, a substituted or unsubstituted C6 to C30 aryl group and a substituted or unsubstituted C5 to 30 heteroaryl group, and
   wherein each of d1, d2, d3 and d4 is independently an integer of 0 to 4.
8. The organic light emitting diode according to clause 7, wherein the first host is one of compounds in Formula 6: 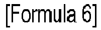 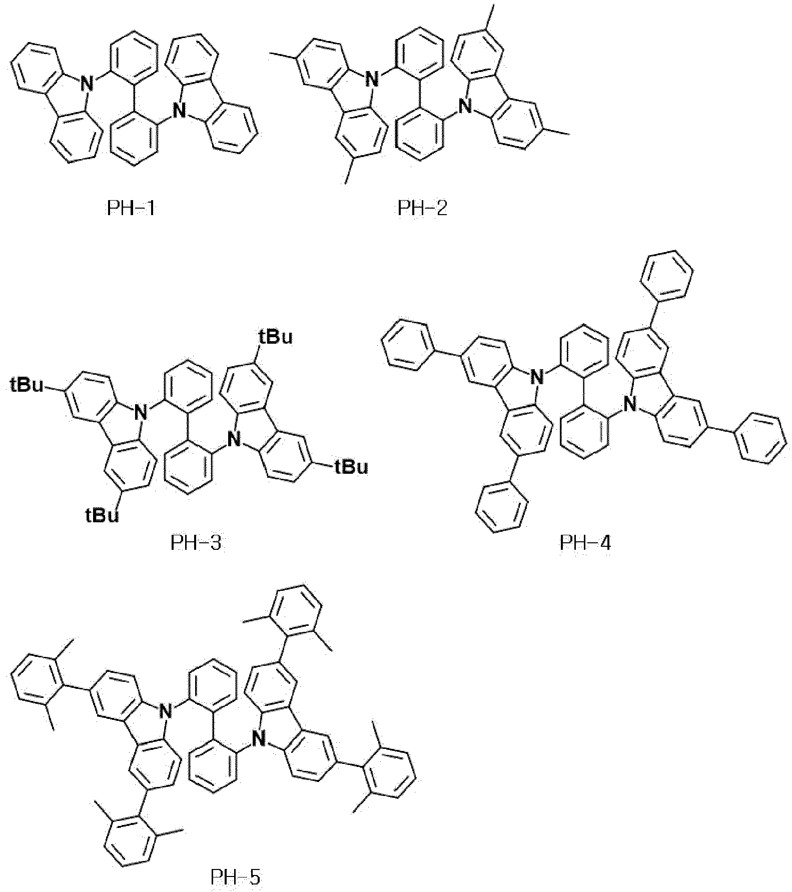
9. The organic light emitting diode according to clause 7, wherein the second host is one of compounds in Formula 8: 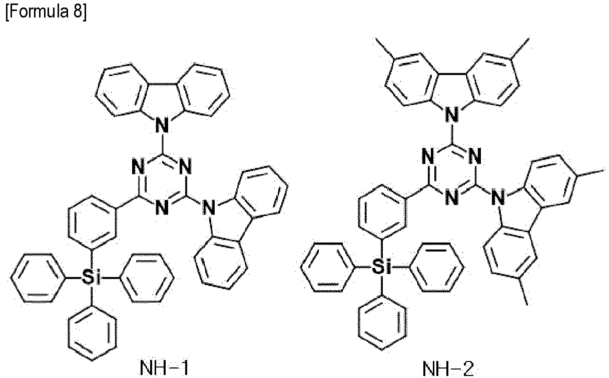 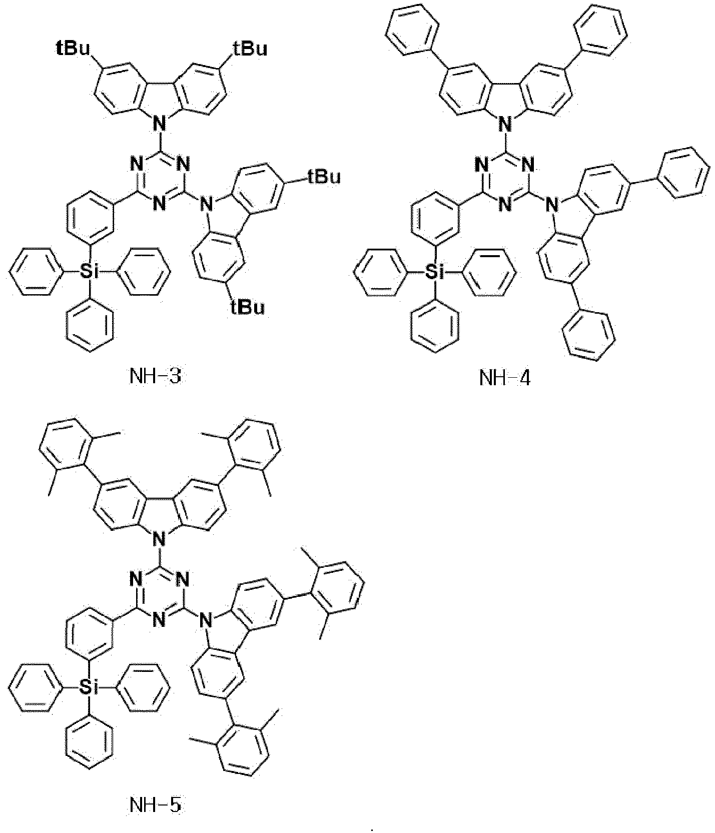
10. The organic light emitting diode according to clause 4, wherein the fluorescent compound in the first blue emitting material layer is represented by Formula 9: 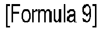 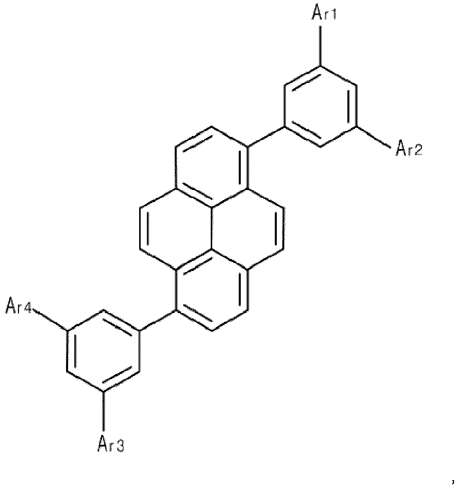 wherein each of Ar₁, Ar₂, Ar₃ and Ar₄ is independently selected from the group consisting of a substituted or unsubstituted C1 to C10 alkyl group, a substituted or unsubstituted C6 to C30 aryl group and a substituted or unsubstituted C6 to C30 arylamine group.
11. The organic light emitting diode according to clause 10, wherein the fluorescent compound in the first blue emitting material layer is one of compounds in Formula 10: 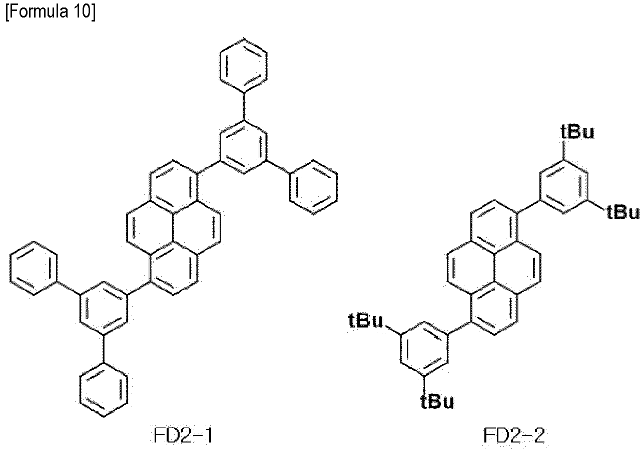 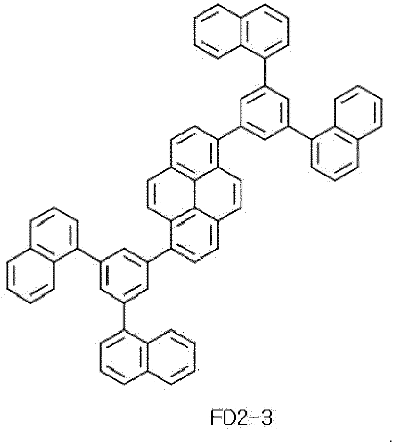
12. The organic light emitting diode according to clause 10, wherein the first blue emitting material layer further includes a host represented by Formula 11: 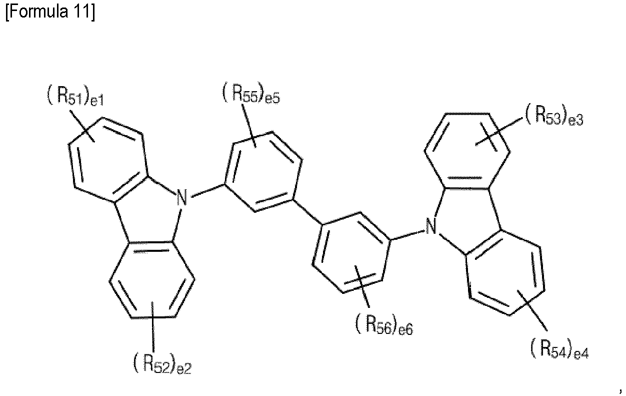
   wherein each of R₅₁, R₅₂, R₅₃, R₅₄, R₅₅ and R₅₆ is independently selected from the group consisting of a substituted or unsubstituted C1 to C10 alkyl group, a substituted or unsubstituted C6 to C30 aryl group and a substituted or unsubstituted C5 to C30 heteroaryl group, and
   wherein each of e1, e2, e3, e4, e5 and e6 is independently an integer of 0 to 4.
13. The organic light emitting diode according to clause 12, wherein the host in the first blue emitting material layer is one of compounds in Formula 12: 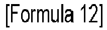 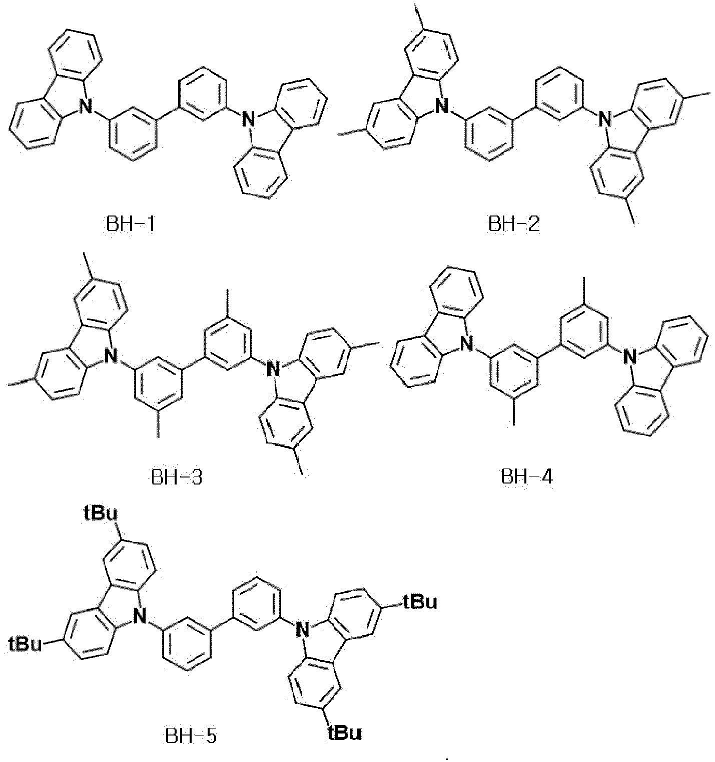
14. The organic light emitting diode according to clause 1, further comprising: a third emitting part including a third emitting material layer and positioned between the first and second emitting parts, wherein the third emitting material layer emits red light and green light.
15. An organic light emitting display device, comprising:
   a substrate including a blue pixel region, a red pixel region and a green pixel region; and
   first to third organic light emitting diodes positioned over the substrate and respectively corresponding to the blue pixel region, the red pixel region and the green pixel region, each of the first to third organic light emitting diodes including:
      a reflective electrode;
      a transparent electrode facing the reflective electrode; and
      an organic light emitting layer between the reflective electrode and the transparent electrode,
      wherein in the first organic light emitting diode, the organic light emitting layer includes a first emitting part including a first blue emitting material layer a second emitting part including a second blue emitting material layer and positioned between the first emitting part and the transparent electrode,
      wherein the first blue emitting material layer includes a fluorescent compound, and the second blue emitting material layer includes a fluorescent compound and a phosphorescent compound, and
      wherein a difference between a second emission peak intensity of the second blue emitting material layer and a second emission peak intensity of the first blue emitting material layer is 0.1 or less.
16. The organic light emitting display device according to clause 15, wherein a difference between a maximum emission wavelength of the fluorescent compound in the first blue emitting material layer and a maximum emission wavelength of the fluorescent compound in the second blue emitting material layer is 15nm or less.
17. The organic light emitting display device according to clause 15, wherein in the second blue emitting material layer, a difference between a maximum absorption wavelength of the fluorescent compound and a maximum emission wavelength of the phosphorescent compound is 10nm or less.
18. The organic light emitting display device according to clause 15, wherein in the second blue emitting material layer, the fluorescent compound is represented by Formula 1: 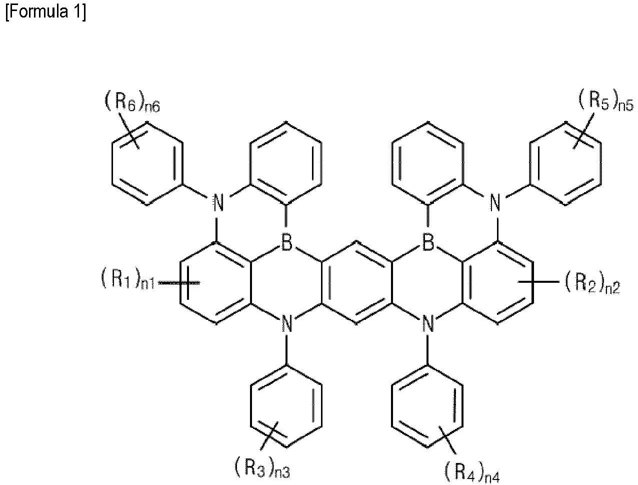
   wherein each of R₁ and R₂ is independently selected from the group consisting of hydrogen, deuterium, a substituted or unsubstituted C5 to C30 heteroaryl group and a substituted or unsubstituted C6 to C30 arylamine group,
   wherein each of R₃, R₄, R₅ and R₆ is independently selected from the group consisting of hydrogen, deuterium, a substituted or unsubstituted C1 to C10 alkyl group and a substituted or unsubstituted C6 to C30 aryl group,
   wherein each of n1 and n2 is independently an integer of 1 to 3, and each of n3, n4, n5 and n6 is independently an integer of 0 to 5,
   wherein the phosphorescent compound is represented by Formula 3: 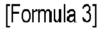 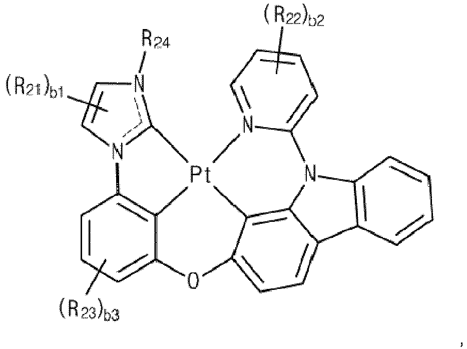
   wherein each of R₂₁, R₂₂ and R₂₃ is independently selected from the group consisting of a substituted or unsubstituted C1 to C10 alkyl group, a substituted or unsubstituted C6 to C30 aryl group and a substituted or unsubstituted C5 to 30 heteroaryl group,
   wherein b1 is an integer of 0 to 2, b2 is an integer of 0 to 4, and b3 is an integer of 0 to 3,
   wherein R₂₄ is selected from the group consisting of hydrogen, a substituted or unsubstituted C1 to C10 alkyl group, a substituted or unsubstituted C6 to C30 aryl group and a substituted or unsubstituted C5 to 30 heteroaryl group.
19. The organic light emitting display device according to clause 18, wherein the fluorescent compound in the second blue emitting material layer is one of compounds in Formula 2: 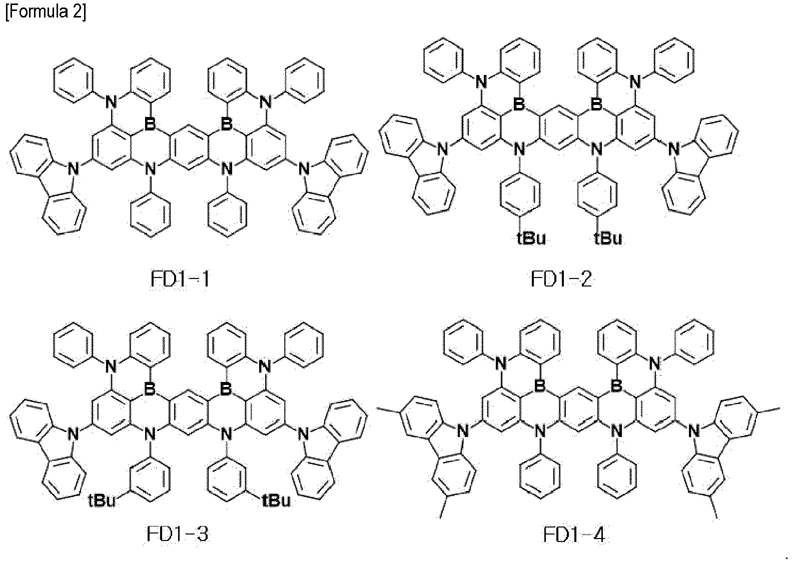
20. The organic light emitting display device according to clause 18, wherein the phosphorescent compound in the second blue emitting material layer is one of compounds in Formula 4: 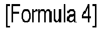 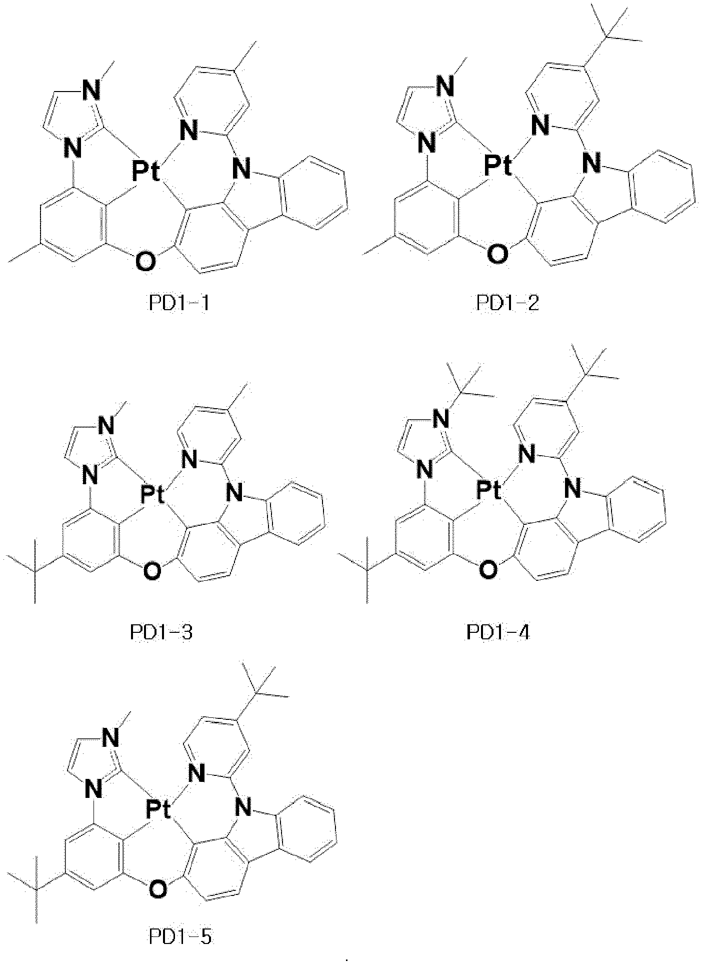
21. The organic light emitting display device according to clause 18, wherein the fluorescent compound in the first blue emitting material layer is represented by Formula 9: 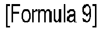 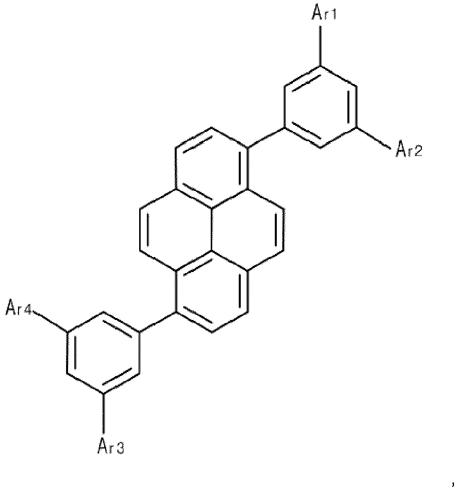 wherein each of Ar₁, Ar₂, Ar₃ and Ar₄ is independently selected from the group consisting of a substituted or unsubstituted C1 to C10 alkyl group, a substituted or unsubstituted C6 to C30 aryl group and a substituted or unsubstituted C6 to C30 arylamine group.
22. The organic light emitting display device according to clause 21, wherein the fluorescent compound in the first blue emitting material layer is one of compounds in Formula 10: 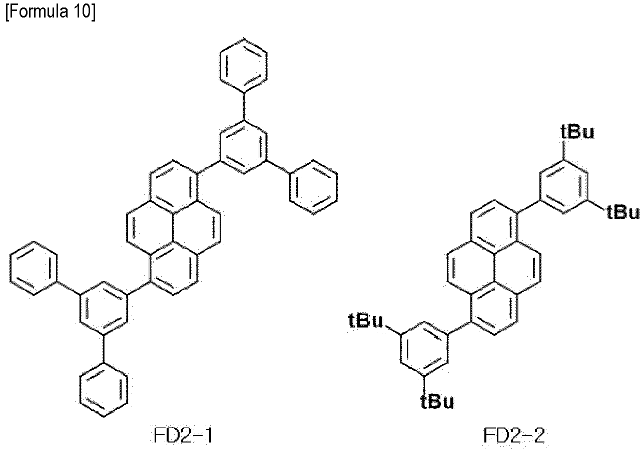 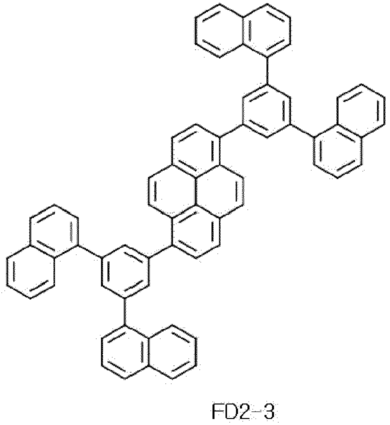
23. The organic light emitting display device according to clause 15, wherein in the second organic light emitting diode, the organic light emitting layer includes a first emitting part including a first red emitting material layer and a second emitting part including a second red emitting material layer and positioned between the first emitting part and the transparent electrode,
   wherein the first red emitting material layer is a florescent emitting layer, and the second red emitting material layer is a phosphorescent emitting layer,
   wherein in the third organic light emitting diode, the organic light emitting layer includes a first emitting part including a first green emitting material layer and a second emitting part including a second green emitting material layer and positioned between the first emitting part and the transparent electrode,
   wherein the first green emitting material layer is a phosphorescent emitting layer, and the second green emitting material layer is a florescent emitting layer.
24. The organic light emitting display device according to clause 23, wherein the second red emitting material layer has an emitting efficiency being greater than the first red emitting material layer, and the second green emitting material layer has an emitting efficiency being greater than the first green emitting material layer.
25. The organic light emitting display device according to clause 15, wherein the organic light emitting layer in the first organic light emitting diode further includes a third emitting material layer and positioned between the first and second emitting parts, wherein the third emitting material layer emits red light and green light, and
   wherein each of the second and third organic light emitting diodes has the same structure as the first organic light emitting diode.
26. The organic light emitting display device according to clause 25, further comprising: a color filter layer positioned between the substrate and each of the first to third organic light emitting diodes or over each of the first to third organic light emitting diodes.
27. The organic light emitting display device according to clause 15, wherein each of the second and third organic light emitting diodes has the same structure as the first organic light emitting diode, and
   wherein the organic light emitting display device further comprises: a color conversion layer positioned between the substrate and each of the first and second organic light emitting diodes or over each of the first and second organic light emitting diodes.

## Claims

1. An organic light emitting diode, comprising:
a reflective electrode;
a transparent electrode facing the reflective electrode; and
a first emitting part including a first blue emitting material layer and positioned between the reflective electrode and the transparent electrode, the first blue emitting material layer including a fluorescent compound;
a second emitting part including a second blue emitting material layer and positioned between the first emitting part and the transparent electrode, the second blue emitting material layer including a fluorescent compound and a phosphorescent compound; and
a charge generation layer positioned between the first and second emitting parts;
wherein a difference between a second emission peak intensity of the fluorescent compound in the second blue emitting material layer and a second emission peak intensity of the fluorescent compound in the first blue emitting material layer is 0.1 or less.

2. The organic light emitting diode according to claim 1, wherein a difference between a maximum emission wavelength of the fluorescent compound in the first blue emitting material layer and a maximum emission wavelength of the fluorescent compound in the second blue emitting material layer is 15nm or less.

3. The organic light emitting diode according to claim 1 or 2, wherein in the second blue emitting material layer, a difference between a maximum absorption wavelength of the fluorescent compound and a maximum emission wavelength of the phosphorescent compound is 10nm or less.

4. The organic light emitting diode according to any preceding claim, wherein in the second blue emitting material layer, the fluorescent compound is represented by Formula 1: 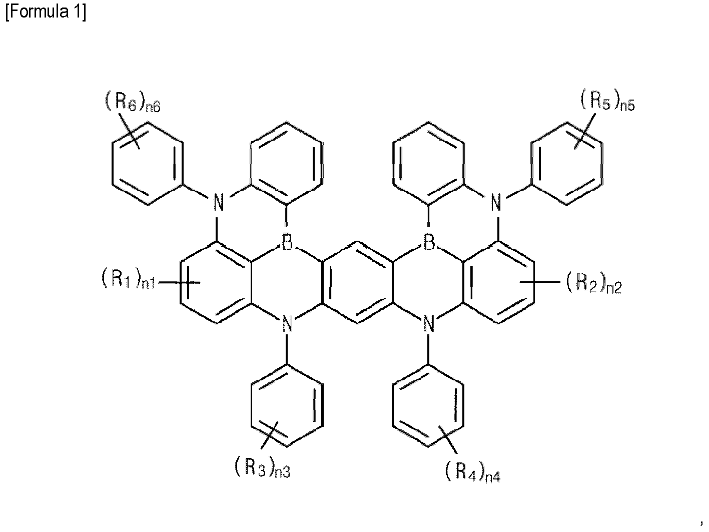
wherein each of R₁ and R₂ is independently selected from the group consisting of deuterium, a substituted or unsubstituted C5 to C30 heteroaryl group and a substituted or unsubstituted C6 to C30 arylamine group,
wherein each of R₃, R₄, R₅ and R₆ is independently selected from the group consisting of deuterium, a substituted or unsubstituted C1 to C10 alkyl group and a substituted or unsubstituted C6 to C30 aryl group,
wherein each of n1 and n2 is independently an integer of 0 to 3, and each of n3, n4, n5 and n6 is independently an integer of 0 to 5, and/or
wherein the phosphorescent compound is represented by Formula 3: 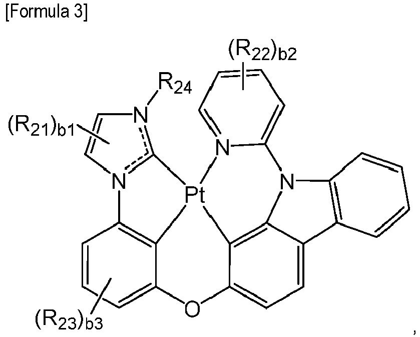
wherein each of R₂₁, R₂₂ and R₂₃ is independently selected from the group consisting of a substituted or unsubstituted C1 to C10 alkyl group, a substituted or unsubstituted C6 to C30 aryl group and a substituted or unsubstituted C5 to 30 heteroaryl group,
wherein b1 is an integer of 0 to 2, b2 is an integer of 0 to 4, and b3 is an integer of 0 to 3,
wherein R₂₄ is selected from the group consisting of absent, hydrogen, a substituted or unsubstituted C1 to C10 alkyl group, a substituted or unsubstituted C6 to C30 aryl group and a substituted or unsubstituted C5 to 30 heteroaryl group.

5. The organic light emitting diode according to claim 4, wherein the fluorescent compound in the second blue emitting material layer is one of compounds in Formula 2:

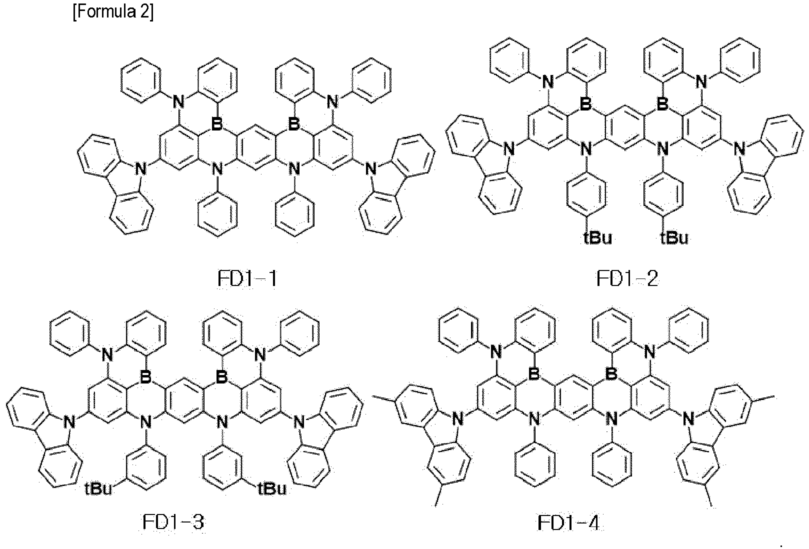

6. The organic light emitting diode according to claim 4 or 5, wherein the phosphorescent compound in the second blue emitting material layer is one of compounds in Formula 4:

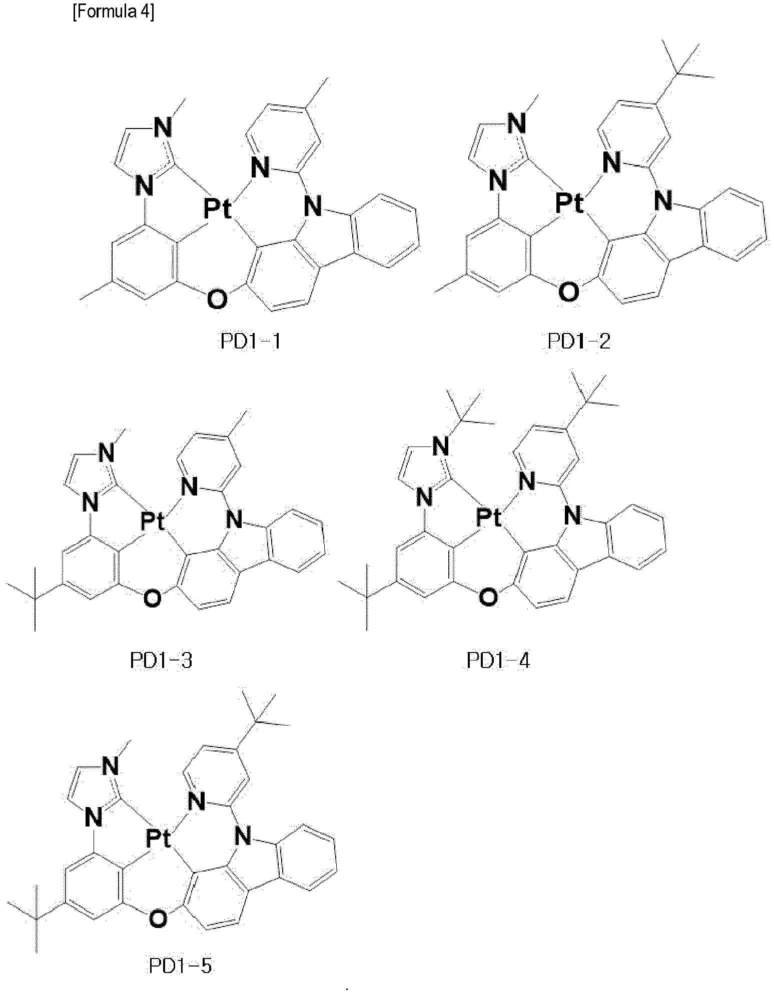

7. The organic light emitting diode according to any preceding claim, wherein the second blue emitting material layer further includes a first host and a second host,
wherein the first host is represented by Formula 5: 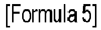 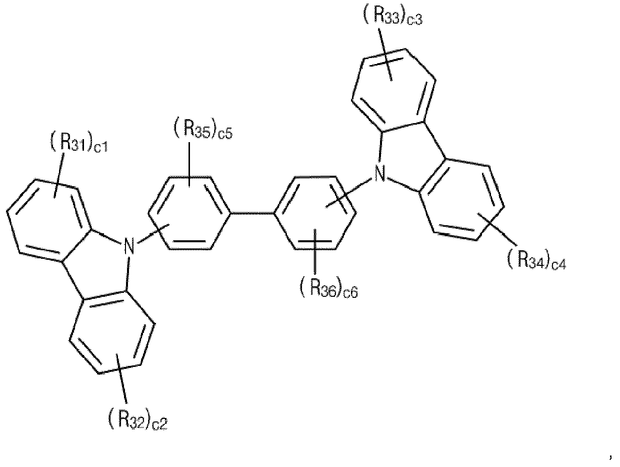
wherein each of R₃₁, R₃₂, R₃₃, R₃₄, R₃₅ and R₃₆ is independently selected from the group consisting of a substituted or unsubstituted C1 to C10 alkyl group, a substituted or unsubstituted C6 to C30 aryl group and a substituted or unsubstituted C5 to C30 heteroaryl group,
wherein each of c1, c2, c3, c4, c5 and c6 is independently an integer of 0 to 4,
wherein the first host is represented by Formula 7: 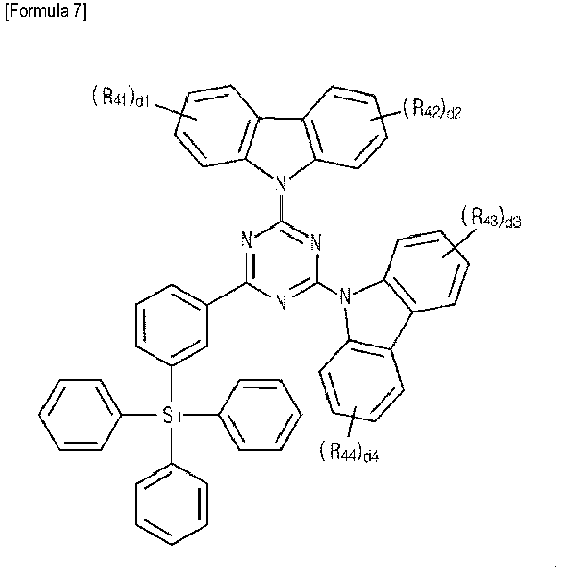
wherein each of R₄₁, R₄₂, R₄₃ and R₄₄ is independently selected from the group consisting of a substituted or unsubstituted C1 to C10 alkyl group, a substituted or unsubstituted C6 to C30 aryl group and a substituted or unsubstituted C5 to 30 heteroaryl group, and
wherein each of d1, d2, d3 and d4 is independently an integer of 0 to 4, optionally wherein the first host is one of compounds in Formula 6: 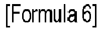 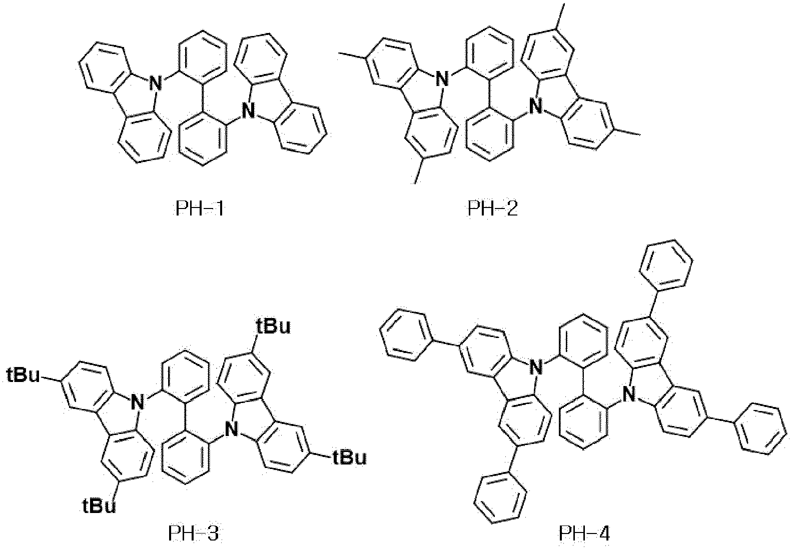 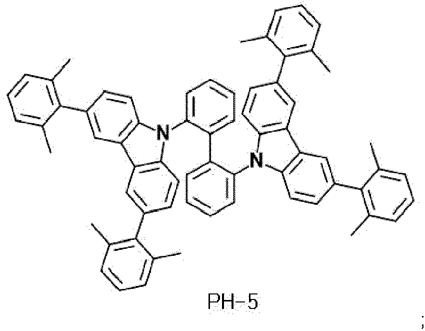 and/or
wherein the second host is one of compounds in Formula 8:

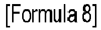

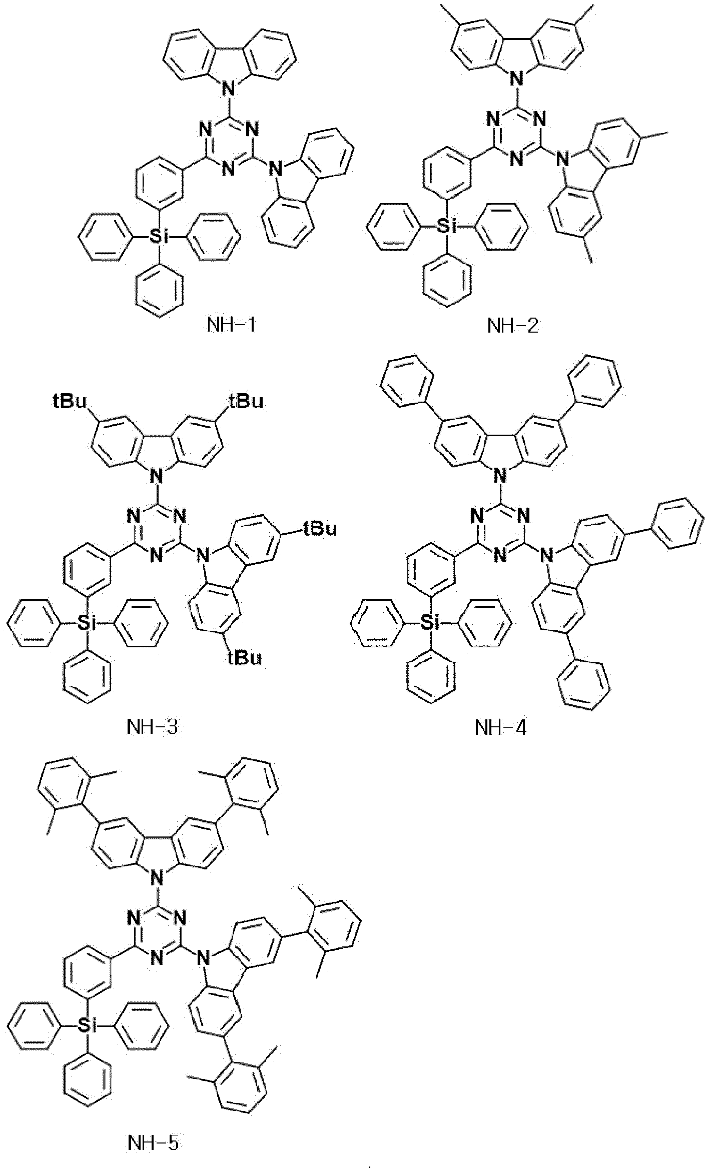

8. The organic light emitting diode according to any preceding claim, wherein the fluorescent compound in the first blue emitting material layer is represented by Formula 9: 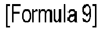 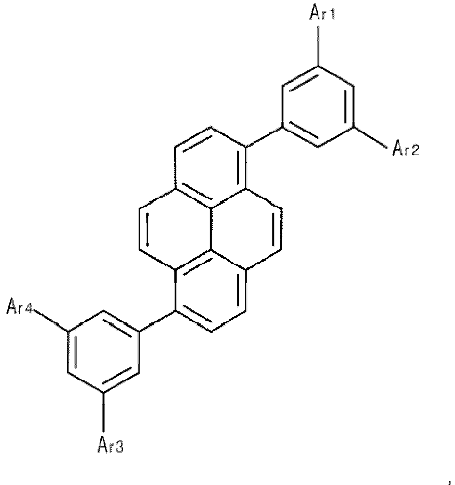 wherein each of Ar₁, Ar₂, Ar₃ and Ar₄ is independently selected from the group consisting of a substituted or unsubstituted C1 to C10 alkyl group, a substituted or unsubstituted C6 to C30 aryl group and a substituted or unsubstituted C6 to C30 arylamine group.

9. The organic light emitting diode according to claim 8, wherein the fluorescent compound in the first blue emitting material layer is one of compounds in Formula 10:

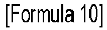

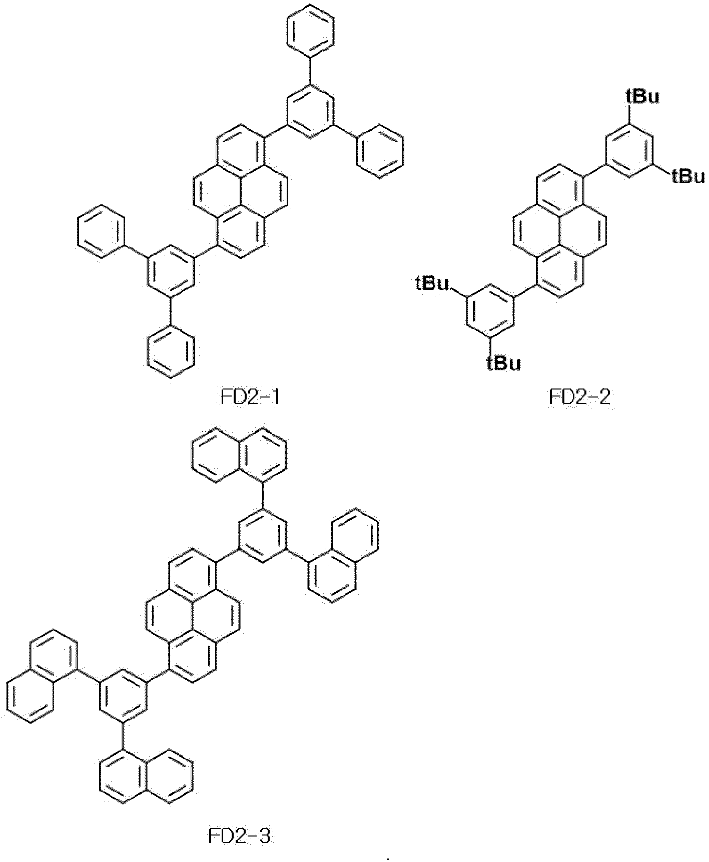

10. The organic light emitting diode according to any preceding claim, wherein the first blue emitting material layer further includes a host represented by Formula 11: 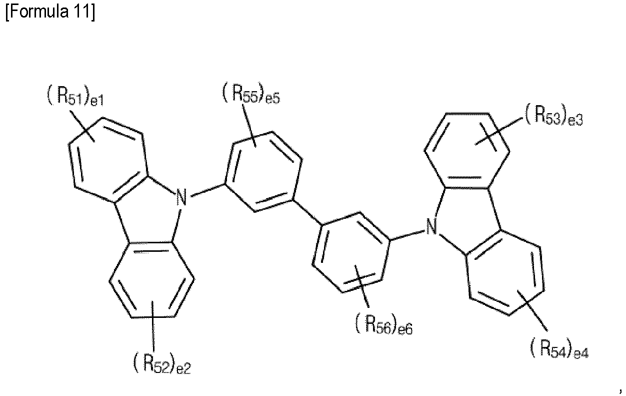
wherein each of R₅₁, R₅₂, R₅₃, R₅₄, R₅₅ and R₅₆ is independently selected from the group consisting of a substituted or unsubstituted C1 to C10 alkyl group, a substituted or unsubstituted C6 to C30 aryl group and a substituted or unsubstituted C5 to C30 heteroaryl group, and
wherein each of e1, e2, e3, e4, e5 and e6 is independently an integer of 0 to 4, optionally wherein the host in the first blue emitting material layer is one of compounds in Formula 12:

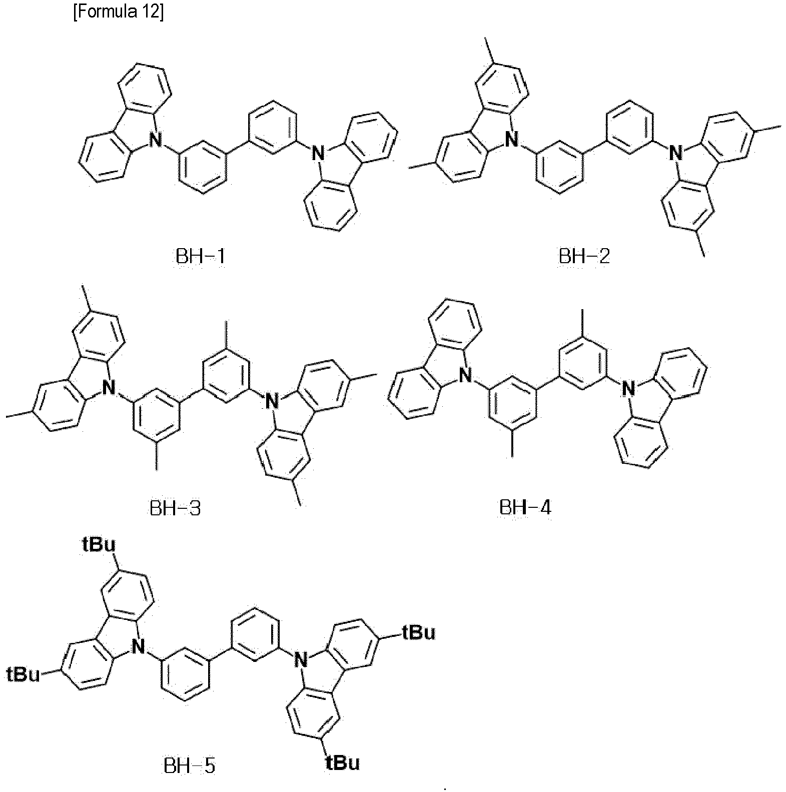

11. The organic light emitting diode according to any preceding claim, further comprising: a third emitting part including a third emitting material layer and positioned between the first and second emitting parts, wherein the third emitting material layer emits red light and yellow-green light.

12. An organic light emitting display device, comprising:
a substrate including a blue pixel region, a red pixel region and a green pixel region; and
first to third organic light emitting diodes positioned over the substrate and respectively corresponding to the blue pixel region, the red pixel region and the green pixel region, each of the first to third organic light emitting diodes including:
a reflective electrode;
a transparent electrode facing the reflective electrode; and
an organic light emitting layer between the reflective electrode and the transparent electrode,
wherein in the first organic light emitting diode, the organic light emitting layer includes a first emitting part including a first blue emitting material layer a second emitting part including a second blue emitting material layer and positioned between the first emitting part and the transparent electrode;
a charge generation layer positioned between the first and second emitting parts;
wherein the first blue emitting material layer includes a fluorescent compound, and the second blue emitting material layer includes a fluorescent compound and a phosphorescent compound, and
wherein a difference between a second emission peak intensity of the fluorescent compound in the second blue emitting material layer and a second emission peak intensity of the fluorescent compound in the first blue emitting material layer is 0.1 or less.

13. The organic light emitting display device according to claim 12, wherein the first organic light emitting diode is an organic light emitting diode according to any one of claims 1-11.

14. The organic light emitting display device according to claim 12 or 13, wherein in the second organic light emitting diode, the organic light emitting layer includes a first emitting part including a first red emitting material layer and a second emitting part including a second red emitting material layer and positioned between the first emitting part and the transparent electrode,
wherein the first red emitting material layer is a florescent emitting layer, and the second red emitting material layer is a phosphorescent emitting layer,
wherein in the third organic light emitting diode, the organic light emitting layer includes a first emitting part including a first green emitting material layer and a second emitting part including a second green emitting material layer and positioned between the first emitting part and the transparent electrode,
wherein the first green emitting material layer is a phosphorescent emitting layer, and the second green emitting material layer is a florescent emitting layer, optionally, wherein the second red emitting material layer has an emitting efficiency being greater than the first red emitting material layer, and the second green emitting material layer has an emitting efficiency being greater than the first green emitting material layer.

15. The organic light emitting display device according to any of claims 12-14, wherein each of the second and third organic light emitting diodes has the same structure as the first organic light emitting diode, optionally
wherein the organic light emitting display device, further comprises: a color filter layer positioned between the substrate and each of the first to third organic light emitting diodes or over each of the first to third organic light emitting diodes; or
wherein the organic light emitting display device further comprises: a color conversion layer positioned between the substrate and each of the first and second organic light emitting diodes or over each of the first and second organic light emitting diodes.
